# EUROPEAN PATENT APPLICATION

(11) **EP 1 767 989 A1**
(43) Date of publication of application: **28.03.2007**
(21) Application number: 05745970.3
(22) Date of filing: 31.05.2005
(51) Int. Cl.: G03F 7/004, B82B 3/00, G02B 3/00, G02B 5/20, G03F 7/26, H01L 21/027, H05K 3/10

(54) **METHOD OF FORMING GRAFT PATTERN, GRAFT PATTERN MATERIAL, METHOD OF LITHOGRAPHY, METHOD OF FORMING CONDUCTIVE PATTERN, CONDUCTIVE PATTERN, PROCESS FOR PRODUCING COLOR FILTER, COLOR FILTER AND PROCESS FOR PRODUCING MICROLENS**

(30) Priority: 31.05.2004 JP 2004161287; 17.06.2004 JP 2004180115; 18.06.2004 JP 2004181413; 24.06.2004 JP 2004186140; 02.03.2005 JP 2005058014; 11.03.2005 JP 2005070028; 11.03.2005 JP 2005070030
(71) Applicant: FUJIFILM CORPORATION, Minato-ku Tokyo 106-8620 (JP)
(72) Inventor: KAWAMURA, Koichi, c/o FUJIFILM corporation, Kanagawa 2588577 (JP)
(74) Representative: HOFFMANN EITLE
(86) International application number: PCT/JP2005/009920
(87) International publication number: WO 2005/116763

(57) **Abstract**

An object of the present invention is to provide a graft pattern-forming method giving a graft pattern allowing formation of a high-resolution pattern that has an oil- and water-repellent region in a commonly-used exposure machine, a lithography method of using the oil- and water-repellent graft pattern formed by the method as an etching stopper, and a conductive pattern-forming method, a color filter forming method, and a microlens production process by using the graft pattern formed by the graft pattern-forming method.

The graft pattern-forming method comprises forming a graft polymer-generated region and a non-generated region thereon by bonding a compound having a photopolymerization-initiating site that initiates radical polymerization by photocleavage radical polymerization and a base material-bonding site onto a base material surface in a patterned form, and additionally, by bringing the radically polymerizable compound having an oil- and water-repellent functional group into contact therewith and exposing the entire surface to light, or alternatively, bonding the compound having a polymerization-initiating site that initiates radical polymerization by photocleavage and a base material-bonding site to the base material, bringing a radically polymerizable compound having an oil- and water-repellent functional group into contact therewith, and exposing the region in a patterned form.

## Description

### Technical Field

The present invention relates to a method of forming graft pattern which has oil- and water-repellent, an graft pattern material, which has oil- and water-repellent, formed by the method, and a lithography method using the graft pattern material.
The present invention also relates to a method of forming a conductive pattern by using an compound having oil- and water-repellent and a conductive pattern formed by the method.
The present invention further relates to a method of producing a color filter suitable for use, for example, as a component for color liquid crystal display devices, and a color filter obtained by the producing method.
The present invention further relates to a method of producing a microlens applicable in various fields, and in particular a method allowing easy production of a fine, uniformly-shaped microlens having an arbitrary diameter and focal length.

### Related Art

Pattern materials having a patterned oil-repellent region by using a compound showing a strong oil repellency, such as a fluorine compound, have been used in a variety of fields such as thin-layered etching resist and template for properly applying droplet by inkjet method and the like. In particular, it is known that a conductive pattern higher in precision is obtained when such a pattern material is used as a template.
Specifically, for example, as a method of forming such a pattern material, proposed is a method of forming a pattern by forming a monomolecular film, for example of an alkylsilane fluoride, on an entire surface of a base material by gas-phase growth (CVD), irradiating the film through a glass mask with a short-wavelength ultraviolet ray, and thus, decomposing and removing the monomolecular film in the irradiated region (see e.g., Patent Document 1).

The methods of removing the monomolecular film by irradiation with a short-wavelength ultraviolet ray, such as the method described in Patent Document 1, demanded irradiation with a ultraviolet ray at a particular wavelength, for example, at a wavelength of 172 nm at an intensity of 10 mw/cm² for about 5 minutes for sufficient decomposition and removal of the monomolecular film. Ultraviolet ray at such a wavelength is lower in transmittance in glass; thickening of the glass mask lead to prolongation of the photoirradiation period, in particular when a pattern material in a larger area is formed; and thus, the method had problems when applied to the practical process for producing the pattern material. In addition, the method also had a problem in forming a fine pattern, although the details of the mechanism are yet to be understood.

Other methods of forming a pattern material so far proposed were, for example, a method of forming a monomolecular layer on the base material by bonding a silane compound having a hydrolytic group and an oil-repellent group thereto, pattern-coating an alkali solution on the substrate by inkjet method, and thus, removing the monomolecular layer in the region by hydrolysis (see e.g., Patent Document 2), and a method of applying a fluorine polymer on the base material surface and removing the fluorine polymer locally by etching using a resist (see e.g., Patent Document 3).
However, methods of using inkjet or resist inherently had restriction in pattern resolution, as in the methods described in Patent Documents 2 or 3.

Accordingly, there existed an urgent need for a method of patterning and also a method of forming a conductive pattern allowing easy and efficient production of a pattern material having a pattern oil-repellent region of a compound showing a high oil repellency such as a fluorine compound and allowing direct patterning in a general-purpose exposure machine.

In addition, there is an increasing demand for color liquid-crystal display devices recently as displays in color liquid-crystal televisions, personal computers, and portable terminals. One of the components for such a color liquid crystal display device is color filter.
Such a color filter has a pixel pattern which is normally colored in three primary colors, red (R), green (G), and blue (B), and light passes through pixels respectively in colors R, G, and B, including the liquid crystal functioning as a shutter by application of voltage to the electrodes corresponding to the respective pixels in colors of R, Q and B, enabling color displaying.

Many of the conventional method of producing a color filter had a problem of high cost, associated with repetition of the same process three times for coloring three colors R, G, and B, and also a problem of low yield by the repeated processing. To obtain a color filter while such a problem is avoided, known is a method of forming pixels by ejection of color inks in the inkjet method. Specifically, for example, known is a method of forming a photocatalyst-containing layer that has a contact angle decreased by photoirradiation on the transparent base material surface, and forming pixels by ejecting ink in the inkjet method onto the exposure region of the photocatalyst-containing layer (see e.g., Patent Document 4).
The method gives a pattern having a contact angle varying by photoirradiation on a transparent base material surface, and thus, it is possible to provide a cost-effective and high-quality color filter by forming pixels on the region of smaller contact angel in the inkjet method.
However, when a large amount of the ink ejects onto the low-contact angle region for increasing the optical density of pixels, there is a problem of color mixing among neighboring pixels, because the difference in contact angle is not sufficient for holding the entire ink thereon. In the method described in Patent Document 1 above, the exposed area of photocatalyst-containing layer is coated after formation of pixels, for prevention of decomposition of the liquid crystal itself by action of the photocatalyst contained in the photocatalyst-containing layer, however presence of such an additional coating process also leads to a problem of low productivity.

In the other hand, another specific known example of pixels-forming method by ejecting color inks in the inkjet method on the base material is a method of forming a fluorinated barrier and forming pixels by ejecting color inks on the region surrounded by the barrier in the inkjet method (see e.g., Patent Document 5).
Because there is a barrier having a higher contact angle formed by fluorination among neighboring pixels, the method does not cause the problem of color mixing among pixels because the barrier has a function of holding the ink in the region, even when a large amount of ink is ejected on the region surrounded by the barrier. However, the barrier is formed only in multiple processes of patterning a resin composition layer formed on the entire base material surface by photolithography or etching and then fluorinating the residual resin composition layer, therefore there has been a problem of complicated production process.

In addition, among conventionally used lenses, there exists a need recently for a microlens, which is fine convex lens, and also for a microlens array which is arranged microlens in order. The microlens arrays are used as a component for liquid crystal displays, for example, in order to optically connect between an optical semiconductor array carrying multiple optical semiconductor elements, such as light-emitting device and light-receiving device, and an optical fiber array having multiple optical fibers arranged in order, and there exists a need for a microlens array which has smaller in unevenness among lenses and is able to produce easily.
For preparation of the conventional microlens, known is a method of forming multiple lenses (convex lenses) by increasing the refractive index at multiple portions on a substrate consisted of multi-component glass by ion diffusion method. However, the lenses obtained by the method had problems of larger unevenness in quality such as focal length, demand for large-scale production equipment such as ion diffusion apparatus, and difficulty of production.

Examples of the method of producing a microlens without complicated apparatus include a method of ejecting droplets of a lens raw material and hardening the droplets on a transparent substrate (see e.g., Patent Document 6), a method of producing a lens component by etching resin film of a lens raw material via a mask and deforming it into the lens shape by heating (see e.g., Patent Document 7), a method of forming lens-shaped dents by etching a glass substrate with a photoresist and glass and filling a lens-forming material therein (see e.g., Patent Document 8), and the like. However, these methods still had the following problems, although large-scale equipment is unnecessary. In the method of Patent Document 6, there was restriction in selecting raw materials, because the lens shape was determined by the contact angle between the lens raw material and the base material, and thus it was difficult to control the focal length. Alternatively in the method of Patent Document 7, it was difficult to form a fine lens, for example, because the resin layer, which is a raw material of the lens, was etched isotropically. Yet alternatively in the method of Patent Document 8, it was complicated to control the shape in the glass-etching process and the refractive index of the lens obtained was also limited.
Patent Document 1: Japanese Patent Application Laid-Open (JP-A) No. 2000-282240
Patent Document 2: JP-A No. 2003-149831
Patent Document 3: JP-A No. 11-40548
Patent Document 4: JP-ANo. 2001-242316
Patent Document 5: JP-A No. 2002-62421
Patent Document 6: JP-A No. 2-165932
Patent Document 7: JP-A No. 5-164904
Patent Document 8: JP-A No. 8-201793

### Disclosure of Invention

The present invention is aimed at solving the conventional problems above and achieving the following objects. A first object of the present invention is to provide a method of forming a graft pattern that allows formation of a high-resolution pattern directly, for example, according to digital data in a general-purpose exposure machine and also formation of a highly oil- and water-repellent region of a fluorine compound efficiently in a desired pattern efficient. The other object thereof is to provide a high-resolution oil- and water-repellent graft pattern formed by the method of forming a graft pattern according to the present invention, and to provide a lithography method allowing high-resolution etching by using the oil- and water-repellent graft pattern as an etching stopper.

A second object of the present invention is to provide a method of being able to form a conductive pattern by forming a pattern material having a patterned oil- and water-repellent region of a highly oil- and water-repellent compound such as a fluorine compound with a general-purpose exposure machine easily and efficiently, and producing a high-resolution high-accuracy conductive pattern by using the pattern material, and to provide a conductive pattern obtained the forming method.

A third object of the present invention is to provide the method of producing a color filter that allows easy production of a color filter at low cost and high quality by using a pattern material having a patterned oil- and water-repellent region with a highly oil- and water-repellent compound such as a fluorine compound.
The other object of the present invention is to provide a high-quality color filter produced by the method of producing a color filter according to the present invention.

A fourth object of the present invention is to provide a method of producing a microlens that allows easy production of a fine uniform microlens without a complicated process or expensive equipment by using a pattern material having a patterned oil- and water-repellent region of a highly oil- and water-repellent compound such as a fluorine compound.

### Means to Solve the Problems

After intensive studies, the inventors have found that it was possible to achieve the first object by using a base material generating polymerization-initiating active sites locally by photoirradiation and forming a graft pattern having a high oil- and high water-repellent functional group such as fluorine by using the active sites as initial points, and completed the present invention.

In the graft pattern-forming method according to the present invention, polymerization-initiating active sites, initial points of graft polymerization, are first formed in a pattern form, and graft polymers having an oil- and water-repellent functional group are formed by using the active sites as the initial point.
In the first embodiment, the graft pattern-forming method of the present invention comprises a process of bringing a radically polymerizable compound having an oil- and water-repellent functional group into contact with the surface of a base material capable of generating radicals by photoirradiation, generating graft polymers from the radicals generated in the exposure region as initial points by patternwise photoirradiation on the base material and thus, forming a surface graft polymer-generated region and a non-generated region on the base material surface.

Thus, a base material having a function to generate radicals by photoirradiation should be used in the embodiment above.
Examples of the base materials include (1) base materials containing a radical generator, (2) base materials containing a polymer compound having a radical-generating site, (3) base materials prepared by coating and drying a coating solution containing a polymer compound having on the side chain a crosslinking site and a radical-generating site on a substrate surface and forming a crosslinked structure in the coated film, and the like (second to fourth embodiments of the method of forming a graft pattern of the present invention).

Alternatively in the method of forming a conductive pattern according to the present invention, it is possible to use a transparent base material having a radical-generating region in a patterned form formed by other means on the surface, not a transparent base material itself containing a radical-generating compound as described above, and generate graft polymers from the radicals as initial points.
Embodiments of such methods include the fifth to eighth embodiments shown below.

Thus, in a fifth embodiment, the graft pattern-forming method of the present invention comprises a process of generating radicals in an exposure region of a base material by bringing a hydrogen-abstraction radical generator into contact with the base material surface and performing patternwise photoirradiation on the base material a process of generating graft polymers by using the radicals generated in the exposure region as initial points by bringing a radically polymerizable compound having an oil- and water-repellent functional group into contact with the base material surface, and a process of forming a graft polymer-generated region and a non-graft polymer-generated region on the base material surface.

In a sixth embodiment, the graft pattern-forming method of the present invention comprises in the following order; a process of bonding a compound having a polymerization-initiating site capable of initiating radical polymerization by photocleavage onto a base material surface in a patterned form; a process of forming a graft polymer-generated region and a non-generated region on the base material surface by bringing a radically polymerizable compound having an oil- and water-repellent functional group into contact with the base material, photoirradiating the entire surface, and thus, preparing graft polymers from the polymerization-initiating sites as initial points.

The process of bonding a compound having a polymerization-initiating site capable of initiating radical polymerization by photocleavage (hereinafter, suitably referred to as "photocleavable compound") to a base material surface in a patterned form bond is not particularly limited, and examples thereof include a method of bonding a photocleavable compound over the entire base material surface and decomposing (inactivating) the polymerization-initiating sites in the exposure region by patternwise photoirradiation, a method of depositing and bonding a photocleavable compound on the base material surface in the patterned form by microcontact printing, and the like.
Considering the resolution of the pattern obtained and application thereof to digital data, preferable is use of a method comprising a process of bonding a compound having a polymerization-initiating site capable of initiating radical polymerization by photocleavage and a base material-bonding site to the base material surface and a process of inactivating the polymerization-initiating sites in the exposure region by patternwise photoirradiation (seventh embodiment of the method of forming a graft pattern of the present invention), as in the method of forming a conductive pattern of a seventh embodyment of the present invention.

Alternatively in an eighth embodiment, the graft pattern-forming method of the present invention comprises a process of bonding a compound having a polymerization-initiating site capable of initiating radical polymerization by photocleavage and a base material-bonding site to the surface of a material surface and a process of forming a graft polymer-generated region and a non-generated region on the base material surface by performing patternwise photoirradiation after bringing a radically polymerizable compound having an oil- and water-repellent functional group into contact with the base material and generating graft polymers by using the polymerization-initiating sites in the exposure region as initial points, performed in this order.

In a favorable embodiment of the present invention, the polymerization-initiating site generating a polymerization-initiating active site preferably contains a bond selected from the group consisting of a C-C bond, a C-N bond, a C-O bond, a C-Cl bond, a N-O bond,and a S-N bond (ninth embodiment of the method of forming a graft pattern of the present invention).

In any method, the graft polymer is generated by initiating and advancing radical polymerization by bringing a radical polymerizable compound having an oil- and water-repellent functional group to the initial point of active site.
These methods are characteristic in that it is possible to form a high-resolution graft pattern according to the exposure accuracy, because the graft polymer-generated region can be determined by photoirradiation.

Although the detailed mechanism of the graft pattern-forming method of the present invention is yet to be understood, it seems that a high oil- and water-repellent graft polymer pattern is formed easily on the solid surface, because the polymerization reaction according to the present invention, any embodiment is a free radical polymerization reaction higher in polymerization rate and demanding no strict control.

The graft pattern thus obtained according to Claim 10 of the present invention, which has an oil- and water-repellent functional group and a freely mobile graft polymer at one terminal and a highly oil- and water-repellent region in an arbitrary region, is useful in wider application fields.
The lithography method according to Claim 11 of the present invention is characterized by using the graft pattern having an oil- and water-repellent functional group obtained by the method of forming a graft pattern according to the present invention as an etching stopper.

After intensive studies, the present inventors have found that it was possible to achieve the second object by using a base material having a function to generate polymerization-initiating active sites locally by photoirradiation, forming graft polymers having a highly oil- and water-repellent functional group such as of a fluorine compound in a pattern form by using the polymerization-initiating active sites as initial points, and using the pattern material.

The method of forming a conductive pattern of the present invention comprises a process of depositing a raw conductive material on the no-graft-polymer-generated region formed by the graft pattern-forming method.
In the method of forming a conductive pattern according to the present invention, the process of depositing a raw conductive material on the no-graft-polymer-generated region is performed by one of the following four methods.
The first method is a method of applying a liquid containing conductive fine particles on the no-graft-polymer-generated region and drying the liquid. The method gives a conductive pattern of conductive fine particles deposited in the no-graft-polymer-generated region. In a favorable embodiment, the liquid containing conductive fine particles is heated after application.
The second method is a method of applying a liquid containing metal oxide fine particles on the no-graft-polymer-generated region and reducing and then heating the metal oxide fine particles. The method gives a conductive pattern of a sintered metal fine particle layer formed in the no-graft-polymer-generated region.
The third method is a method of activating the no-graft-polymer-generated region and subjecting the activated region to electroless plating. The method gives a conductive pattern formed by plating in the no-graft-polymer-generated region.
The fourth method is a method of forming a conductive polymer layer on the no-graft-polymer-generated region. The method gives a conductive pattern of a conductive polymer layer formed in the no-graft-polymer-generated region.

In any embodiment above, the graft polymer according to the present invention is generated rapidly in free radical polymerization reaction without need for strict control of the reaction. Seemingly for that reason, a highly oil- and water-repellent the pattern of a graft polymer-generated region and a non-generated region is formed easily on the base material surface.
Because the film thickness in the graft polymer-generated region is larger than that of the monomolecular film by using a conventional fluorine compound, there is a barrier effect in addition to the difference in contact angle between the graft polymer-generated region and the non-generated region in the present invention. Seemingly for that reason, it is possible to deposit a raw conductive material in a larger amount in the no-graft-polymer-generated region and consequently to make the layer more conductive.
As a result, the conductive pattern obtained by the method of forming a conductive pattern of the present invention is higher in conductivity and superior in quality.

After intensive studies, the inventors have also found that it was possible to achieve the third object by using a base material having a function to generate polymerization-initiating active sites locally by photoirradiation, and then forming graft polymers having a highly oil- and water-repellent functional group such as of a fluorine compound in a pattern form by using the polymerization-initiating active sites as initial points, and using the pattern material, and completed the present invention.

Thus, the first embodiment of the method of producing a color filter of the present invention is a method of producing a color filter having multiple pixels and partitions separating the neighboring pixels on a transparent base material, the method comprising a process of forming the partitions by bringing a radically polymerizable compound having a oil- and water-repellent functional group into contact with a transparent base material surface that generates radicals by photoirradiation, photoirradiating the transparent base material in a patterned form, and thus, generating graft polymers from the radicals generated in the exposure region as the initial points, and a process of forming pixels in the no-graft-polymer-generated region by using a liquid containing a colorant.

Thus in the embodiment above, a transparent base material having a function to generate radicals by photoirradiation should be used.
Examples of the transparent base materials include (1) transparent base materials containing a radical generator, (2) transparent base materials containing a polymer compound having a radical-generating site, (3) transparent base materials prepared by coating a coating solution containing a polymer compound having on the side chain a crosslinking site and a radical-generating site on a substrate surface and then drying the coating solution on a substrate surface to form a crosslinked structure in the coated film crosslinked structure, and the like.

Alternatively in the method of forming a color filter according to the present invention, it is possible to use a transparent base material having a radical-generating region in a patterned form formed by other means on the surface, not a transparent base material itself containing a radical-generating compound as described above, and generate graft polymers from the radicals as initial points.
Embodiments of such methods include the second to fourth embodiments shown below.

Thus, a second embodiment of the method of producing a color filter according to the present invention is a method of producing a color filter having multiple pixels and partitions separating the neighboring pixels on a transparent base material, the method comprising a process of generating radicals in an exposure region of a base material by bringing a hydrogen-abstraction radical generator into contact with the transparent base material surface and photoirradiating the transparent base material in a patterned shape, a process of forming partitions by bringing a radically polymerizable compound having a oil-and water-repellent functional group into contact with the transparent base material surface and graft-polymerizing the radically polymerizable compound by using the radicals generated in the exposure region as initial points into graft polymers, and a process of forming pixels in the no-graft-polymer-generated region by using a liquid containing a colorant.

A third embodiment of the method of producing a color filter according to the present invention is a method of producing a color filter having multiple pixels and partitions separating the neighboring pixels on a transparent base material, the method comprising a process of bonding a compound having a polymerization-initiating site capable of initiating radical polymerization by photocleavage onto a transparent base material surface in a patterned form, a process of forming partitions by bringing the radically polymerizable compound having a oil- and water-repellent functional group into contact with the transparent base material and photoirradiating the entire surface, and thus, generating graft polymer by using the polymerization-initiating sites as initial points, and a process of forming pixels in the no-graft-polymer-generated region by using a liquid containing a colorant.

The process of bonding a compound having a polymerization-initiating site capable of initiating radical polymerization by photocleavage (hereinafter, suitably referred to as "photocleavable compound") on to a transparent base material surface in a patterned form bond is not particularly limited and examples thereof include a method of bonding a photocleavable compound over the entire transparent base material surface and decomposing (inactivating) the polymerization-initiating sites in the exposure region by patternwise photoirradiation, a method of depositing and bonding a photocleavable compound on the base material surface in the patterned form by microcontact printing, and the like.
Considering the resolution of the pattern obtained and application thereof to digital data, preferable is use of a method including a process of bonding a compound having a polymerization-initiating site capable of initiating radical polymerization by photocleavage and a base material-bonding site to the transparent base material surface and a process of inactivating the polymerization-initiating sites in the exposure region by patternwise photoirradiation as in the method of producing a color filter of Claim 7 of the present invention.

Alternatively, the fourth embodiment the method of producing a color filter of the present invention is a method of producing a color filter having multiple pixels and partitions separating the neighboring pixels on a transparent base material, the method comprising a process of bonding a compound having a polymerization-initiating site capable of initiating radical polymerization by photocleavage and a base material-bonding site to the transparent base material surface, a process of forming partitions by bringing the radically polymerizable compound having a oil- and water-repellent functional group into contact with the transparent base material, performing patternwise photoirradiation, and thus, the generating graft polymers by using the polymerization-initiating sites in the exposure region as initial points, and a process of forming pixels in the no-graft-polymer-generated region by using a liquid containing a colorant, which are preformed in this order.

In a preferred embodiment of the present invention, the polymerization-initiating site generating a polymerization-initiating active site preferably contains a bond selected from the group consisting of a C-C bond, a C-N bond, a C-O bond, a C-Cl bond, a N-O bond and a S-N bond.

In any embodiment of the method of producing a color filter of the present invention, the graft polymer is generated rapidly in free radical polymerization reaction without need for strict control of the reaction. Seemingly for that reason, a highly oil- and water-repellent the pattern of a graft polymer-generated region and a non-generated region is formed easily on the transparent base material surface.
In addition, when a liquid containing a colorant is applied on the no-graft-polymer-generated region thus formed, the liquid containing a colorant does not remain in the generated region by the high oil- and water repellency of the graft polymer-generated region, leaving accurately formed pixels.
As a result, the color filter prepared by the method of producing a color filter of the present invention becomes superior in quality.

Alternatively, after intensive studies, the inventors have found that it was possible to achieve the fourth object by using a base material having a function to generate polymerization-initiating active sites locally by photoirradiation, forming graft polymers having a highly oil- and water-repellent functional group such as of a fluorine compound in a pattern form by using the polymerization-initiating active sites as initial points, and using the pattern material, and completed the present invention.

Thus, the method of producing a microlens according to the present invention comprises a process of bonding a compound having a polymerization-initiating site capable of initiating radical polymerization by photocleavage onto a base material surface in a patterned shape, a process of forming a graft polymer-generated region and a non-generated region by applying an oil-repellent radically polymerizable compound having a functional group on the base material, photoirradiating the entire surface, and thus, preparing graft polymers from the polymerization-initiating sites as initial points, and a process of applying a microlens raw material fluid in the no-graft-polymer-generated region and hardening the microlens raw material fluid.

The process of bonding a compound having a polymerization-initiating site capable of initiating radical polymerization (hereinafter, suitably referred to as "photocleavable compound") by photocleavage onto a base material surface in a patterned shape is not particularly limited, and examples thereof include a method of bonding a photocleavable compound over the entire base material surface and decomposing (inactivating) the polymerization-initiating sites in the exposure region by desirably patternwise photoirradiation, a method of applying a photocleavable compound on the base material surface and bonding it thereto into a desired pattern by microcontact printing, and the like.
Considering the resolution of the pattern obtained and application thereof to digital data, preferable is use of a method including a process of bonding a compound having a polymerization-initiating site capable of initiating radical polymerization by photocleavage and a base material-bonding site to the base material surface and a process of inactivating the polymerization-initiating sites in the exposure region by patternwise photoirradiation, as in the method of producing a microlens of Claim 2 of the present invention.

The method of producing a microlens of Claim 3 of the present invention comprises a process of bonding a compound having a polymerization-initiating site capable of initiating radical polymerization by photocleavage and a base material-bonding site to the surface of a material surface, a process of forming a graft polymer-generated region and a non-generated region by applying an oil-repellent radically polymerizable compound having a functional group on the base material, performing patternwise photoirradiation, and thus, generating graft polymers by using the polymerization-initiating sites in the exposure region as initial points, and a process of applying a microlens raw material fluid in the no-graft-polymer-generated region and hardening the microlens raw material fluid, which are performed in this order.

In a preferred embodiment of the present invention, the polymerization-initiating site generating a polymerization-initiating active site preferably contains a bond selected from the group consisting of a C-C bond, a C-N bond, a C-O bond, a C-Cl bond, a N-O bond and a S-N bond.

In any embodiment of the method of producing a microlens of the present invention, the graft polymer is generated rapidly in free radical polymerization reaction from the polymerization-initiating sites photocleaved by photoirradiation as initial points without need for strict control of the reaction. Seemingly for that reason, a highly oil- and water-repellent the pattern of a graft polymer-generated region and a non-generated region is formed easily on the base material surface.
Because the film thickness in the graft polymer-generated region is larger than that of the monomolecular film by using a conventional fluorine compound there is a barrier effect, in addition to the difference in contact angle, generated between the graft polymer-generated region and the non-generated region in the present invention. Seemingly for that reason, it is possible to deposit a microlens raw material fluid in the no-graft-polymer-generated region more accurately.

### Effects of the Present Invention

The present invention provides a method of forming a graft pattern that allows formation of a high-resolution pattern directly, for example, according to digital data in a general-purpose exposure machine and also formation of a highly oil- and water-repellent region of a fluorine compound efficiently in a desired pattern efficient.
In addition, the graft pattern formed by the method according to the present invention is higher in resolution and has a highly oil- and water-repellent region even if it is a thin layer, and thus, useful in various fields, for example, as thin-layered etching resist, template for ejecting ink droplets in the inkjet method, and others.
The present invention also provides a lithography method allowing high-resolution etching, by using a high-resolution oil- and water-repellent graft pattern formed by the method of forming a graft pattern according to the present invention as an etching stopper.

The present invention also provides a conductive pattern-forming method by forming a pattern material having a patterned oil- and water-repellent region of a highly oil- and water-repellent compound such as a fluorine compound with a general-purpose exposure machine easily and producing a high-resolution high-accuracy conductive pattern by using the pattern material, and a conductive pattern obtained by the forming method.

The present invention further provides a method of producing a color filter by using a pattern material having a patterned oil- and water-repellent region of a highly oil- and water-repellent compound such as a fluorine compound that allows easy production of a color filter at low cost and high quality.
The present invention further provides a high-quality color filter.

In addition, the present invention provides a method of producing a microlens by using a pattern material having a patterned oil- and water-repellent region of a highly oil- and water-repellent compound such as a fluorine compound that allows easy production of a fine uniform microlens without a complicated process or expensive equipment.

### Brief Description of Drawings

Figure 1 is a schematic chart showing the steps up to the graft polymer-forming process in the third embodiment of the method of forming a graft pattern of the present invention.
Figure 2 is a schematic chart showing the photocleavable compound-bonding process and the graft polymer-generating process in the fourth embodiment of the method of forming a graft pattern of the present invention.

### Best Mode for Carrying Out the Invention

Hereinafter, the present invention will be described in detail.

### <First embodiment of the graft pattern-forming method of the present invention>

The first embodiment of the method of forming a graft pattern according to the present invention contains a process of forming a graft polymer-generated region and a non-graft polymer-generated region on the surface of a base material by bringing a radically polymerizable compound having an oil- and water-repellent functional group into contact with the base material surface capable of generating radicals by photoirradiation, and generating graft polymers from the radicals generated in the exposure region as initial points by patternwise photoirradiation on the base material (hereinafter, referred to as "graft polymer-generating process (A)").

The "base material capable of generating radicals by photoirradiation" used in the present process is, for example, a base material containing a radical generator. Examples of the radical generators include (1) low-molecular weight radical generators (hereinafter, referred to as "low-molecular weight radical generators") and (2) polymer compounds having a radical-generating site in its main or side chain thereof (hereinafter, referred to as "polymeric radical generators"). Hereinafter, the base material containing a low-molecular weight radical generator will be described as base material (1), and the base material containing a polymeric radical generator will be described as base material (2).
The base material may be prepared by adding a radical generator directly to the components constituting the base material, or forming a layer containing a radical generator (radical generator-containing layer) on an arbitrary substrate. When the base material has a substrate and a radical generator-containing layer, an undercoat layer may be formed between them, for improvement in adhesiveness.

Examples of the low-molecular weight radical generators used in the base material (1) include known radical generators such as acetophenones, benzophenones, Michler's ketone, benzoylbenzoate, benzoins, a-acyloxime esters, tetramethylthiuram monosulfide, trichloromethyltriazine and thioxanthone. Other examples thereof for use in the present invention include sulfonium salts and iodonium salts normally used as photochemical acid generators, because photochemical acid generators also function as a radical generator by photoirradiation.

Examples of the polymeric radical generators for use in the base material (2) include the polymer compounds having an active carbonyl group on the side chain thereof, wherein is described in paragraph numbers [0012] to [0030] of JP-A No. 9-77891, paragraph numbers [0020] to [0073] of JP-A No. 10-45927, and the like.
The molecular weight of the polymeric radical generator is preferably 1,000 to 300,000, and more preferably, 3,000 to 100,000, from the viewpoint of controllability in production.

The content of the low-molecular weight or polymeric radical generator may be selected properly according to the kind of the base material, the amount of the desired graft polymer generated, and the like.
Generally, the content of the low-molecular weight radical generator is preferably in the range of 0.1 to 40 % by mass based on the total solid content in the base material or in the radical generator-containing layer, and the content of the polymeric radical generator is preferably in the range of 1.0 to 50 % by mass based on the total solid content in the base material or in the radical generator-containing layer.

In addition to the low-molecular weight or the polymeric radical generator, a sensitizer may be added to the base material for improvement in sensitivity. Examples of the sensitizers include n-butylamine, triethylamine, tri-n-butylphosphine, thioxanthone derivatives, and the like.
The content of the sensitizer is preferably, approximately 50 to 200 % by mass, based on the radical generator.

Although a radical generator should be added to the base material itself in the base material (1) or (2) described above, it is possible to prepare a "base material capable of generating radicals by photoirradiation" by forming a layer capable of generating radicals on the surface of a substrate, as in the following base material (3).
Specifically, it is a base material (3) prepared by coating a coating solution containing a polymer compound having a crosslinking site and a radical-generating site on the side chain thereof on the surface of a substrate, drying the coating solution, and then forming a crosslinked structure in the coated film.
Specifically as for the base material (3), it is possible to obtain a "base material capable of generating radicals by photoirradiation", by forming a polymerization-initiation layer on a arbitrary substrate which immobilizes a polymer having a functional group capable of initiating polymerization and a group crosslinkable in crosslinking reaction. Photoirradiation of the polymerization-initiation layer surface in a patterned form generates radicals in the region.
Such a method of forming a polymerization-initiation layer is described, for example, in JP-A No. 2004-123837 in detail, and the polymerization-initiation layer may be applied to the present invention.

Advantageously, in the presence of a polymerization-initiation layer in the crosslinked structure, it is possible, for example, to prevent undesirable solubilization of the polymerization-initiating component when a liquid monomer component, specifically a radically polymerizable compound having an oil- and water-repellent functional group, is brought into contact; and thus, it is possible to perform efficient radical polymerization reaction because the strength of the polymerization-initiation layer is high and to improve the adhesiveness of the formed graft polymer with the base material.

In the present invention, under the graft polymer-generating process (A), a raw material for the desirable graft polymer, a radically polymerizable compound having an oil-and water-repellent functional group (e.g., oil-repellent monomer typified by fluorine-containing monomer) is brought into contact with the above base material surface; radicals are generated in the exposure region of the base material by pattern exposure; and grafting reaction of the radically polymerizable compound having an oil- and water-repellent functional group is initiated and advanced from the radicals as initial points. As a result, an oil- and water-repellent graft polymer is generated only in the exposure region of the base material.

Hereinafter, the method of preparing the graft polymer in the graft polymer-generating process (A) will be described in detail.
The graft polymer according to the present invention is generated by using a radically polymerizable compound having an oil- and water-repellent functional group as raw material and is grown from the radicals as initial points on the base material surface. During preparation of the graft polymer, a raw material, i.e., a radically polymerizable compound having an oil- and water-repellent functional group, is brought into contact with the base material. Examples of the contacting methods include a so-called non-solvent method of bringing the compound into contact alone, a method of coating a solution or dispersion of the compound, a method of dipping a base material into the solution or dispersion, and others.
When the raw material is brought into contact with the base material without solvent, the concentration of the radically polymerizable compound which has an oil- and water-repellent functional group is 100%, based on a composition that is brought into contact with the base material
The radically polymerizable compound having an oil- and water-repellent functional group is preferably used as a composition diluted with a solvent having solubility of the radically polymerizable compound, from the viewpoint of handling efficiency. The solvent for use is not particularly limited, preferable are methanol, acetone, methylethylketone, ethanol, hexane, heptane, benzene, toluene, and the like. Additives such as other monofunctional or multifunctional monomer, surfactant, and thickener may be added then as needed to the composition, together with the radically polymerizable compound having an oil- and water-repellent functional group.

For prevention of polymerization inhibition by oxygen during growing the graft polymer, contact of the composition containing a radically polymerizable compound having an oil- and water-repellent functional group with the base material and graft polymerization reaction thereof may be performed under an inert gas atmosphere such as of nitrogen, or alternatively, the composition containing a radically polymerizable compound having an oil-and water-repellent functional group after contact with the base material may be covered with a plate or film of a material transmitting the light for graft polymerization reaction such as glass, quartz, or a transparent plastic material.

In the graft polymer-generating process (A), any light may be used without restriction in patternwise photoirradiation for generating the graft polymer, if it is a light having a wavelength allowing generation of radicals from the base material capable of generating radicals by photoirradiation, and specifically favorable lights include ultraviolet and visible rays having a wavelength of 150 to 800 nm, preferably 200 to 600 nm.
Specific examples of the light sources include high-pressure mercury lamp, low-pressure mercury lamp, halogen lamp, xenon lamp, excimer laser, colorant laser, semiconductor laser, YAG laser, and the like.
For generating the graft polymer in desired region, it is needed to irradiate the region other than the desired conductive region accurately by the pattern irradiation. Scanning beam irradiation or masked irradiation by using a particular optical system allowing high-resolution patterned irradiation is favorable for the patternwise photoirradiation, and a photoirradiation method is selected properly according to the desired pattern resolution. Alternatively, a stepper irradiation by using an i-ray, KrF, or ArF stepper may be used.

Hereinafter, the radically polymerizable compound having an oil- and water-repellent functional group for use in the graft polymer-generating process (A) of the present invention will be described.
The radically polymerizable compound having an oil- and water-repellent functional group is not particularly limited, if it is a compound having an oil- and water-repellent functional group and a radically polymerizable group, and may be in any form of monomer, macromer, oligomer, or polymer.

### (Radically polymerizable compound having an oil- and water-repellent functional group)

Hereinafter, examples of the radically polymerizable compound having an oil- and water-repellent functional group favorably used in the graft polymer-generating process (A) are described.
In the present invention, the water-droplet contact angle of the formed graft polymer in air is desirably 90 degrees or more, for high discrimination between the oil- and water-repellent graft polymer-generated region and the non-generated region. The high oil-and water-repellency can be estimated from the surface atom content as determined by ESCA. For example, in the case of a silicon-containing silicon-based graft polymer, a high value of oil- and water-repellency is usually obtained, when the Si ratio in the surface elemental composition is 10 % by atom or more based on the total amount of Si, C, and O. Alternatively in the case of a fluorine-containing fluorine-based graft polymer, the F ratio in the surface elemental composition should be 30 % by atom or more based on the total amount of F, C, and O. For preparation of a graft polymer having such a surface atom content, the raw monomer should have a silicon content of at least 10 % by atom or more in the monomer when it is a silicon-based monomer, and a fluorine content of 30 % by atom or more when it is a fluorine-based monomer. Thus, it is important to use a monomer satisfying the requirements above, to obtain a high oil- and water-repellent graft polymer.
The macromer, oligomer, polymer, or the like used for preparation of a graft polymer having such a surface atom content should also have a silicon or fluorine atom content ratio in the molecule similar to that above.

Specific examples of the monomers having an oil- and water-repellent functional group satisfying the requirements above include fluorine-containing monomers, silicone-containing monomers, and the like.
Hereinafter, the fluorine- and silicone-containing monomers used in the present invention will be described.

### -Fluorine-containing monomer-

The fluorine-containing monomer for use in the graft polymer-generating process (A) is at least one fluorine-containing monomer selected from the groups consisting of the monomers represented by the following Formulae (I), (II), (III), (IV) and (V).

CH₂=CR¹COOR²R^{f} (I)

[wherein, R¹ represents a hydrogen atom or a methyl group; R² represents -CpH₂p-, -C(CₚH₂ₚ₊₁)H-, -CH₂C(CₚH₂ₚ₊₁)H-, or - CH₂CH₂O-; R^{f} represents -CₙF₂ₙ₊₁, -(CF₂)ₙH, -CₙF₂ₙ₊₁-CF₃, -(CF₂)ₚOCₙH₂ₙCᵢF₂ᵢ₊₁, -(CF₂)ₚOCₘH₂ₘCᵢF₂ᵢH, -N(CₚH₂ₚ₊₁)COCₙF₂ₙ₊₁, or -N(CₚH₂ₚ₊₁)SO₂CₙF₂ₙ₊₁; however, p is an integer of 1 to 10; n is an integer of 1 to 16; and m is an integer of 0 to 10; and i is an integer of 0 to 16].

CF₂=CFOR^{g} (II)

[wherein, R^{g} represents a fluoroalkyl group having 1 to 20 carbon atoms].

CH₂=CHR^{g} (III)

[wherein, R^{g} represents a fluoroalkyl group having 1 to 20 carbon atoms].

CH₂=CR³COOR⁵R^{j}R⁶OCOCR⁴=CH₂ (IV)

[wherein, R³ and R⁴ each independently represent a hydrogen atom or a methyl group; R⁵ and R⁶ each independently represent -C_{q}H_{2q}-, -C(C_{q}H_{2q+1})H-, -CH₂C(C_{q}H_{2q+i})H-, or - CH₂CH₂O-; R^{j} represents -Cₜ F₂ₜ; however, q is an integer of 1 to 10, and t is an integer of 1 to 16].

CH₂=CHR⁷COOCH₂(CH₂R^{k})CHOCOCR⁸=CH₂ (V)

[wherein, R⁷ and R⁸ each independently represent a hydrogen atom or a methyl group; R^{k} represents -CyF_{2y+1}; however, y is an integer of 1 to 16].

Hereinafter, specific examples of the fluorine-containing monomers for use in the graft polymer-generating process (A) will be listed, however the present invention is not restricted thereby.
Examples of the monomers represented by Formula (I) include CF₃(CF₂)₇CH₂CH₂OCOCH=CH₂, CF₃CH₂OCOCH=CH₂, CF₃(CF₂)₄CH₂CH₂OCOC(CH₃)=CH₂, C₇F₁₅CON(C₂H₅)CH₂OCOC(CH₃)=CH₂, CF₃(CF₂)₇SO₂N(CH₃)CH₂CH₂OCOCH=CH₂, CF₃(CF₂)₇SO₂N(C₃H₇CH₂CH₂OCOCH=CH₂, C₂F₅SO₂N(C₃H₇)CH₂CH₂OCOC(CH₃)=CH₂, (CF₃)₂CF(CF₂)₆(CH₂)₃OCOCH=CH₂, (CF₃)₂CF(CF₂)₁₀(CH₂)₃OCOC(CH₃)=CH₂, CF₃(CF₂)₄CH(CH₃)OCOC(CH₃)=CH₂,

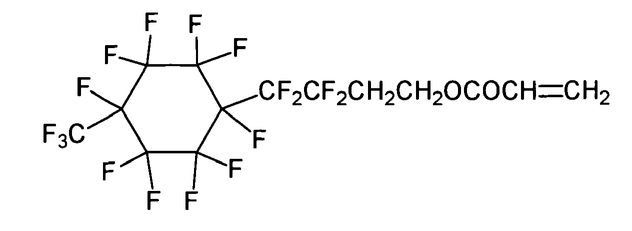

CF₃CH₂OCH₂CH₂OCOCH=CH₂, C₂F₅(CH₂CH₂O)₂CH₂OCOCH=CH₂, (CF₃)₂CFO(CH₂)₅OCOCH=CH₂, CF₃(CF₂)₄OCH₂CH₂OCOC(CH₃)=CH₂, C₂F₅CON(C₂H₅)CH₂OCOCH=CH₂, CF₃(CF₂)₂CON(CH₃)CH(CH₃)CH₂OOCOCH=CH₂, H(CF₂)₆C(C₂H₅)OCOC(CH₃)=CH₂, H(CF₂)₈CH₂OCOCH=CH₂, H(CF₂)₄CH₂OCOCH=CH₂, H(CF₂)CH₂OCOC(CH₃)=CH₂,

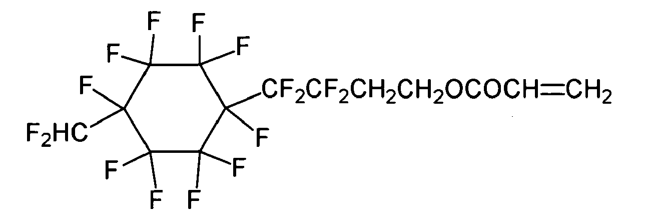

CF₃(CF₂)₇SO₂N(CH₃)CH₂CH₂OCOC(CH₃)=CH₂, CF₃(CF₂)₇SO₂N(CH₃)(CH₂)₁₀OCOCH=CH₂, C₂F₅SO₂N(C₂H₅)CH₂CH₂OCOC(CH₃)=CH₂, CF₃(CF₂)₇SO₂N(CH₃)(CH₂)₄OCOCH=CH₂, C₂F₅SO₂N(C₂H₅)C(C₂H₅)HCH₂OCOCH=CH₂, and the like.

Examples of the fluoroalkylated olefins represented by Formulae (II) and (III) include C₃F₇CH=CH₂, C₄F₉CH=CH₂, C₁₀F₂₁CH=CH₂, C₃F₇OCF=CF₂, C₇F₁₅OCF=CF₂, C₈F₁₇OCF=CF₂, and the like.

Examples of the monomers represented by Formulae (IV) and (V) include CH₂=CHCOOCH₂(CF₂)₃CH₂OCOCH=CH₂, CH₂=CHCOOCH₂CH(CH₂CₛF₁₇)OCOCH=CH₂, and the like.

It is possible to use another monomer containing no fluorine as the monomer for preparation of the fluorine-containing graft polymer in combination with the fluorine-containing monomer above in the range that does not impair the advantageous effects of the present invention. The monomer is not particularly limited, if it is radically polymerizable, and specific examples thereof include; unsaturated carboxylic acids such as (meth)acrylic acid, maleic acid, fumaric acid, and itaconic acid; the alkyl or glycidyl esters thereof, styrene; vinyl esters of alkyl acid; silicon-containing monomers, and the like. The content of the monomer when used in combination is preferably 50 % by mass or less based on the fluorine-containing monomer.

### -Silicon-containing monomer-

Examples of the silicon-containing monomers for use in the graft polymer-generating process (A) include silicon-containing monomers having group SiCH₃ or O-Si-CH₃ group. A specific example thereof is silicone acrylate or silicone methacrylate, represented by a Formula: (CH₃O)ₙSi(CH₃)₃-n-R³-O-CO-CR⁴=CH₂ (n is an integer of 0 to 3), wherein R³ represents a connecting group, and R⁴ represents methyl or hydrogen. Other favorable examples thereof include the silicon-based monomers described in paragraph number [0025] of JP-A No. 2003-335984.

These monomers having an oil- and water-repellent functional group may be used alone or as a mixture of two or more.

It is preferable to remove the homopolymer remaining on the base material having a graft polymer-generated region and a non-generated region thus formed, for example, by immersing and purifying the base material in solvent. Specifically, the base material is purified by washing with water or acetone and drying, or the like. Use of a means such as ultrasonic wave irradiation is preferable, from the viewpoint of removing efficiency of the homopolymer
After purification, the residual homopolymer on the base material surface is removed completely, and there is only a patterned oil- and water-repellent graft polymer tightly bound to the base material.

### <Second embodiment of the method of forming a graft pattern according to the present invention>

Hereinafter, the second embodiment of the method of forming a graft pattern according to the present invention will be described.
The second embodiment of the method of forming a graft pattern according to the present invention is characterized by including a process of generating radicals in an exposure region of a base material by bringing a hydrogen-abstraction radical generator into contact with the base material surface and performing patternwise photoirradiation on the base material (hereinafter, referred to as "radical-generating process") and a process of bringing a radically polymerizable compound having an oil- and water-repellent functional group into contact with the base material surface, and generating graft polymers by using the radicals generated in the exposure region as initial points to form a graft polymer-generated region and a non-graft polymer-generated region on the base material surface (hereinafter, referred to as "graft polymer-generating process (B)").

In the second embodiment of the present invention, under the radical-generating process, radicals are generated on the exposure region by bringing a hydrogen-abstraction radical generator into contact with the base material surface and performing patternwise photoirradiation.
The radical-generating process and the graft polymer-generating process (B) preferable proceed simultaneously, for more efficient utilization of the radicals generated in preparation of the graft polymer. That is, radical generation on the base material surface and graft polymerization from the radicals as initial points preferably proceed almost simultaneously.
Specifically, used is a method of bringing mixture of a hydrogen-abstraction radical generator and a radically polymerizable compound having an oil- and water-repellent functional group into contact with the base material and performing patternwise photoirradiation on the base material. By the patternwise photoirradiation, the hydrogen-abstraction radical generator abstracts hydrogen from the base material surface, generating active radicals in the exposure region, and graft polymerization of the radically polymerizable compound starts from the radicals as initial points. As a result, graft polymers having an oil- and water-repellent functional group are formed only in the exposed region of the base material.

Examples of the hydrogen-abstraction radical generators include benzophenones, thioxanthones, and the like.
For contact of the hydrogen-abstraction radical generator with the base material, used is a method of dissolving or dispersing the radical generator in a suitable solvent such as methylethylketone or 1-methoxy-2-propanol and coating the solution or dispersion on the base material surface, a method of dipping the base material in the solution or dispersion, or the like. The concentration of the hydrogen-abstraction radical generator in such a solution or dispersion is preferably, approximately 0.1 to 10 % by mass.
A solution or dispersion containing hydrogen-abstraction radical generator additionally containing an added radically polymerizable compound having an oil- and water-repellent functional group is used, for bringing the hydrogen-abstraction radical generator and the radically polymerizable compound having an oil- and water-repellent functional group simultaneously into contact with the base material surface.

In the graft polymer-generating process (B) in the second embodiment of the present invention, if the processing is conducted simultaneously with the radical-generating process as described above, a solution or dispersion containing both a hydrogen-abstraction radical generator and a radically polymerizable compound having an oil- and water-repellent functional group is used for contact thereof with the base material, and other method, condition, and the like are the same as those for the graft polymer-generating process (A) in the first embodiment of the present invention.
In the graft polymer-generating process (B), regions containing and not containing the graft polymers, which have an oil- and water-repellent functional group, are formed.

### <Third embodiment of the method of forming a graft pattern according to the present invention>

In the third embodiment, the graft pattern-forming method according to the present invention includes a process of bonding a compound having a polymerization-initiating site capable of initiating radical polymerization by photocleavage (photocleavable compound) on the base material surface in a patterned form.
For example, a method of bonding a photocleavable compound over the entire base material surface and decomposing (inactivating) the polymerization-initiating sites in the exposure region by patternwise photoirradiation, or a method of depositing and bonding a photocleavable compound on the base material surface in a patterned form by microcontact printing can be used in the process.
Most preferable in the embodiment is a method including a process of bonding a compound having a polymerization-initiating site capable of initiating radical polymerization by photocleavage and a base material-bonding site to the base material surface (hereinafter, referred to as "photocleavable compound-bonding process (A)") and a process of inactivating the polymerization-initiating sites in the exposure region by patternwise photoirradiation (hereinafter, "polymerization initiating potential-inactivating process").

In the third embodiment, the graft pattern-forming method according to the present invention includes a process of forming a graft polymer-generated region and a non-generated region on the base material surface by bringing a radically polymerizable compound having an oil- and water-repellent functional group into contact with the base material, photoirradiating the entire surface, and thus, preparing graft polymers from the polymerization-initiating sites as initial points (hereinafter, referred to as "graft polymer-generating process (C)".

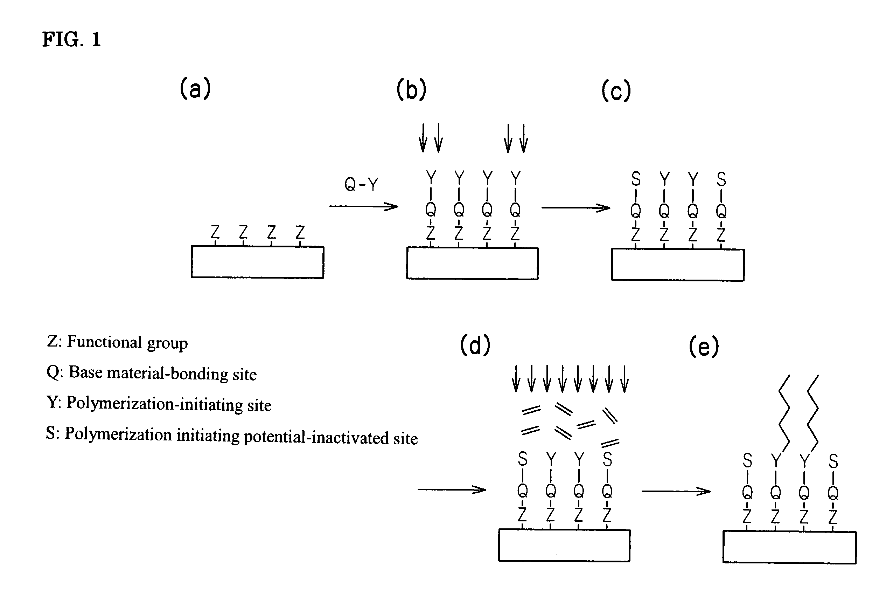

Hereinafter, respective processes to the graft polymer-generating process (C) will be described briefly, taking the third embodiment of the present invention as the most favorable embodiment, with reference to Figure 1.
Figure 1 is an exemplary schematic chart illustrating the processes to the graft polymer-generating process (C) in the third embodiment of the method of forming a conductive pattern according to the present invention.

As shown in Figure 1 (a), the base material surface has functional groups (represented by Z in the Figure) from the beginning. A compound (Q-Y) having a base material-bonding site (Q) and a polymerization-initiating site (Y) capable of initiating radical polymerization by photocleavage is then brought into contact with the base material surface. As shown in Figure 1(b), the functional group (Z) present on the base material surface and the base material-bonding site (Q) bind to each other, introducing the compound (Q-Y) on the base material surface (photocleavable compound-bonding process (A)).
The compound (Q-Y)-introduced face is then pattern-irradiated, as indicated by the arrow in Figure 1(b). The polymerization-initiating site (Y) is cleaved by the irradiation energy. As a result, as shown in Figure 1(c), the compound (Q-Y) in the exposure region becomes a compound having a polymerization initiating potential-inactivated site (S), by decomposition and inactivation of the polymerization-initiating site (Y) (polymerization initiating potential-inactivating process).
Then as shown in Figure 1(d), the entire surface is exposed to light while a raw material for graft polymer such as a monomer having an oil- and water-repellent functional group is in contact, as indicated by the arrow in Figure 1 (d). As shown in Figure 1 (e), a graft polymer is grown from the polymerization-initiating site (Y) of the compound (Q-Y) as an initial point in the region where the polymerization-initiating site (Y) is preserved [graft polymer-generating process (C)].

Hereinafter, each of the processes above will be described specifically.
The group represented by Z in Figure 1 is a functional group present on the base material surface, and specifically, for example, a hydroxyl, carboxyl or amino group, or the like. The functional group may be the group inherently present on the base material surface of silicon or glass, or a group additionally formed by surface treatment of the base material surface, for example, by corona discharge treatment.

The base material for use in the present invention is not particularly limited, and examples thereof include base materials having a functional group (Z) such as a hydroxy, carboxyl, or amino group on the surface, and base materials having a functional group such as a hydroxyl or carboxyl group generated by surface treatment such as corona discharge treatment, glow treatment, or plasma treatment.
Generally, a flat plate-shaped base material is used, however the base material is not limited to a flat plate-shaped base material, and thus, the graft polymer may be introduced on the surface of a base material in any other shape such as cylindrical.

Specific examples of the base materials favorable in the present invention include various base materials, for example, the base materials which surface thereof has hydroxyl groups: such as glass, quartz, ITO, and silicon; and the base materials which surface thereof has hydroxyl or carboxyl groups generated by surface treatment such as corona discharge treatment, glow treatment or plasma treatment: for example plastic base materials, such as of PET, polypropylene, polyimide, epoxy, acryl, and urethane, and the like.
The thickness of the base material varies according to applications and is not particularly limited, but generally, approximately 10 µm to 10 cm.

Hereinafter, the structure of the compound having a polymerization-initiating site capable of initiating radical polymerization by photocleavage (hereinafter, simply referred to as polymerization-initiating site) and a base material-bonding site (photocleavable compound) will be described in detail.
When the photocleavable compound is described in detail by using the model of the compound (Q-Y) having a base material-bonding site (Q) and a polymerization-initiating site (Y) in the schematic chart of Figure 1, the polymerization-initiating site (Y) generally has a structure containing a single bond that cleaves by photoirradiation.
The photocleavable single bond is, for example, a single bond that is broken in the α-and β-carbonyl cleavage reaction, photo-Fries rearrangement reaction, phenacyl ester cleavage reaction, sulfonimide cleavage reaction, sulfonyl ester cleavage reaction, N-hydroxysulfonyl ester cleavage reaction, benzyl imide cleavage reaction, activated halogenated compound cleavage reaction, or the like. The photocleavable single bond is broken by such a reaction. Examples of the cleavable single bonds include C-C, C-N, C-O, C-Cl, N-O, and S-N bonds, and the like.

The polymerization-initiating site (Y) containing a photocleavable single bond becomes the initial point of graft polymerization in the graft polymer-generating process (C), and thus, has a function to generate a radical in cleavage reaction when the photocleavable single bond is cleaved. Examples of such structures of a polymerization-initiating site (Y), which have a photocleavable single bond capable of generating a radical, include structures having a group such as an aromatic ketone, phenacyl ester, sulfonimide, sulfonyl ester, N-hydroxysulfonyl ester, benzylimide, trichloromethyl, or benzyl chloride group.

Such a polymerization-initiating site (Y) generates a radical by photocleavage, and thus, when polymerizable compounds are present in the area around the radical, a desired graft polymer, and thus a graft polymer-generated region, is formed, while the radical functioning as an initial point of graft polymerization reaction.
On the other hand, when there is no polymerizable compound in the area around the radical, the radical is inactivated without use even when it is generated by photoirradiation cleavage of the polymerization-initiating site (Y), and as a result, the polymerization-initiating potential is also inactivated. As a result, the region becomes a no-graft-polymer-generated region.

On the other hand, the base material-bonding site (Q) is a reactive group bonding to the functional group (Z) present on the base material surface, and specific examples of the reactive groups include the following groups.

Base material-bonding group Q: -Si(OMe)₃, -SiCl₃, -NCO, -CH₂Cl

The polymerization-initiating site (Y) and the base material-bonding site (Q) may be connected to each other directly or via a connecting group. Examples of the connecting groups include those containing atoms selected from the group consisting of carbon, nitrogen, oxygen and sulfur, and specific examples thereof include saturated carbon groups, aromatic groups, ester groups, amido groups, ureido groups, ether groups, amino groups, sulfonamido groups, and the like. The connecting group may have an additional substituent group, and examples of the substituent groups that may be introduced include alkyl groups, alkoxy groups, halogen atoms, and the like.

Specific examples of the compounds (Q-Y) having a base material-bonding site (Q) and a polymerization-initiating site (Y) are listed below (exemplary compounds 1 to 16), together with the cleavage sites, however the present invention is not particularly restricted thereby

C-C bond cleavage compound

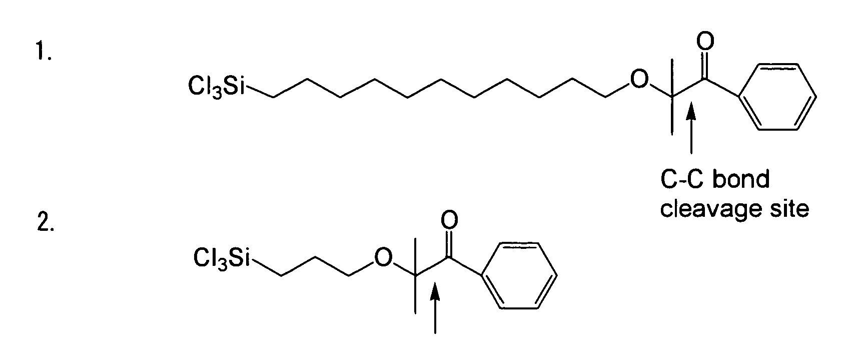

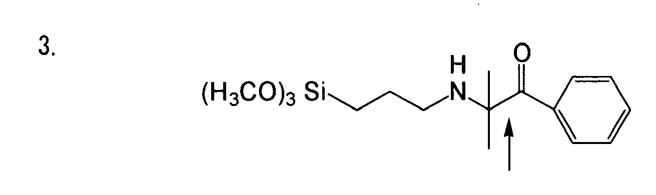

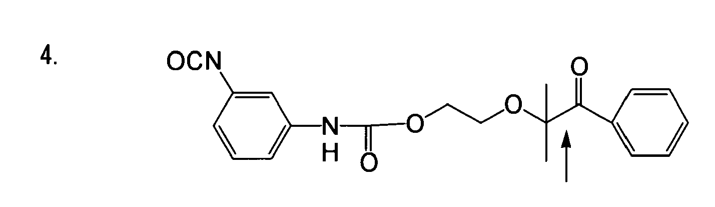

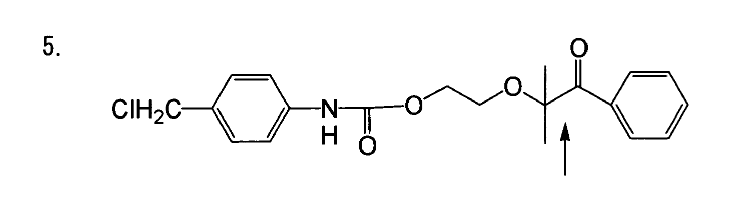

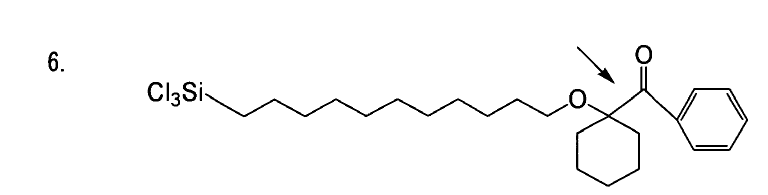

C-O bond cleavage compound 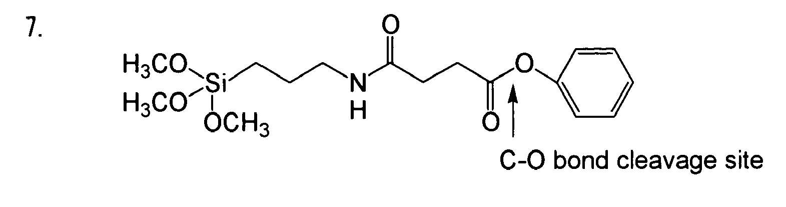 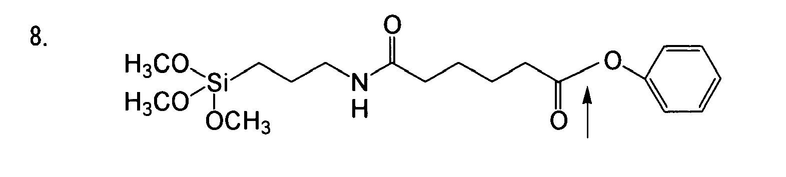 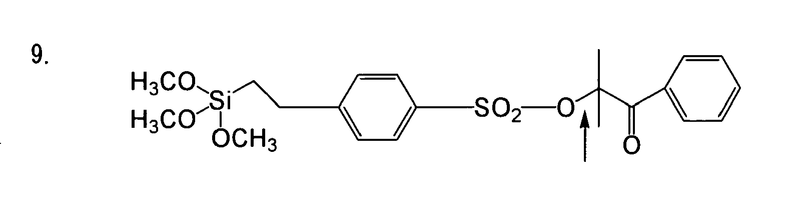 S-N bond cleavage compound

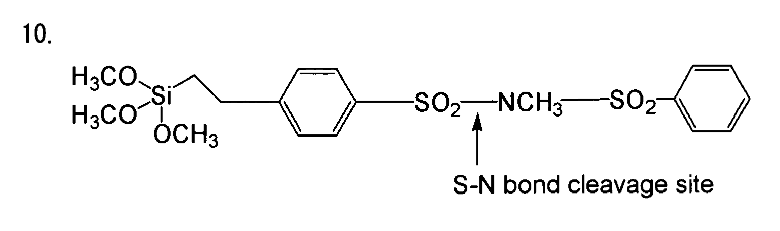

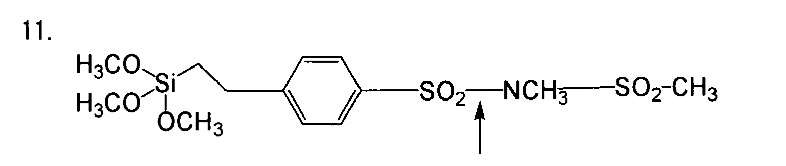

C-N bond cleavage compound 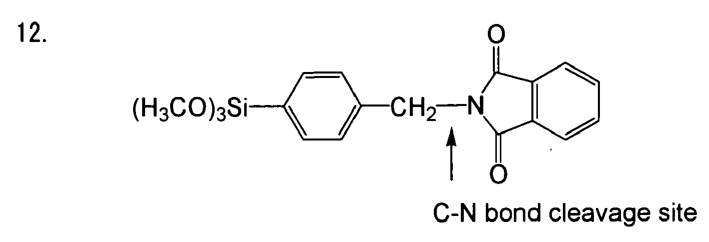 N-O bond cleavage compound 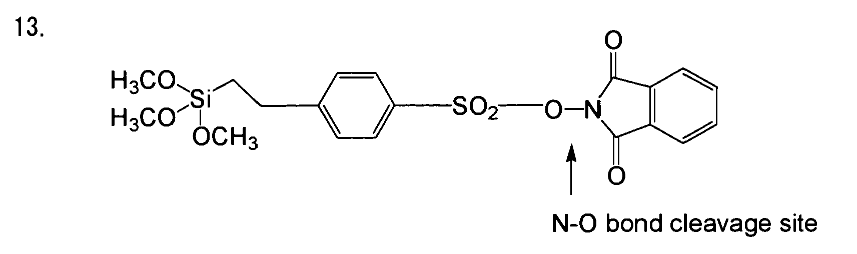 C-Cl bond cleavage compound

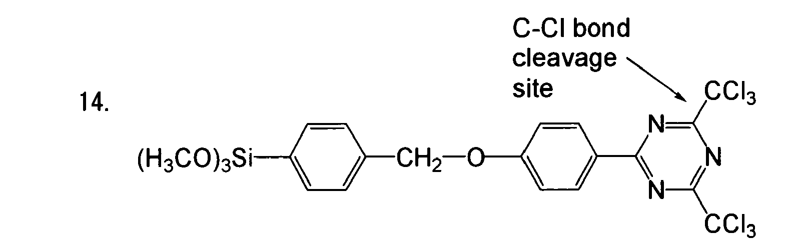

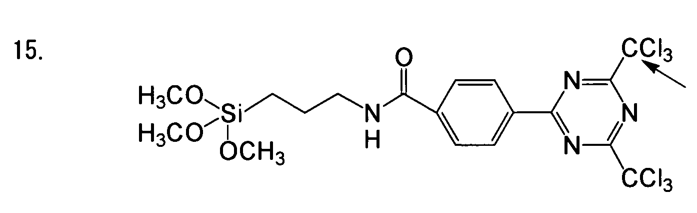

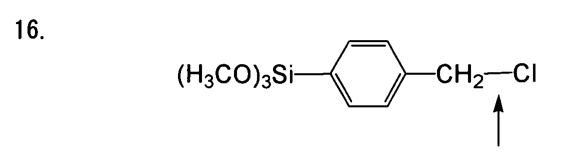

The photocleavable compound-bonding process (A) according to the present invention is a process of bonding the compound (Q-Y) to the base material.
For example for bonding the exemplified compound (Q-Y) to the functional group (Z) present on the base material surface, a method of coating the solution or dispersion, which dissolve or disperse a compound (Q-Y) in a suitable solvent such as toluene, hexane or acetone, on the base material surface, or dipping the base material in the solution or dispersion may be used. The concentration of the compound (Q-Y) in the solution or dispersion then is preferably 0.01 to 30 % by mass, particularly preferably 0.1 to 15 % by mass. The liquid temperature when in contact is preferably 0°C to 100°C. The contact period is preferably 1 second to 50 hours, more preferably 10 seconds to 10 hours.

Then in the polymerization initiating potential-inactivating process, the compound (Q-Y) bound to the base material surface is photocleaved and the polymerization-initiating potential is inactivated by patternwise photoirradiation in the region where generation of the graft polymer is desirably prevented. As a result, a polymerization initiation-allowing region and a polymerization initiating potential-inactivated region are formed on the base material surface.
In the polymerization initiating potential-inactivating process, the resolution of the pattern, which consists of the polymerization initiation-allowing region and the polymerization-initiating-potential-inactivated region, depends on the photoirradiation condition.
The patternwise photoirradiation methods for obtaining high resolution include, for example, scanning beam irradiation by using a particular optical system, masked irradiation, and the like, and a photoirradiation method suitable for the desired resolution of pattern is selected. Specifically, a stepper exposure, for example by using an i-ray stepper, KrF stepper, or ArF stepper, can be used.

The base material having the polymerization initiation-allowing region and the polymerization-initiating-potential-inactivated region thus formed is then processed in the graft polymer-generating process (C).
In the graft polymer-generating process (C), grafting reaction of the radically polymerizable compound having an oil- and water-repellent functional group is initiated and advanced from the radicals as initial points, by bringing a material for the desirable graft polymer, i.e., a radically polymerizable compound having an oil- and water-repellent functional group (e.g., oil-repellent monomer typified by fluorine-containing monomer), into contact with the base material having a polymerization initiation-allowing region and a polymerization-initiating-potential-inactivated region, photoirradiating the entire surface, and thus, generating radicals by photocleavage of the polymerization-initiating sites (Y) in the polymerization initiation-allowing region. As a result, an oil- and water-repellent graft polymer is generated, only in the polymerization initiation-allowing region.

The method of preparing the graft polymer in the graft polymer-generating process (C), the condition thereof, and others are the same as those in the graft polymer-generating process (A) of the first embodiment described above, except that the entire surface is irradiated.
Because a photocleavable compound-containing layer is formed on the base material surface in the third embodiment, for prevention of uneven generation of the graft polymer by surface solubilization of the photocleavable compound-containing layer, it is preferable to select a solvent and other compounds having a physical property that does not dissolve the photocleavable compound-containing layer when the composition containing a radically polymerizable compound having an oil- and water-repellent functional group is brought into contact with the base material, as those contained in the composition containing the radically polymerizable compound.
The radically polymerizable compound having an oil- and water-repellent functional group used in the graft polymer-generating process (C) is also the same as that used in the graft polymer-generating process (A).

Any light may be used without restriction in photoirradiation (patternwise photoirradiation and entire-surface irradiation) in the third embodiment of the present invention, if it can cleave the polymerization-initiating site (Y) of the photocleavable compound by irradiation, and an ultraviolet or visible ray specifically having a wavelength of 200 to 800 nm, preferably 200 to 600 nm, is preferable.
Specific examples of the light sources include high-pressure mercury lamp, low-pressure mercury lamp, halogen lamp, xenon lamp, excimer laser, colorant laser, semiconductor laser, YAG laser, and the like.

### <Fourth embodiment of the method of forming a graft pattern according to the present invention>

Hereinafter, the fourth embodiment of the method of forming a graft pattern according to the present invention will be described.
In the fourth embodiment, the graft pattern-forming method according to the present invention includes a process of bonding a compound having a polymerization-initiating site capable of initiating radical polymerization by photocleavage and a base material-bonding site to the surface of a material surface (hereinafter, referred to as "photocleavable compound-bonding process (B)") and a process of generating graft polymers from the polymerization-initiating sites in an exposure region as an initial points after bringing a radically polymerizable compound having an oil- and water-repellent functional group into contact with the base material and then performing patternwise photoirradiation to form a graft polymer-generated region and a non-generated region (hereinafter, suitably referred to as "graft polymer-generating process (D)"), which are performed in this order.

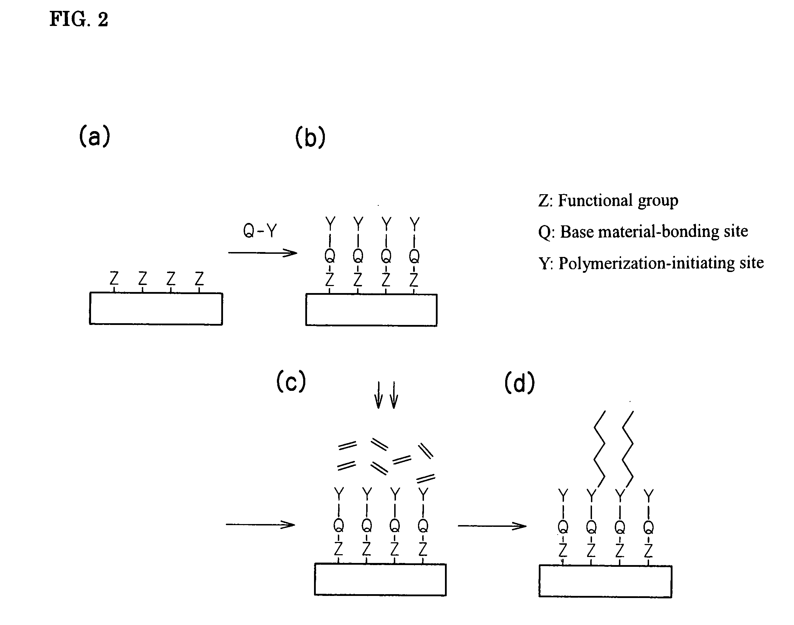

Hereinafter, the photocleavable compound-bonding process (B) and the graft polymer-generating process (B) in the fourth embodiment of the present invention will be described briefly, with reference to Figure 2.
Figure 2 is an exemplary schematic chart illustrating the photocleavable compound-bonding process (B) and the graft polymer-generating process (D) in the method of forming a conductive pattern in the fourth embodiment of the present invention.
As shown in Figure 2(a), the base material has functional groups (indicated by Z in the Figure) on the base material surface from the beginning. A compound (Q-Y) having a base material-bonding site (Q) and a polymerization-initiating site (Y), which is capable of initiating radical polymerization by photocleavage, is brought into contact with the base material surface. As shown in Figure 2(b), the functional group (Z) present on the base material surface and the base material-bonding site (Q) bind to each other, and the compound (Q-Y) is introduced on the base material surface [photocleavable compound-bonding process (B)].
Then as shown in Figure 2(c), patternwise photoirradiation is performed in the presence of a known raw graft polymer material such as monomer. Thus as shown in Figure 2(d), a graft polymer-generated region is formed in the exposed region by generation of graft polymers from the polymerization-initiating sites (Y) of the compound (Q-Y) as initial points, while a no-graft-polymer-generated region is formed, as no graft polymer is generated in the non-exposure region [graft polymer-generating process (D)].

Hereinafter, each of the processes above will be described in detail.
The group represented by (Z) in Figure 2 is the same as the functional group (Z) present on the base material surface described in the third embodiment, and specifically, for example, a hydroxyl, carboxyl or amino group, or the like.
The specific examples, shape, thickness, and others of the base material having the functional group (Z) are also the same as those in the third embodiment.

Hereinafter, the structure of the compound having a polymerization-initiating site capable of initiating radical polymerization by photocleavage (hereinafter, simply referred to as polymerization-initiating site) and a base material-bonding site will be described specifically. The compound (Q-Y) having a base material-bonding site (Q) and a polymerization-initiating site (Y) shown in the schematic chart of Figure 2 is the same as the compound (Q-Y) having a base material-bonding site (Q) and a polymerization-initiating site (Y) described in the third embodiment, and the structure and specific examples are also the same.
In the fourth embodiment, the polymerization-initiating sites (Y) capable of generating radicals are distributed over the entire base material surface in the graft polymer-generating process (D), because the polymerization-initiating sites are not inactivated previously by patternwise photoirradiation, as in the third embodiment.

When a radical is formed at the polymerization-initiating site (Y) by cleavage by patternwise photoirradiation, the radical, functioning as an initial point of graft polymerization reaction, induces growth of a desired graft polymer and gives a graft polymer-generated region, if there are polymerizable compounds in the area around the radical. On the other hand, there is no cleavage at the polymerization-initiating site (Y) and no growth of graft polymer in the non-exposure region, and thus, there is no graft-polymer-generated region formed.

The photocleavable compound-bonding process (B) according to the present invention is a process of bonding such a compound (Q-Y) to the base material. The method and condition used in the present process are the same as those in the photocleavable compound-bonding process (A) of the third embodiment.

In the graft polymer-generating process (D) of the present invention, grafting reaction of the radically polymerizable compound having an oil- and water-repellent functional group is initiated and advanced from the radicals as initial points, by bringing a material for the desirable graft polymer, i.e., a radically polymerizable compound having an oil- and water-repellent functional group (e.g., monomer having an oil-repellent functional group monomer), into contact with the base material after processing in the photocleavable compound-bonding process (B), performing patternwise photoirradiation, and thus, generating radicals by photocleavage of the polymerization-initiating sites (Y) in the exposed region. As a result, oil- and water-repellent graft polymers are generated only in the exposure region.
In the fourth embodiment of the present invention, the unphotocleaved compound (Q-Y) remains in the no-graft-polymer-generated region.

The method of bringing the radically polymerizable compound having an oil- and water-repellent functional group into contact with the base material surface in the graft polymer-generating process (D) may be the same as that in the graft polymer-generating process (A) of the first embodiment. The radically polymerizable compound having an oil-and water-repellent functional group for use in the graft polymer-generating process (D) is also the same as that described in the graft polymer-generating process (A) of the first embodiment.

The method for patternwise photoirradiation for use in the graft polymer-generating process (D) is not particularly limited, if a light having a wavelength allowing photocleavage of the polymerization-initiating site (Y) of photocleavable compound is used, and a specific light for use is a ultraviolet or visible ray having a wavelength similar to that described in the third embodiment.
Also in the graft polymer-generating process (D), the resolution of the pattern of a graft polymer-generated region and a non-generated region depends on the condition of patternwise photoirradiation. The patternwise photoirradiation methods for obtaining high resolution include, for example, scanning beam irradiation by using a particular optical system, masked irradiation, and the like, and a photoirradiation method suitable for the desired resolution of pattern is selected. Specifically, a stepper exposure, for example by using an i-ray, KrF, or ArF stepper, can be used.
A high-resolution pattern of a graft polymer-generated region and a non-generated region is formed in the graft polymer-generating process (D), and high-resolution patternwise photoirradiation gives a high-resolution pattern according to the irradiation.

### (Base material used in graft pattern-forming method)

The base material for use in the method of forming a graft pattern according to the present invention will be described below. The base material is not particularly limited in its constituent material, either organic, inorganic, or, organic/inorganic hybrid, if it has physical properties suitable for application as a conductive pattern, and selected properly according to the mechanism of the polymerization-initiating active site generated.
For example, an organic, inorganic, or organic/inorganic hybrid material is used as the material for the base material (1) or (2) in the first embodiment and the base material in the second embodiment.
When the base material (1) or (2) in the first embodiment has any radical generator-containing layer formed on a substrate, or when a polymerization-initiation layer is formed on a substrate as in the base material (3) of the first embodiment, the substrate may be either an organic material or an inorganic material.

Each of the base materials in the third and fourth embodiments should have a functional group such as hydroxyl, carboxyl or amino or alternatively, a hydroxyl, carboxyl, or other group generated by surface treatment such as corona treatment, glow treatment, or plasma treatment on its surface. Specific examples of the base materials include various base materials containing surface hydroxyl groups such as glass, quartz, and ITO, plastic base materials, such as of PET, polypropylene, polyimide, epoxy, acryl, and urethane, having surface hydroxyl and carboxyl groups generated by surface treatment such as corona treatment, glow treatment, plasma treatment, or the like.

Examples of the organic materials favorably used for the various base materials (substrates) above include acrylic resins such as polymethyl methacrylate; polyester resins such as polyethylene terephthalate, polyethylene naphthalate, poly-1,4-cyclohexanedimethylene terephthalate, polyethylene-1,2-diphenoxyethane-4,4'-dicarboxylate, and polybutylene terephthalate;
Commercially available products such as Epikote (trade name, manufactured by Yuka Shell Epoxy Co., Ltd.); epoxy resins, polycarbonate resins, polyimide resins, novolak resins, phenol resins, and the like.
Examples of other organic materials include cellulose esters (e.g., triacetylcellulose, diacetylcellulose, propionylcellulose, butyrylcellulose, and acetylpropionylcellulose, nitrocellulose), polyamides, polystyrenes (e.g., syndiotactic polystyrene), polyolefins (e.g., polypropylene, polyethylene, polymethylpentene), polysulfones, polyether sulfones, polyarylates, polyether imides, polyether ketones, and the like.

Examples of the inorganic materials for the various base materials (substrates) include
metal materials such as of glass, glass, quartz, silicon, iron, zinc, copper, and stainless steel; metal oxides such as tin oxide, zinc oxide; ITO, and the like. The composite materials thereof are also usable.

Other compounds may be added to the base material of organic material as needed according to application of the graft pattern.
For example, it is possible to improve the strength of the base material, by adding a compound having a radically polymerizable double bond. Examples of the compounds having a radically polymerizable double bond include acrylate and methacrylate compounds. The acrylate ((meth)acrylate) compound for use in the present invention is not particularly limited, if it contains an ethylenic unsaturated group, i.e., an acryloyl group, but is preferably a multifunctional monomer for improvement of hardening efficiency and also the rigidity and strength of the base material surface.
The multifunctional monomer favorably used in the present invention is an ester of a polyvalent alcohol and acrylic or methacrylic acid. Examples of the polyvalent alcohols include ethylene glycol, 1,4-cyclohexanol, pentaerythritol, trimethylolpropane, trimethylolethane, dipentaerythritol, 1,2,4-cyclohexanol, polyurethane polyols, and polyester polyols. Among them, trimethylolpropane, pentaerythritol, dipentaerythritol and polyurethane polyol are preferable. The intermediate layer may contain two or more multifunctional monomers.

The multifunctional monomer is a monomer having at least two ethylenic unsaturated groups, more preferably a monomer having three or more unsaturated groups. Specific examples thereof include multifunctional acrylate monomers containing 3 to 6 acrylic ester groups in the molecule; and in addition, oligomers, called urethane acrylates, polyester acrylates, and epoxyacrylates, that have several acrylic ester groups in the molecule and a molecular weight of several hundreds to several thousands are also used favorably as the component for the intermediate layer according to the present invention.
Specific examples of the acrylates having three or more acryl group in the molecule include polyol polyacrylates such as trimethylolpropane triacrylate, ditrimethyrollpropane tetraacrylate, pentaerythritol triacrylate, pentaerythritol tetraacrylate, dipentaerythritol pentaacrylate, and dipentaerythritol hexaacrylate; urethane acrylates obtained in reaction of a polyisocyanate and a hydroxyl group-containing acrylate such as hydroxyethyl acrylate; and the like. The thickness of the base material is not particularly limited, but generally, approximately 10 µm to 10 cm.

### (Application of graft pattern-forming method)

It is possible to form a fine oil- and water-repellent graft pattern easily according to the resolution of irradiation light by the graft pattern-forming method of the present invention, and the high-resolution oil- and water-repellent graft pattern obtained by the method can be applied to various fields. Specifically, for example, the high-resolution oil- and water-repellent graft pattern is useful as an etching resist of thin layer, and also as a template when ink droplets are ejected onto suitable sites by inkjet method, and thus, has a wide range of application.

In the lithography method according to the present invention, the high water- and oil-repellent and high-resolution graft pattern obtained by the method of forming a graft pattern according to the present invention is used as the etching resist. Use of the oil- and water-repellent graft pattern, which has a surface energy significantly lower in the pattern-forming region and is a thin layer, as an etching stopper enables high-resolution etching. It is thus possible to perform etching according to a high-resolution pattern by the lithography method to which the method of forming a graft pattern according to the present invention is applied.

### <Method of forming a conductive pattern according to the present invention>

Hereinafter, the method of forming a conductive pattern according to the present invention will be described.
The method of forming a conductive pattern according to the present invention includes a process of depositing a raw conductive material to the no-graft-polymer-generated region formed by the graft pattern-forming method described in the first to fourth embodiment (hereinafter, suitably referred to as "raw conductive material-depositing process"). A conductive pattern is formed in the raw conductive material-depositing process. The graft pattern-forming method described in the first to fourth embodiment may be applied to the graft pattern-forming method in the method of forming a conductive pattern according to the present invention, and favorable condition and others are also the same.
Examples of the raw conductive material-depositing processes include a method of forming a conductive region by applying a liquid containing conductive fine particles selectively in the no-graft-polymer-generated region and removing the solvent, a method of applying a liquid containing metal oxide fine particles in the no-graft-polymer-generated region and reducing and then heating the metal oxide fine particles, a method of forming a conductive region by activating the no-graft-polymer-generated region and performing electroless plating in the activated region, a method of forming a conductivity region by forming a conductive polymer layer in the no-graft-polymer-generated region, and the like. The conductive pattern is formed by any one of the four methods.
Hereinafter, the graft pattern-forming method and then the raw conductive material-depositing process will be described.

### (First embodiment of graft pattern-forming method)

The first embodiment of the graft pattern-forming method according to the present invention includes a process of forming a graft polymer-generated region and a non-graft polymer-generated region on the surface of a base material (hereinafter, referred to as "graft polymer-generating process (A)") by bringing a radically polymerizable compound having an oil- and water-repellent functional group into contact with the base material surface capable of generating radicals by photoirradiation, and generating graft polymers by using the radicals generated in the exposure region by patternwise photoirradiation on the base material as initial points.

The "base material capable of generating radicals by photoirradiation" used in the present process is, for example, a base material containing a radical generator. Examples of the radical generators include (1) low-molecular weight radical generators (hereinafter, referred to as "low-molecular weight radical generators") and (2) polymer compounds having a radical-generating site in its main or side chain (hereinafter, referred to as "polymeric radical generators"). Hereinafter, the present invention will be described, as the low-molecular weight base material containing a radical generator is designated as base material (1) and the polymeric base material containing a radical generator as base material (2).
The base material may be prepared by adding a radical generator directly to the components constituting the base material or by forming a layer containing a radical generator (radical generator-containing layer) on a substrate.
When the base material has a substrate and a radical generator-containing layer, an undercoat layer may be formed additionally between them for improvement in adhesiveness.

Examples of the low-molecular weight radical generators used in the base material (1) include known radical generator such as acetophenones, benzophenones, Michler's ketone, benzoylbenzoate, benzoins, α-acyloxime esters, tetramethylthiuram monosulfide, trichloromethyltriazine and thioxanthones. Other examples thereof for use in the present invention include sulfonium and iodonium salts normally used as photochemical acid generators, which also function as a radical generator by photoirradiation.

Examples of the polymeric radical generators for use in the base material (2) include the polymer compounds having an active carbonyl group on the side chain described, for example, in JP-A No. 9-77891, paragraph numbers [0012] to [0030] and JP-A No. 10-45927, paragraph numbers [0020] to [0073].
The molecular weight of the polymeric radical generator is preferably 1,000 to 300,000, and more preferably 3,000 to 100,000, from the viewpoint of controllability in production.

The content of these low-molecular weight radical generator and polymeric radical generator may be selected properly according to the kind of the base material used, the amount of the desired graft polymer generated, and the like.
Generally, the content of the low-molecular weight radical generator is preferably in the range of 0.1 to 40 % by mass based on the total solid content in the base material or to the radical generator-containing layer, and the content of the polymeric radical generator is preferably in the range of 1.0 to 50 % by mass based on the total solid content in the base material or to the radical generator-containing layer.

In addition to the low-molecular weight radical generator and the polymeric radical generator, a sensitizer may be added to the base material for improvement in sensitivity. Examples of the sensitizers include n-butylamine, triethylamine, tri-n-butylphosphine, thioxanthone derivatives, and the like.
The content of the sensitizer is preferably, approximately 50 to 200 % by mass, based on the radical generator.

Although a radical generator should be added to the base material itself in the base materials (1) and (2) described above, it is possible to form a "base material capable of generating radicals by photoirradiation", by forming a layer capable of generating radicals on the surface of a substrate, as in the following base material (3).
Specifically, it is a base material (3) prepared by coating and drying a coating solution containing a polymer compound having on the side chain a crosslinking site and a radical-generating site on the surface of a substrate and forming a crosslinked structure in the coated film.
Specifically, as for the base material (3), it is possible to obtain a "base material capable of generating radicals by photoirradiation", by forming a polymerization-initiation layer on a substrate by immobilizing a polymer having a functional group capable of initiating polymerization and a crosslinkable group by crosslinking reaction on the side chain. Photoirradiation of the polymerization-initiation layer surface in a patterned form generates radicals in the region.
Such a method of forming a polymerization-initiation layer is described, for example, in JP-A No. 2004-123837 in detail, and such a polymerization-initiation layer may be applied to the present invention.

Advantageously, in the presence of a polymerization-initiation layer in the crosslinked structure, it is possible, for example, to prevent undesirable solubilization of polymerization-initiating component when a liquid monomer component, specifically a radically polymerizable compound having an oil- and water-repellent functional group, is brought into contact; and it is possible to perform efficient radical polymerization reaction because the strength of the polymerization-initiation layer is high and to improve the adhesiveness of the formed graft polymer with the base material.

In the present invention, radicals are generated in the exposed region of the base material bringing a material for the desirable graft polymer, i.e., a radically polymerizable compound having an oil- and water-repellent functional group (e.g., oil-repellent monomer represented by fluorine-containing monomer), into contact with the base material surface described above and pattern exposure thereof in the graft polymer-generating process (A); and grafting reaction of the radically polymerizable compound having an oil- and water-repellent functional group is initiated and advanced from the radicals as initial points. As a result, oil-and water-repellent graft polymers are generated only in the exposure region of the base material.

Hereinafter, the method of preparing a graft polymer in the graft polymer-generating process (A) will be described in detail.
The graft polymer according to the present invention is prepared by using a radically polymerizable compound having an oil- and water-repellent functional group as raw material and radicals generated on the base material surface as initial points. During preparation of the graft polymer, a raw material, i.e., a radically polymerizable compound having an oil- and water-repellent functional group, is brought into contact with the base material, and examples of the methods include a so-called non-solvent method of bringing the compound alone into contact, a method of coating a solution or dispersion of the compound, a method of dipping a base material into the solution or dispersion, and others.
When the raw material is brought into contact with the base material without solvent, the concentration of the radically polymerizable compound having an oil- and water-repellent functional group in the composition that is brought into contact with the base material is 100%.
The radically polymerizable compound having an oil- and water-repellent functional group is preferably used as a composition as it is diluted with a good solvent, from the viewpoint of handling efficiency. The solvent for use is not particularly limited, but preferable solvents are methanol, acetone, methylethylketone, ethanol, hexane, heptane, benzene, toluene, and the like. Additives such as other monofunctional or multifunctional monomer, surfactant, and thickener may be added then as needed to the composition, together with the radically polymerizable compound having an oil- and water-repellent functional group.

For prevention of polymerization inhibition by oxygen during preparation of the graft polymer, contact of the composition containing a radically polymerizable compound having an oil- and water-repellent functional group with the base material and graft polymerization reaction thereof may be performed under an inert gas atmosphere such as of nitrogen, or alternatively, the composition containing a radically polymerizable compound having an oil-and water-repellent functional group may be covered with a plate or film of a material transmitting the light for graft polymerization reaction such as glass, quartz, or a transparent plastic material, after contacting with the base material.

In the graft polymer-generating process (A), any light may be used in the patternwise photoirradiation for preparation of the graft polymer without restriction, if it is a light having a wavelength allowing generation of radicals from the base material capable of generating radicals by photoirradiation, and specifically favorable lights include ultraviolet and visible rays having a wavelength of 150 to 800 nm, preferably 200 to 600 nm.
Specific examples of the light sources include high-pressure mercury lamp, low-pressure mercury lamp, halogen lamp, xenon lamp, excimer laser, colorant laser, semiconductor laser, YAG laser, and the like.
For preparation of the graft polymer in desired region, it is needed to irradiate the region other than the desired conductive region accurately by the pattern irradiation. Scanning beam irradiation by using a particular optical system or masked irradiation allowing high-resolution pattern irradiation is favorable for patternwise photoirradiation, and a photoirradiation method suitable for the desired resolution of pattern is selected. Alternatively, a stepper irradiation by using an i-ray, KrF, or ArF stepper may be used.

Hereinafter, the radically polymerizable compound having an oil- and water-repellent functional group for use in the present invention graft polymer-generating process (A) will be described.
The radically polymerizable compound having an oil- and water-repellent functional group is not particularly limited, if it is a compound having an oil- and water-repellent functional group and a radically polymerizable group, and may be in any form of monomer, macromer, oligomer, or polymer.

### (Radically polymerizable compound having an oil- and water-repellent functional group)

Hereinafter, examples of the radically polymerizable compound having an oil- and water-repellent functional group favorably used in the graft polymer-generating process (A) are described.
In the present invention, the water-droplet contact angle of the formed graft polymer in air is desirably 90 degrees or more for high discrimination between the oil- and water-repellent graft polymer-generated region and the non-generated region. The high oil-and water-repellency can be estimated from the surface atom content as determined by ESCA. In the case of a silicon-containing silicon-based graft polymer, a high oil- and water-repellency is usually obtained, for example, when the Si ratio in the surface elemental composition is 10 % by atom or more based on the total amount of Si, C, and O. Alternatively in the case of a fluorine-containing fluorine-based graft polymer, the F ratio in the surface elemental composition should be 30 % by atom or more based on the total amount of F, C, and O. For preparation of a graft polymer having such a surface atom content, the raw monomer should have a silicon content of at least 10 % by atom or more in the atoms constituting the monomer when it is a silicon-based monomer and a fluorine content of 30 % by atom or more when it is a fluorine-based monomer. It is thus important to use a monomer satisfying the requirements above, to obtain a high oil- and water-repellent graft polymer.
The macromer, oligomer, polymer, or the like used for preparation of a graft polymer having such a surface atom content should also have a silicon or fluorine atom content ratio in the molecule similar to that above.

Specific examples of the monomers having an oil- and water-repellent functional group satisfying the requirements above include fluorine-containing monomers, silicone-containing monomers, and the like.
Hereinafter, the fluorine- and silicone-containing monomers used in the present invention will be described.

### -Fluorine-containing monomer-

The fluorine-containing monomer for use in the graft polymer-generating process (A) is, for example, at least one fluorine-containing monomer selected from the groups consisting of the monomers represented by the following Formulae (I), (II), (III), (IV) and (V).

CH₂=CR¹COOR²R^{f} (I)

(wherein, R¹ represents a hydrogen atom or a methyl group; R² represents -CₚH₂ₚ₋, -C(CₚH₂ₚ₊₁)H-, -CH₂C(CₚH₂ₚ₊₁)H-, or -CH₂CH₂O-; R^{f} represents -CₙF₂ₙ₊₁, -(CF₂)ₙH, -CₙF₂ₙ₊₁-CF₃, -(CF₂)ₚOCₙH₂ₙCᵢF₂ᵢ₊₁, -(CF₂)ₚOCₘH₂ₘCᵢF₂ᵢH, -N(CₚH₂ₚ₊₁)COCₙF₂ₙ₊₁, Or -N(CₚH₂ₚ₊₁)SO₂CₙF₂ₙ₊₁; however, p is an integer of 1 to 10; n is an integer of 1 to 16; and m is an integer of 0 to 10; and i is an integer of 0 to 16].

CF₂=CFOR^{g} (II)

[wherein, R^{g} represents a fluoroalkyl group having 1 to 20 carbon atoms].

CH₂=CHR^{g} (III)

[wherein, R^{g} represents a fluoroalkyl group having 1 to 20 carbon atoms].

CH₂=CR³COOR⁵R^{j}R⁹OCOR⁴=CH₂ (IV)

[wherein, R³ and R⁴ each independently represent a hydrogen atom or a methyl group; R⁵ and R⁶ each independently represent -C_{q}H_{2q}-, -C(C_{q}H_{2q+1})H-, -CH₂C(CqH_{2q+1})H-, or -CH₂CH₂O-; R^{j} represents -CₜF₂ₜ; however, q is an integer of 1 to 10, and t is an integer of 1 to 16].

CH₂=CHR⁷COOCH₂(CH₂R^{k})CHOCOCR⁸=CH₂ (V)

[wherein, R⁷ and R⁸ each independently represent a hydrogen atom or a methyl group; R^{k} represents -CyF_{2y+1}; however, y is an integer of 1 to 16].

Hereinafter, specific examples of the fluorine-containing monomers for use in the graft polymer-generating process (A) will be listed, however the present invention is not restricted thereby.
Examples of the monomers represented by Formula (I) include CF₃(CF₂)₇CH₂CH₂OCOCH=CH₂, CF₃CH₂OCOCH=CH₂, CF₃(CF₂)₄CH₂CH₂OCOC(CH₃)=CH₂, C₇F₁₅CON(C₂H₅)CH₂OCOC(CH₃)=CH₂, CF₃(CF₂)₇SO₂N(CH₃)CH₂CH₂OCOCH=CH₂, CF₃(CF₂)₇SO₂N(C₃H₇)CH₂CH₂OCOCH=CH₂, C₂F₅SO₂N(C₃H₇)CH₂CH₂OCOC(CH₃)=CH₂, (CF₃)₂CF(CF₂)₆(CH₂)₃OCOCH=CH₂, (CF₃)₂CF(CF₂)₁₀(CH₂)₃OCOC(CH₃)=CH₂, CF₃(CF₂)₄CH(CH₃)OCOC(CH₃)=CH₂,

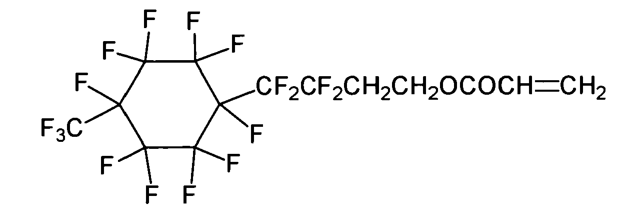

CF₃CH₂OCH₂CH₂OCOCH=CH₂, C₂F₅(CH₂CH₂O)CH₂OCOCH=CH₂, (CF₃)₂CFO(CH₂)₅OCOCH=CH₂, CF₃(CF₂)₄OCH₂CH₂OCOC(CH₃)=CH₂, C₂F₅CON(C₂H₅)CH₂OCOCH=CH₂, CF₃(CF₂)₂CON(CH₃)CH(CH₃)CH₂OCOCH=CH₂, H(CF₂)₆C(C₂H₅)OCOC(CH₃)=CH₂, H(CF₂)₈CH₂OCOCH=CH₂, H(CF₂)₄CH₂OCOCH=CH₂, H(CF₂)CH₂OCOC(CH₃)=CH₂,

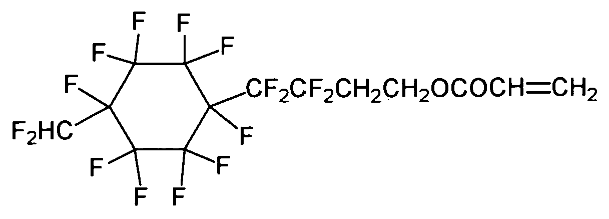

CF₃(CF₂)₇SO₂N(CH₃)CH₂CH₂OCOC(CH₃)=CH₂, CF₃(CF₂)₇SO₂N(CH₃)(CH₂)₁₀OCOCH=CH₂, C₂F₅SO₂N(C₂H₅)CH₂CH₂OCOC(CH₃)=CH₂, CF₃(CF₂)₇SO₂N(CH₃)(CH₂)₄OCOCH=CH₂, C₂F₅SO₂N(C₂H₅)C(C₂H₅)HCH₂OCOCH=CH₂, and the like.

Examples of the fluoroalkylated olefins represented by Formulae (II) and (III) include C₃F₇CH=CH₂, C₄F₉CH=CH₂, C₁₀F₂₁CH=CH₂, C₃F₇OCF=CF₂, C₇F₁₅OCF=CF₂, C₈F₁₇OCF=CF₂, and the like.

Examples of the monomers represented by Formulae (IV) and (V) include CH₂=CHCOOCH₂(CF₂)₃CH₂OCOCH=CH₂, CH₂=CHCOOCH₂CH(CH₂C₈F₁₇)OCOCH=CH₂, and the like.

It is possible to use another monomer containing no fluorine as the monomer for preparation of the fluorine-containing graft polymer, in combination with the fluorine-containing monomer above in the range that does not impair the advantageous effects of the present invention. The monomer is not particularly limited, if it is radically polymerizable, and specific examples thereof include unsaturated carboxylic acids such as (meth)acrylic acid, maleic acid, fumaric acid, and itaconic acid, the alkyl or glycidyl esters thereof, styrene, alkyl acid vinyl esters, silicon-containing monomers, and the like. The content of the monomers when used in combination is preferably 50 % by mass or less based on the fluorine-containing monomer.

### -Silicon-containing monomer-

Examples of the silicon-containing monomer for use in the graft polymer-generating process (A) include silicon-containing monomers containing a SiCH₃ or O-Si-CH₃ group. A specific example thereof is silicone acrylate or methacrylate represented by a Formula: (CH₃O)ₙSi(CH₃)₃₋ₙ R³-O-CO-CR⁴=CH₂ (n is an integer of 0 to 3), wherein R³ represents a connecting group, and R⁴ represents methyl or hydrogen. Other favorable examples thereof include the silicon-based monomers described in JP-ANo. 2003-335984, paragraph number [0025].

These monomers having an oil- and water-repellent functional group may be used alone or as a mixture of two or more.

It is preferable to remove the homopolymer remaining on the base material having the graft polymer-generated region and the non-generated region thus formed, for example by immersing the base material in solvent, and thus to purify the base material. Specifically, the base material is purified by washing with water or acetone, drying, or the like. Use of a means such as ultrasonic wave irradiation is preferable, for removal of the homopolymer.
The homopolymer remaining on the base material surface is removed completely after purification, and there is only a patterned oil- and water-repellent graft polymer tightly bound to the base material.

### (Second embodiment of graft pattern-forming method)

Hereinafter, the second embodiment of the method of forming a graft pattern according to the present invention will be described. The second embodiment of the method of forming a graft pattern according to the present invention is includes a process of generating radicals in an exposure region of a base material by bringing a hydrogen-abstraction radical generator into contact with the base material surface and performing patternwise photoirradiation on the base material (hereinafter, referred to as "radical-generating process") and a process of forming a graft polymer-generated region and a non-graft polymer-generated region on the base material surface, by bringing a radically polymerizable compound having an oil- and water-repellent functional group into contact with the base material surface and generating graft polymers by using the radicals generated in the exposure region as initial points (hereinafter, referred to as "graft polymer-generating process (B)").

In the second embodiment of the present invention, radicals are generated in the radical-generating process by bringing a hydrogen-abstraction radical generator into contact with the base material surface and performing patternwise photoirradiation on the base material exposure region.
The processing in the radical-generating process and the graft polymer-generating process (B) are preferable performed simultaneously, for more efficiency utilization of generated radicals in preparation of the graft polymer. In other words, radical generation on the base material surface and graft polymerization from the radicals as initial points preferably proceed almost simultaneously.
Specifically, used is a method of bringing a mixture of a hydrogen-abstraction radical generator and a radically polymerizable compound having an oil- and water-repellent functional group into contact with the base material and performing patternwise photoirradiation on the base material. By the patternwise photoirradiation, the hydrogen-abstraction radical generator abstracts hydrogen from the base material surface, generating an active radical in the exposure region, and graft polymerization of the radically polymerizable compound starts from the radical as an initial point. As a result, graft polymers having an oil- and water-repellent functional group are formed only in the exposure region of the base material.

Examples of the hydrogen-abstraction radical generators include benzophenones, thioxanthones, and the like.
For contact of the hydrogen-abstraction radical generator with the base material, used is a method of dissolving or dispersing the radical generator in a suitable solvent such as methylethylketone or 1-methoxy-2-propanol and coating the solution or dispersion on the base material surface, a method of dipping a base material in the solution or dispersion, or the like. The concentration of the hydrogen-abstraction radical generator in such a solution or dispersion is preferably, approximately 0.1 to 10 % by mass.
A solution or dispersion containing hydrogen-abstraction radical generator additionally containing an added radically polymerizable compound having an oil- and water-repellent functional group is used for bringing the hydrogen-abstraction radical generator and the radically polymerizable compound having an oil- and water-repellent functional group simultaneously into contact with the base material surface.

In the graft polymer-generating process (B) in the second embodiment of the present invention, if the processing is conducted simultaneously with that in the radical-generating process as described above, a solution or dispersion containing both a hydrogen-abstraction radical generator and a radically polymerizable compound having an oil- and water-repellent functional group is used for contact thereof with the base material, and the method, condition; and other method, condition, and the like are the same as those for the graft polymer-generating process (A) in the first embodiment of the present invention.
Regions containing and not containing the graft polymer having an oil- and water-repellent functional group are formed in the graft polymer-generating process (B).

(Third embodiment of the method of forming a graft pattern according to the present invention)
In the third embodiment, the graft pattern-forming method according to the present invention characteristically includes a process of bonding a compound having a polymerization-initiating site capable of initiating radical polymerization by photocleavage (photocleavable compound) on the base material surface in a patterned form.
For example, a method of bonding a photocleavable compound over the entire base material surface and decomposing (inactivating) the polymerization-initiating sites in the exposure region by patternwise photoirradiation or a method of depositing and bonding a photocleavable compound on the base material surface in the patterned form by microcontact printing can be used in the process.
Most preferable in the embodiment is a method including a process of bonding a compound having a polymerization-initiating site capable of initiating radical polymerization by photocleavage and a base material-bonding site (hereinafter, referred to as "photocleavable compound-bonding process (A)") to the base material surface and a process of inactivating the polymerization-initiating sites in the exposure region by patternwise photoirradiation (hereinafter, "polymerization initiating potential-inactivating process").

In the third embodiment, the graft pattern-forming method according to the present invention characteristically has a process of forming a graft polymer-generated region and a non-generated region on the base material surface by bringing a radically polymerizable compound having an oil- and water-repellent functional group into contact with the base material, photoirradiating the entire surface, and thus, preparing graft polymers from the polymerization-initiating sites as initial points (hereinafter, referred to as "graft polymer-generating process (C)".

Hereinafter, the processes to the graft polymer-generating process (C) will be described briefly, taking the third embodiment of the present invention as the most favorable embodiment, with reference to Figure 1.
Figure 1 is an exemplary schematic chart illustrating the processes to the graft polymer-generating process (C) in the third embodiment of the method of forming a conductive pattern according to the present invention.

As shown in Figure 1 (a), the base material surface has functional groups (represented by Z in the Figure) from the first. A compound (Q-Y) having a base material-bonding site (Q) and a polymerization-initiating site capable of initiating radical polymerization by photocleavage (Y) is then brought into contact with the base material surface. As shown in Figure 1(b), the functional group (Z) present on the base material surface and the base material-bonding site (Q) bind to each other, introducing the compound (Q-Y) on the base material surface (photocleavable compound-bonding process (A)).
Then, the compound (Q-Y)-introduced face is pattern-irradiated, as indicated by the arrow in Figure 1(b). The polymerization-initiating site (Y) is cleaved by the irradiation energy. As a result, as shown in Figure 1(c), the compound (Q-Y) in the exposure region becomes a compound having a polymerization initiating potential-inactivated site (S), by decomposition and inactivation of the polymerization-initiating site (Y) (polymerization initiating potential-inactivating process).
Then as shown in Figure 1(d), the entire surface is exposed to light while a raw material for graft polymer such as a monomer having an oil- and water-repellent functional group kept in contact, as indicated by the arrow in Figure 1 (d). As shown in Figure 1 (e), a graft polymer is grown from the polymerization-initiating site (Y) of the compound (Q-Y) as an initial point in the region where the polymerization-initiating site (Y) is preserved [graft polymer-generating process (C)].

Hereinafter, each of the processes above will be described specifically.
The group represented by (Z) in Figure 1 is a functional group present on the base material surface, and specifically, for example, a hydroxyl, carboxyl, or amino group, or the like. The functional group may be the group inherently present on the base material surface of silicon or glass, or a group additionally formed by surface treatment of the base material surface, for example, by corona discharge treatment.

The base material for use in the present invention is not particularly limited, and examples thereof include base materials having a functional group (Z) such as hydroxy, carboxyl, or amino on the base material surface and base materials having a functional group such as hydroxyl or carboxyl generated by surface treatment such as corona discharge treatment, glow treatment, or plasma treatment.
Generally, a flat plate-shaped base material is used, however the base material is not limited to a flat plate-shaped base material, and the graft polymer may be introduced on the surface of a base material in any other shape such as cylindrical.

Specific examples of the base materials favorable in the present invention include various base material having surface hydroxyl groups such as glass, quartz, ITO, and silicon, plastic base materials, such as PET, polypropylene, polyimide, epoxy, acryl, and urethane, having surface hydroxyl and carboxyl groups generated by surface treatment such as corona discharge treatment, glow treatment, or plasma treatment, and the like.
The thickness of the base material varies according to applications and is not particularly limited, but generally, approximately 10 urn to 10 cm.

Hereinafter, the structure of the compound having a polymerization-initiating site capable of initiating radical polymerization by photocleavage (hereinafter, simply referred to as polymerization-initiating site) and a base material-bonding site (photocleavable compound) will be described in detail.
When the photocleavable compound is described in detail by using the model of the compound (Q-Y) having a base material-bonding site (Q) and a polymerization-initiating site (Y) in the schematic chart of Figure 1, the polymerization-initiating site (Y) generally has a structure containing a single bond that cleaves by photoirradiation.
The photocleavable single bond is, for example, a single bond that is broken by α-and β-carbonyl cleavage reaction, photo-Fries rearrangement reaction, phenacyl ester cleavage reaction, sulfonimide cleavage reaction, sulfonyl ester cleavage reaction, N-hydroxysulfonyl ester cleavage reaction, benzylimide cleavage reaction, activated halogenated compound cleavage reaction, or the like. The photocleavable single bond is broken by such a reaction. Examples of the cleavable single bonds include C-C, C-N, C-O, C-Cl, N-O, and S-N bonds, and the like.

The polymerization-initiating site (Y) containing a photocleavable single bond becomes the initial point of graft polymerization in the graft polymer-generating process (C), and thus, has a function to generate a radical by cleavage reaction when the photocleavable single bond is cleaved. Examples of such structures having a photocleavable single bond and a polymerization-initiating site (Y) capable of generating a radical include structures having a group such as an aromatic ketone, phenacyl ester, sulfonimide, sulfonyl ester, N-hydroxysulfonyl ester, benzylimide, trichloromethyl, or benzyl chloride group.

Such a polymerization-initiating site (Y) generates a radical by photocleavage, and thus, when polymerizable compounds are present in the area around the radical, a desired graft polymer, and thus a graft polymer-generated region, is formed, with the radical functioning as an initial point of graft polymerization reaction.
On the other hand, when there is no polymerizable compound in the area around the radical, the radical is inactivated without use even when it is generated by photoirradiation cleavage of the polymerization-initiating site (Y), and as a result, the polymerization-initiating potential is also inactivated. As a result, the region becomes a no-graft-polymer-generated region.

On the other hand, the base material-bonding site (Q) is a reactive group bonding to the functional group (Z) present on the base material surface, and specific examples of the reactive groups include the following groups.

Base material-bonding group Q: -Si(OMe)₃, -SiCl₃, -NCO, -CH₂Cl

The polymerization-initiating site (Y) and the base material-bonding site (Q) may bind to each other directly or via a connecting group. Examples of the connecting groups include those containing atoms selected from the group consisting of carbon, nitrogen, oxygen, and sulfur; and specific examples thereof include saturated carbon groups, aromatic groups, ester groups, amido groups, ureido groups, ether groups, amino groups, sulfonamido groups, and the like. The connecting group may have an additional substituent group, and examples of the substituent groups that may be introduced include alkyl groups, alkoxy groups, halogen atoms, and the like.

Specific examples of the compounds (Q-Y) having a base material-bonding site (Q) and a polymerization-initiating site (Y) are listed below (exemplary compounds 1 to 16), together with the cleavage sites, however the present invention is not particularly restricted thereby

C-C bond cleavage compound

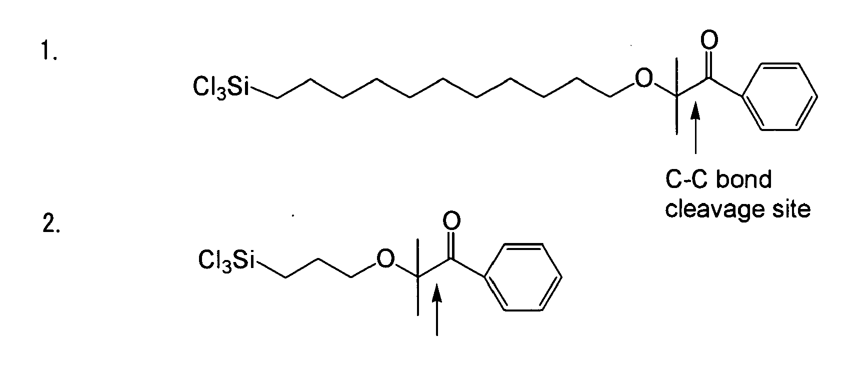

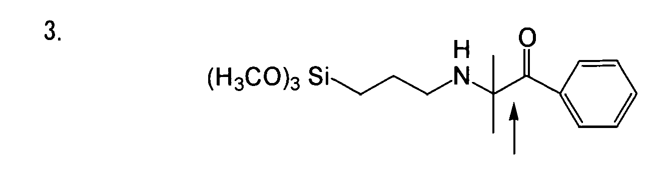

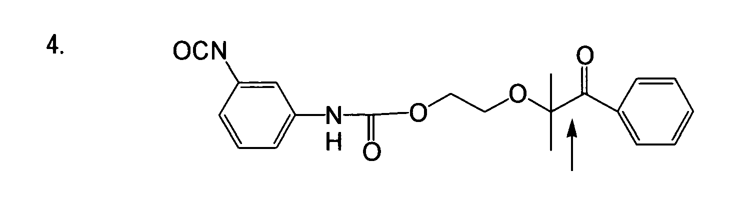

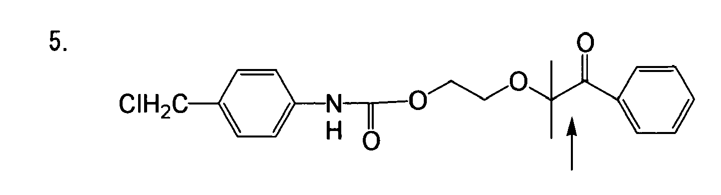

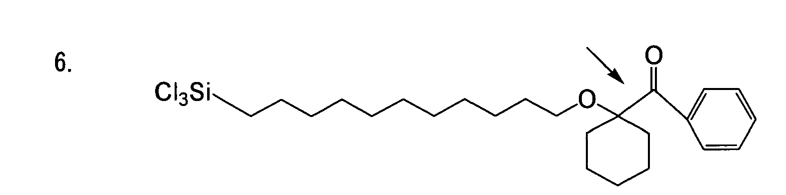

C-O bond cleavage compound 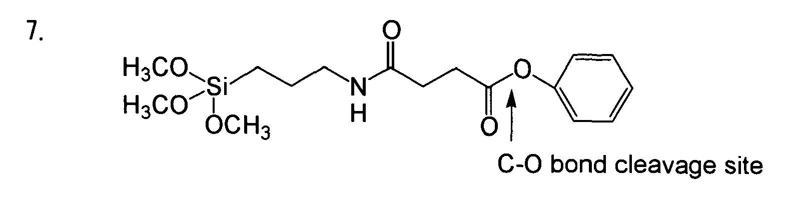 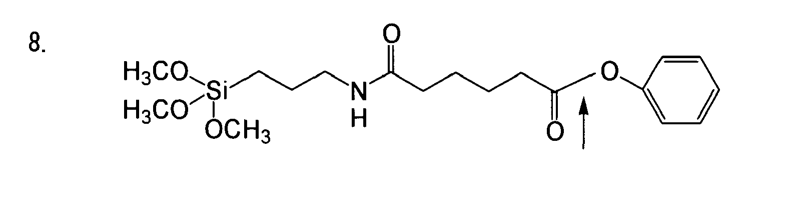 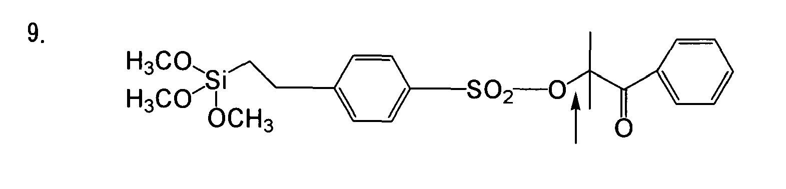 S-N bond cleavage compound

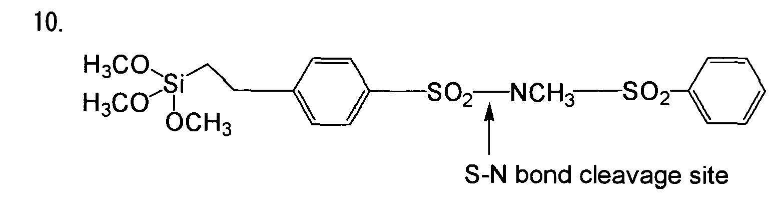

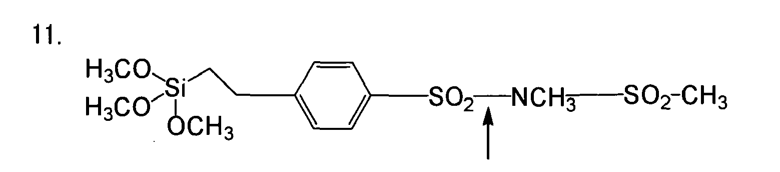

C-N bond cleavage compound 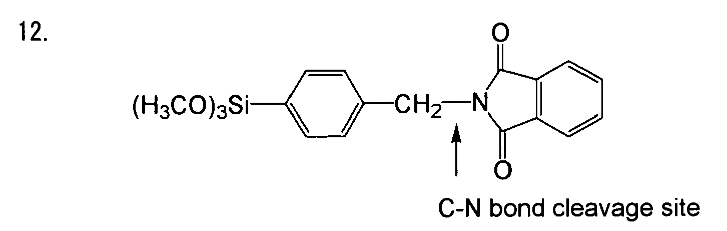 N-O bond cleavage compound 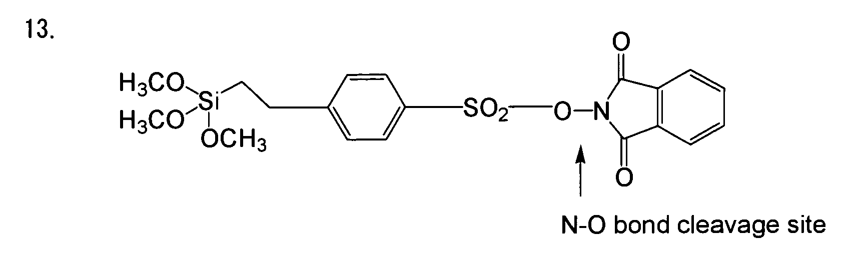 C-Cl bond cleavage compound

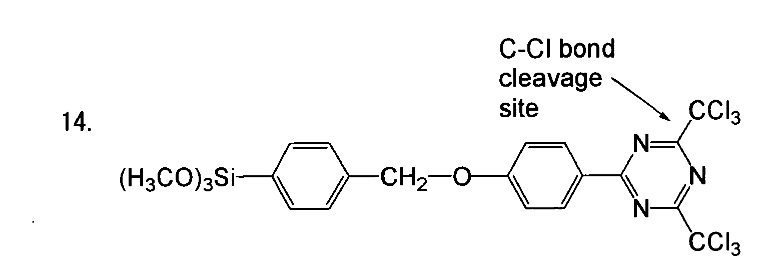

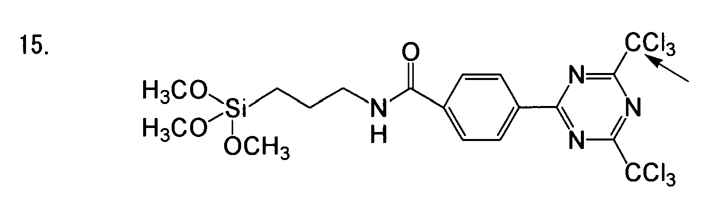

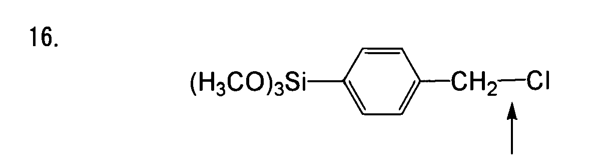

The photocleavable compound-bonding process (A) according to the present invention is a process of bonding such a compound (Q-Y) to the base material.
For example for bonding the exemplified compound (Q-Y) to the functional group (Z) present on the base material surface, a method of dissolving or dispersing a compound (Q-Y) in a suitable solvent such as toluene, hexane, or acetone and coating the solution or dispersion on the base material surface or a method of dipping the base material in the solution or dispersion may be applied. The concentration of the compound (Q-Y) in the solution or dispersion then is preferably 0.01 to 30 % by mass, particularly preferably 0.1 to 15 % by mass. The liquid temperature when in contact is preferably 0°C to 100°C. The contact period is preferably 1 second to 50 hours, more preferably 10 seconds to 10 hours.

Then in the polymerization initiating potential-inactivating process, the compound (Q-Y) bound to the base material surface is photocleaved, and the polymerization-initiating potential is inactivated by patternwise photoirradiation in the region where generation of the graft polymer is desirably prevented. As a result, a polymerization initiation-allowing region and a polymerization-initiating-potential-inactivated region are formed on the base material surface.
In the polymerization initiating potential-inactivating process, the resolution of the pattern of the polymerization initiation-allowing region and the polymerization-initiating-potential-inactivated region depends on the photoirradiation condition.
The patternwise photoirradiation methods for obtaining high resolution include, for example, scanning beam irradiation by using a particular optical system, masked irradiation, and the like, and a photoirradiation method suitable for the desired resolution of pattern is selected. Specifically, a stepper exposure, for example by using an i-ray, KrF, or ArF stepper, can be used.

The base material having the polymerization initiation-allowing region and the polymerization-initiating-potential-inactivated region thus formed is then processed in the graft polymer-generating process (C).
In the graft polymer-generating process (C), grafting reaction of the radically polymerizable compound having an oil- and water-repellent functional group is initiated and advanced from the radicals as initial points, by bringing a material for the desirable graft polymer, i.e., a radically polymerizable compound having an oil- and water-repellent functional group (e.g., oil-repellent monomer represented by fluorine-containing monomer), into contact with the base material having a polymerization initiation-allowing region and a polymerization-initiating-potential-inactivated region, photoirradiating the entire surface, and thus, generating radicals by photocleavage of the polymerization-initiating sites (Y) in the polymerization initiation-allowing region. As a result, the oil- and water-repellent graft polymers are generated only in the polymerization initiation-allowing region.

The method of preparing the graft polymer in the graft polymer-generating process (C), the condition thereof, and others are the same as those in the graft polymer-generating process (C) of the first embodiment described above, except that the entire surface is irradiated.
Because a photocleavable compound-containing layer is formed on the base material surface in the third embodiment, for prevention of uneven generation of the graft polymer by surface solubilization of the photocleavable compound-containing layer, it is preferable to select a solvent and other compounds having a physical property that does not dissolve the photocleavable compound-containing layer when the composition containing a radically polymerizable compound having an oil- and water-repellent functional group is brought into contact with the base material, as those contained in the composition containing the radically polymerizable compound.
The radically polymerizable compound having an oil- and water-repellent functional group used in the graft polymer-generating process (C) is also the same as that in the graft polymer-generating process (A).

Any light may be used without restriction in photoirradiation (patternwise photoirradiation and entire-surface irradiation) in the third embodiment of the present invention, if it can cleave the polymerization-initiating site (Y) of photocleavable compound by irradiation, however a ultraviolet or visible ray specifically having a wavelength of 200 to 800 nm, preferably 200 to 600 nm, is preferable.
Specific examples of the light sources include high-pressure mercury lamp, low-pressure mercury lamp, halogen lamp, xenon lamp, excimer laser, colorant laser, semiconductor laser, YAG laser, and the like.

### (Fourth embodiment of the method of forming a graft pattern according to the present invention)

Hereinafter, the fourth embodiment of the method of forming a graft pattern according to the present invention will be described. In the fourth embodiment, the graft pattern-forming method according to the present invention is characteristically includes a process of bonding a compound having a polymerization-initiating site capable of initiating radical polymerization by photocleavage and a base material-bonding site to the surface of a material surface (hereinafter, referred to as "photocleavable compound-bonding process (B)") and a process of forming a graft polymer-generated region and a non-generated region by performing patternwise photoirradiation after bringing a radically polymerizable compound having an oil- and water-repellent functional group into contact with the base material and generating graft polymers from the polymerization-initiating sites in the exposure region as an initial points (hereinafter, referred to as "graft polymer-generating process (D)"), which are performed in this order.

Hereinafter, the photocleavable compound-bonding process (B) and the graft polymer-generating process (B) in the fourth embodiment of the present invention will be described briefly, with reference to Figure 2.
Figure 2 is an exemplary schematic chart illustrating the photocleavable compound-bonding process (B) and the graft polymer-generating process (D) in the method of forming a conductive pattern in the fourth embodiment of the present invention.
As shown in Figure 2(a), the base material has functional groups (indicated by Z in the Figure) on the surface from the first. A compound (Q-Y) having a base material-bonding site (Q) and a polymerization-initiating site (Y) capable of initiating radical polymerization by photocleavage is then brought into contact with the base material surface. As shown in Figure 2(b), the functional group (Z) present on the base material surface and the base material-bonding site (Q) bind to each other, introducing the compound (Q-Y) on the base material surface [photocleavable compound-bonding process (B)].
Then as shown in Figure 2(c), patternwise photoirradiation is performed in the presence of a known raw graft polymer material such as monomer. As shown in Figure 2(d), a graft polymer-generated region is formed in the exposure region by generation of graft polymers from the polymerization-initiating sites (Y) of the compound (Q-Y) as initial points, while a no-graft-polymer-generated region is formed in the non-exposure region where there is no graft polymer generated [graft polymer-generating process (D)].

Hereinafter, each of the processes above will be described in detail.
the group represented by (Z) in Figure 2 is the same as the functional group (Z) present on the base material surface described in the third embodiment, and is specifically, for example, a hydroxyl, carboxyl or amino group, or the like.
The specific examples, shape, thickness, and others of the base material having the functional group (Z) are also the same as those in the third embodiment.

Hereinafter, the structure of the compound having a polymerization-initiating site capable of initiating radical polymerization by photocleavage (hereinafter, simply referred to as polymerization-initiating site) and a base material-bonding site will be described specifically. The compound (Q-Y) having a base material-bonding site (Q) and a polymerization-initiating site (Y) in the schematic chart of Figure 2 is the same as the compound (Q-Y) having a base material-bonding site (Q) and a polymerization-initiating site (Y) described in the third embodiment, and the structure and specific examples thereof are also the same.
In the fourth embodiment, the polymerization-initiating sites (Y) capable of generating radicals are distributed over the entire base material surface in the graft polymer-generating process (D), because the polymerization-initiating sites are not inactivated previously by patternwise photoirradiation, as in the third embodiment.

When a radical is formed by patternwise photoirradiation cleavage at the polymerization-initiating site (Y), the radical, which functions as an initial point of graft polymerization reaction, induces growth of a desired graft polymer and gives a graft polymer-generated region if there are polymerizable compounds in the area around the radical. On the other hand, there is no cleavage at the polymerization-initiating site (Y) and no growth of graft polymer in the non-exposure region and thus, there is no graft-polymer-generated region formed.

The photocleavable compound-bonding process (B) according to the present invention is a process of bonding such a compound (Q-Y) to the base material. The method and condition used in the present process are the same as those in the photocleavable compound-bonding process (A) of the third embodiment.

In the graft polymer-generating process (D) of the present invention, grafting reaction of the radically polymerizable compound having an oil- and water-repellent functional group is initiated and advanced from the radicals as initial points, by bringing a material for the desirable graft polymer, i.e., a radically polymerizable compound having an oil- and water-repellent functional group (e.g., monomer having an oil-repellent functional group monomer), into contact with the base material after processing in the photocleavable compound-bonding process (B), performing patternwise photoirradiation, and thus, generating radicals by photocleavage of the polymerization-initiating sites in the exposure region (Y). As a result, oil- and water-repellent graft polymers are generated only in the exposure region.
In the fourth embodiment of the present invention, the unphotocleaved compound (Q-Y) remains in the no-graft-polymer-generated region.

The method of bringing the radically polymerizable compound having an oil- and water-repellent functional group into contact with the base material surface in the graft polymer-generating process (D) may be the same as that in the graft polymer-generating process (A) of the first embodiment. The radically polymerizable compound having an oil-and water-repellent functional group for use in the graft polymer-generating process (D) is also the same as that described in the graft polymer-generating process (A) of the first embodiment.

The method for patternwise photoirradiation for use in the graft polymer-generating process (D) is not particularly limited, if it is a light having a wavelength allowing photocleavage of the polymerization-initiating site (Y) of photocleavable compound, and a ultraviolet or visible ray having a wavelength similar to that described in the third embodiment is used favorably.
Also in the graft polymer-generating process (D), the resolution of the pattern of a graft polymer-generated region and a non-generated region depends on the condition of the patternwise photoirradiation. The patternwise photoirradiation methods for obtaining high resolution include, for example, scanning beam irradiation by using a particular optical system, masked irradiation, and the like, and a photoirradiation method suitable for the desired resolution of pattern is selected. Specifically, a stepper exposure, for example by using an i-ray, KrF, or ArF stepper, can be used. A high-resolution pattern of a graft polymer-generated region and a non-generated region is formed in the graft polymer-generating process (D), and the high-resolution patternwise photoirradiation give a high-resolution pattern according to the irradiation.

### (Base material used in graft pattern-forming method)

The base material for use in the method of forming a graft pattern according to the present invention will be described below. The base material is not particularly limited in its constituent material, organic, inorganic, or organic/inorganic hybrid, if it has physical properties suitable for application as a conductive pattern, and is selected properly according to the mechanism of the polymerization-initiating active site generated.
For example, an organic, inorganic, or organic/inorganic hybrid material is used as the material for the base materials (1) or (2) in the first embodiment and the base material in the second embodiment.
When the base materials (1) or (2) in the first embodiment has any radical generator-containing layer formed on a substrate, or when a polymerization-initiation layer is formed on a substrate as in the base material (3) of the first embodiment, the substrate may be either an organic or inorganic material.

Each of the base materials used in the third and fourth embodiments should have a functional group such as hydroxyl, carboxyl, or amino or alternatively, a hydroxyl, carboxyl, or other group generated by surface treatment such as corona treatment, glow treatment, or plasma treatment on its surface. Specific examples of the base materials include various base materials containing surface hydroxyl groups such as glass, quartz, and ITO, plastic base materials, such as of PET, polypropylene, polyimide, epoxy, acryl, and urethane, having surface hydroxyl and carboxyl groups generated by surface treatment such as corona treatment, glow treatment, plasma treatment, or the like.

Examples of the organic materials properly used for the various base materials (substrates) include acrylic resins such as polymethyl methacrylate; polyester resins such as polyethylene terephthalate, polyethylene naphthalate, poly-1,4-cyclohexanedimethylene terephthalate, polyethylene-1,2-diphenoxyethane-4,4'-dicarboxylate, and polybutylene terephthalate; commercial products such as Epikote (trade name, manufactured by Yuka Shell Epoxy Co., Ltd.); epoxy resins, polycarbonate resins, polyimide resins, novolak resins, phenol resins, and the like.
Examples of other organic materials include cellulose esters (e.g., triacetylcellulose, diacetylcellulose, propionylcellulose, butyrylcellulose, and acetylpropionylcellulose, nitrocellulose), polyamides, polystyrenes (e.g., syndiotactic polystyrene), polyolefins (e.g., polypropylene, polyethylene, polymethylpentene), polysulfones, polyether sulfones, polyarylates, polyether imides, polyether ketones, and the like.

Examples of the inorganic materials for the various base materials (substrates) include metal materials such as of glass, glass, quartz, silicon, iron, zinc, copper, or stainless steel; metal oxides such as tin oxide, zinc oxide; ITO, and the like. The composite materials thereof are also usable.

Other compounds may be added to the base material of organic material as needed according to application of the graft pattern.
For example, it is possible to improve the strength of the base material by adding a compound having a radically polymerizable double bond. Examples of the compounds having a radically polymerizable double bond include acrylate and methacrylate compounds. The acrylate ((meth)acrylate) compound for use in the present invention is not particularly limited, if it contains an ethylenic unsaturated group i.e., an acryloyl group, and is preferably a multifunctional monomer for improvement of hardening efficiency and also of the rigidity and strength of the base material surface.
The multifunctional monomer favorably used in the present invention is an ester of a polyvalent alcohol and acrylic or methacrylic acid. Examples of the polyvalent alcohols include ethylene glycol, 1,4-cyclohexanol, pentaerythritol, trimethylolpropane, trimethylolethane, dipentaerythritol, 1,2,4-cyclohexanol, polyurethane polyols, and polyester polyols. Among them, trimethylolpropane, pentaerythritol, dipentaerythritol and polyurethane polyol are preferable. The intermediate layer may contain two or more multifunctional monomers.

The multifunctional monomer is a monomer having at least two ethylenic unsaturated groups, more preferably a monomer having three or more unsaturated groups. Specific examples thereof include multifunctional acrylate monomers containing 3 to 6 acrylic ester groups in the molecule, and in addition, oligomers called urethane acrylates, polyester acrylate, and epoxyacrylates that have several acrylic ester groups in the molecule and a molecular weight of several hundreds to several thousands are also used favorably as the component for the intermediate layer according to the present invention.
Specific examples of the acrylates having three or more acryl group in the molecule include polyol polyacrylates such as trimethylolpropane triacrylate, ditrimethyrollpropane tetraacrylate, pentaerythritol triacrylate, pentaerythritol tetraacrylate, dipentaerythritol pentaacrylate, and dipentaerythritol hexaacrylate; urethane acrylates obtained in reaction of a polyisocyanate and a hydroxyl group-containing acrylate such as hydroxyethyl acrylate; and the like. The thickness of the base material is not particularly limited, but generally, approximately 10 µm to 10 cm.

### (Formation of conductive pattern by using conductive fine particles)

Specifically in the method of forming a conductive region by applying a liquid containing conductive fine particles in the no-graft-polymer-generated region selectively and removing the solvent, a liquid containing conductive fine particles is applied on the base material having an oil- and water-repellent graft polymer-generated region and a non-generated region and immobilized thereon in the no-graft-polymer-generated region selectively by the oil-and water-repellency of the graft polymer-generated region and the barrier effect emerging between the graft polymer-generated and non-generated regions, and then, the solvent is removed by drying.

When the difference in contact angle between in the graft polymer-generated region (oil- and water-repellent region) and in the non-generated region (lyophilic region) on the base material is larger than 30°, specifically when the graft polymer is a fluoroalkylsilane (hereinafter, referred to as "FAS") such as heptadecafluoro-1,1,2,2 tetrahydrodecyltriethoxysilane, heptadecafluoro-1,1,2,2 tetrahydrodecyltrimethoxysilane, heptadecafluoro-1,1,2,2 tetrahydrodecyltrichlorosilane, tridecafluoro-1,1,2,2 tetrahydrooctyltriethoxysilane, tridecafluoro-1,1,2,2 tetrahydrooctyltrimethoxysilane, tridecafluoro-1,1,2,2 tetrahydrooctyl trichlorosilane, or trifluoropropyltrimethoxysilane and the liquid is an alcohol such as ethanol, a hydrocarbon solvent such as n-heptane, an ether solvent such as ethylene glycol dimethylether, a polar solvent such as propylene carbonate, or the like, methods such as spin coating, curtain coating, immersion, spray coating, inkjet ejection, and roll coating may be used for the application above.
Use of such a method results in accumulation of the coated liquid in the lyophilic no-graft-polymer-generated region (base material-exposed region) as the liquid is repelled by the liquid-repellent graft polymer-generated region and also, in lyophilic non-generated region as separated from the liquid-repellent graft polymer-generated region. As a result, the liquid containing conductive fine particles is coated only in the lyophilic base material-exposed region.

Alternatively when the difference in contact angle between in the graft polymer-generated region and the non-generated region is smaller than 30°, the coating method used is preferably inkjet ejection or screen printing. It is possible to apply the liquid only in the no-graft-polymer-generated region, i.e., the desired base material-exposed region, accurately in a simple process and form a high-resolution conductive pattern by the method.

Hereinafter, the conductive pattern formation by using conductive fine particles according to the present invention will be described in detail.
A dispersion of conductive fine particles in a dispersion medium is used as the liquid containing conductive fine particles. Examples of the conductive fine particles for use include fine particles of metals such as gold, silver, copper, platinum, palladium, nickel, and aluminum, fine particles of conductive polymers and superconductive materials, and the like.
The diameter of the conductive fine particles is preferably 1 to 100 nm, more preferably 2 to 10 nm, from the viewpoint of dispersibility in solvent and ejection efficiency in the inkjet method.
These conductive fine particles may be used alone or in combination of two or more kinds.

The conductive fine particles may be surface-coated with an organic material for improvement of dispersion, and examples of the coating materials include molecules used as a dispersion medium for the fine particles, organic molecules such as citric acid, common surfactants, and the like.
When metal fine particles having a diameter of 1 to 100 nm are used as the conductive fine particles, the metal fine particles are preferably surface-coated with one or more compounds having a group coordinating with the metal element such as a group containing a nitrogen, oxygen, or sulfur atom, for improvement in the dispersion stability of the ultrafine particles. Examples of the coating compound used for improvement in dispersion stability include compounds having a terminal amino group (-NH₂), hydroxy group (-OH), sulfanyl group (-SH) and organic compound having an ether (-O-) or sulfide (-S-) bond in the molecule, and use of a coating compound superior in compatibility with the dispersion solvent is preferable. The coating compound preferably improves dispersion by forming a molecular layer coating the metal fine particle surface, but does not inhibit surface contact of the metal fine particles with each other during the final heat treatment. Thus, the coating compound preferably has a boiling point allowing easy vaporization from the metal fine particle surface when heated, for example, at 200°C or higher and finally complete elimination by vaporization.

The dispersion medium for use in the liquid containing conductive fine particles is not particularly limited, if it can disperse the conductive fine particles and does not cause aggregation, but is preferably a medium having a vapor pressure of 0.001 mmHg or more and 200 mmHg or less (approximately 0.133 Pa or more and approximately 26.6 kPa or less) at room temperature, from the viewpoints of filming efficiency and drying speed.
When the liquid coating is performed by inkjet ejection, the vapor pressure of the dispersion medium at room temperature is more preferably 0.001 mmHg or more and 50 mmHg or less (approximately 0.133 Pa or more and approximately 6,65kPa or less), from the viewpoints of filming efficiency and nozzle clogging.

Specific examples of the dispersion media for use include water; alcohols such as methanol, ethanol, propanol, butanol, and terpineol; hydrocarbon compounds such as n-heptane, n-octane, decane, tetradecane, toluene, xylene, cymene, durene, indene, depentene, tetrahydronaphthalene, decahydronaphthalene, and cyclohexylbenzene; ether compounds such as ethylene glycol dimethylether, ethylene glycol diethylether, ethylene glycol methylethylether, diethylene glycol dimethylether, diethylene glycol diethylether, diethylene glycol methylethylether, 1,2-dimethoxyethane, bis(2-methoxyethyl)ether, and p-dioxane; polar compounds such as propylene carbonate, y-butylolactone, N-methyl-2-pyrrolidone, dimethylformamide, dimethylsulfoxide, and cyclohexanone; mineral spirits; and the like.
Among them, water, alcohols, hydrocarbon compounds, and ether compounds are preferable, from the points of dispersion and dispersion stability of conductive fine particles, and water and hydrocarbon compounds are used more preferably, from the points of applicability to inkjet method.
These dispersion media may be used alone or as a mixture of two or more.

The dispersoid concentration of the conductive fine particles in the dispersion of conductive fine particles (hereinafter, referred to as "fine particle dispersion") may be altered according to the desirable thickness of the conductive film, but is generally, preferably 1 % by mass or more and 80 % by mass or less, from the viewpoints of aggregation and cost effectiveness based on coating frequency.

The surface tension of the fine particle dispersion is preferably in the range of 0.02 N/m or more and 0.07 N/m or less, from the viewpoints of applicability to inkjet method and controllability of ejection condition.
A surface-tension adjustor, either fluorine-based, silicone-based, nonionic, or the like, may be added to the dispersion, for adjustment of the surface tension. Among them, a nonionic surface-tension adjustor, which improves compatibility of the fine particle dispersion to the base material and uniformity in the level of the coated film, is effective in preventing the surface irregularity and the orange peel often found on the coated film.

In addition, the viscosity of the fine particle dispersion is preferably 1 mPa·s or more and 50 Pa·s or less, from the viewpoint of the cost effectiveness based on coating frequency and the efficiency of liquid accumulation in the no-graft-polymer-generated region, and more preferably 20 to 50 Pa·s when the dispersion is applied to screen printing and 5 to 30 mPa·s when applied to inkjet printing.
The viscosity of the fine particle dispersion is determined according to the particle diameter of the conductive fine particles used, the dispersion concentration, and the kind of the dispersion solvent used, and a desirable liquid viscosity is obtained by adjusting the three kinds of factors properly.

The method of applying the fine particle dispersion on the base material having a graft polymer-generated region and a non-generated region is selected properly according to the difference in oil- and water-repellency between in the graft polymer-generated region and in the non-generated region as described above. Specifically, it is selected properly from methods such as spin coating, screen printing, roll coating, curtain coating, immersion, spraying, inkjet printing, and the like.
For example, when in a spin coating method, the rotational frequency of the spinner is determined according to the desirable thickness of the conductive film, the solid content concentration and the viscosity of the conductive fine-particle dispersion, but generally, 100 rpm to 5,000 rpm, preferably 300 rpm to 3,000 rpm.

The method of applying the fine particle dispersion, which allows selective coating of a required amount of it only in the lyophilic region, i.e., the no-graft-polymer-generated region, is particularly preferably an inkjet printing process. Use of the inkjet printing process allows easier control of the ink ejection rate of the fine particle dispersion and thus the film thickness, and enables formation of films different in thickness and containing different kinds of conductive fine particles in different no-graft-polymer-generated regions on the base material. It also has an advantage that it is possible to reduce the amount of the materials for the fine particle dispersion, because it is possible to coat the fine particle dispersion only in the no-graft-polymer-generated regions.

The inkjet droplet-ejecting apparatus for use in the method of applying the fine particle dispersion is not particularly limited, if it can eject a certain amount of the droplet of any fine particle dispersion, and any apparatus, for example in the inkjet system using a piezoelectric device ejecting a droplet of several dozens of ng by weight or in the bubble jet (registered trade name) system in which air bubbles are generated by the heat energy of heater, may be used.
A common coating method such as spin coating, curtain coating, immersion, spray coating, inkjet printing, or roll coating may be used as needed in combination with the inkjet method, as the method of applying the fine particle dispersion.

The liquid (dispersion medium) in the fine particle dispersion deposited in the no-graft-polymer-generated region by the method is removed by drying. It is preferable then to heat the base material carrying the deposited fine particle dispersion for acceleration of drying and improvement of the electrical contact among conductive fine particles. When metal fine particles are used as the conductive fine particles, the heat treatment causes sintering of the metal fine particles, giving a sintered body layer.
The heat treatment is performed normally in air from the viewpoint of productivity, but may be performed as needed in an inert gas atmosphere such as of nitrogen, argon, or helium. The heat treatment temperature may be determined properly according to the kind of the base material, the boiling point (vapor pressure) of the solvent used in the fine particle dispersion (dispersion medium), pressure, and the thermal behavior of the conductive fine particles, and is not particularly limited, but generally, preferably in the range of room temperature or higher and 300°C or lower. It is particularly favorable to perform in a temperature range of room temperature to 100°C or lower, because a wide variety of base materials including plastics may be used as the base material.

The heat treatment may be performed by using a common hot plate, electric furnace, or the like, or by lamp annealing. The light source of the light for use in lamp annealing is not particularly limited, and examples thereof for use include infrared lamp, xenon lamp, YAG laser, argon laser, carbon dioxide laser, excimer lasers such as of XeF, XeCl, XeBr, KrF, KrCl, ArF, and ArCl, and the like. The light source commonly used has an output of 10 to 5,000 W, however normally, an output of 100 to 1,000 W is sufficient.

A conductive pattern having conductive fine particles deposited in the no-graft-polymer-generated region is obtained in this way. A metal pattern is obtained when metal fine particles are used as the conductive fine particles, and the metal pattern may be made of a sintered body layer of sintered metal fine particles.

### (Formation of conductive pattern by using metal oxide fine particles)

Specifically in the method of applying a liquid containing metal oxide fine particles on the no-graft-polymer-generated region and reducing and then heating the metal oxide fine particles according the present invention, a liquid containing metal oxide fine particles is coated on the base material having an oil- and water-repellent graft polymer-generated region and a non-generated region; after the liquid is fixed selectively in the no-graft-polymer-generated region by the oil- and water-repellency of the graft polymer-generated region and the barrier effect emerging between the graft polymer-generated region and the non-generated region, the metal oxide fine particles are reduced; and the solvent is removed. As a result, metal fine particles mutually in contact are sintered to give a sintered body layer.

A dispersion of metal oxide fine particles in a dispersion medium is used as the liquid containing metal oxide fine particles. Examples of the metal oxide fine particles for use include fine particles of gold, silver, copper, platinum, palladium, nickel, aluminum, or the like having a coating layer of the oxide of the metal on the surface.
The diameter of the metal oxide fine particles is preferably 1 to 100 nm, more preferably 2 to 10 nm, from the viewpoint of dispersibility in solvent and ejection efficiency in the inkjet method.
These metal oxide fine particles may be used alone or in combination of two or more kinds.

The metal oxide fine particles are preferably coated with one or more compounds containing a group coordinating with the metal element, i.e. a group containing a nitrogen, oxygen, or sulfur atom, on the surface for improvement in dispersion stability. The coating compound used for improvement in dispersibility is the same as the coating compound for the conductive fine particles above, and the favorable examples thereof are also the same.

A dispersion solvent showing a favorable wettability to the metal oxide fine particles and allowing favorable dispersion of the metal oxide fine particles having a surface coating layer is used as the dispersion medium used in the liquid containing metal oxide fine particles. Favorable examples of the dispersion solvents satisfying these requirements include relatively high-boiling point nonpolar or less polar solvents that do not vaporize easily at around room temperature such as terpineol, mineral spirits, xylene, toluene, tetradecane, and dodecane.
These dispersion media may be used alone or as a mixture of two or more.

The method of coating the dispersion of the metal oxide fine particles on a base material having a graft polymer-generated region and a non-generated region is selected properly according to the difference in oil- and water-repellency between in the graft polymer-generated region and in the non-generated region. Specifically, it is selected from spin coating, screen printing, roll coating, curtain coating, immersion, spraying, inkjet printing, and the like, and among them, screen printing and inkjet printing are preferable.

The dispersion of the metal oxide fine particles is preferably adjusted to a viscosity suitable for the coating method employed. For example, the viscosity is more preferably 20 to 50 Pa·s when the dispersion is used in screen printing, and 5 to 30 mPa·s when in inkjet printing. The viscosity of the dispersion depends on the particle diameter of the metal oxide fine particles, the dispersion concentration, and the kind of the dispersion solvent used; and a desirable liquid viscosity is adjusted by selecting the three kinds of factors properly.

After the dispersion of the metal oxide fine particles is coated on the base material having an oil- and water-repellent graft polymer-generated region and a non-generated region, the metal oxide fine particles are reduced. An example of the reduction method is to add a reducing agent to the dispersion previously, coating the dispersion on the base material, and reduce the metal oxide fine particles into its metal from the surface under heat, i.e., to reduce the metal oxide coating layer on the metal fine particle surface into metal. A hydrogenating agent such as a hydrogenated boron derivative is used as the reducing agent added to the dispersion in such a method, however it is preferable to add a required amount of reducing agent suitable for the amount of metal oxide fine particles to the dispersion previously, for sufficient and reproducible reduction to metal fine particles. Increase in the amount of the by-products generated in the reductive reaction by the hydrogenating agent or the residual unreacted hydrogenating agent demands an additional process of removing these components by washing.
Considering these points, a reduction method of forming a coated film by coating a metal oxide fine particle dispersion on the base material having an oil- and water-repellent graft polymer-generated region and a non-generated region and reducing the coated film while supplying a reductive reactive species in the gas phase is more preferable as the reduction method than the method of blending a required amount of reducing agent in the dispersion.

An example of the reduction method by supplying a reductive reactive species in the gas phase is a reduction method of exposing the metal oxide fine particles contained in the coated film to a plasma atmosphere generated in the presence of a reductive gas. Specifically, in reducing the metal oxide coating layer on the metal fine particle surface, it is possible to advance the reductive reaction of the surface metal oxide rapidly even at a low heating temperature of 300°C or lower, by exposing the metal oxide fine particles contained in the coated film o a plasma atmosphere generated in the presence of a reductive gas at a heating temperature adjusted to 300°C or lower and allowing active reactive species derived from the reductive gas previously generated in the plasma atmosphere to act on the metal oxide coating layer on the metal fine particle surface.

The metal oxide inside is converted into its metal atom in the reduced state while the metal oxide is formed on the surface by solid-phase reaction of the metal atom in the reduced state once generated on the surface with the metal oxide molecule inside, and the metal oxide generated on the surface is reduced into its metal atom by the reductive action of the reductive gas-derived active reactive species supplied continuously in the gas phase. After series of reaction cycles, the metal oxide coating layer originally spreading deep into the metal fine particles thins gradually, and finally, all metal oxide fine particles are converted to desirable metal fine particles.

In a specific plasma reduction process, a coat film is first formed on a base material having an oil- and water-repellent graft polymer-generated region and a non-generated region by coating a dispersion of metal oxide fine particles; the coated film is placed flat on the surface of a highly planar plate; and the air in the apparatus is removed under a reduced pressure of 150 Pa or less. Then, a mixed gas of an inert gas and a reductive gas is supplied from a gas inlet at a certain flow rate; plasma is generated in the presence of the reductive gas; and the coated film is reduced under the plasma atmosphere. For example, the flow rate of the mixed gas of an inert gas and a reductive gas is adjusted to 1 to 1,000 ml/min (normal flow rate), and the internal pressure of the apparatus is adjusted to a pressure suitable for generation and preservation of the plasma, for example in the range of 1 to 120,000 Pa, with the pressure adjusting function of the exhaust system. The internal pressure of the apparatus is preferably selected properly according to the frequency of the high-frequency power used, the electric energy, and the composition and the flow rate of the gas used. Specifically, the condition is determined properly, with reference to the condition favorable for the plasma state in various plasma CVD methods, for example in reduced-pressure plasma CVD method.

In producing plasma, it is preferable to keep a favorable plasma density by adjusting the electric energy in the range of 100 to 5,000 W, for example, by applying a high-frequency power commonly used in plasma CVD at a frequency of 13.56 MHz to the electrode. The inert gas used then for dilution of the reductive gas hydrogen or ammonia is, for example, nitrogen, helium, argon, or the like. For example, helium and argon are advantageous in generating and preserving plasma under the condition above. The blending ratio (by volume) of the inert gas to the reductive gas is preferably in the range of 50:50 to 99.9:0.1, more preferably in the range of 80:20 to 99:1.

Although there is temperature rise due to the plasma in the plasma atmosphere, the temperature is preferably so adjusted that the base material carrying the formed coating solution installed in the processing apparatus is kept at a temperature of 300°C or lower, i.e., in the range of 20°C to 300°C. The period of plasma treatment is in the range of 1 second to 1 hour, preferably 1 minute to 20 minutes, although it may vary according to the temperature setting and the plasma-generating condition.
Specifically, the temperature setting and the plasma-generating condition are selected properly, taking into account the thickness of the metal oxide layer on the metal fine particle surface and the period needed for reduction thereof. After reduction of the metal oxide layer on the metal fine particle surface by the plasma treatment, metal fine particles mutually in contact with each other on the purified metal surface are sintered at low temperature under the reductive atmosphere, giving a sintered body layer having no oxide film at the interface.

More specifically, the base material carrying the formed coating solution installed in the processing apparatus itself is reduced at a temperature of 300°C or lower, i.e., in the range of 20°C to 300°C, under the plasma treatment condition above; and the metal fine particles mutually in contact on the purified metal surface are sintered at low temperature by the thermal energy supplied by locally irradiated plasma particles. Thus, the reduction treatment is more preferably performed in combination of the reduction method of using plasma and low temperature sintering.

It is thus possible to obtain a conductive pattern (metal pattern) carrying a sintered body layer of metal fine particles in the no-graft-polymer-generated region in this manner.
The methods described, for example, in JP-ANos. 2004-247572, 2002-299833, 2004-55345, and 2003-203522 may also be used as the method of forming a conductive pattern by using a liquid containing conductive fine particles or the method of forming a conductive pattern by using a liquid containing metal oxide fine particles described above.

### (Formation of conductive pattern by electroless plating)

Specifically in the method of forming a conductive region by activating the no-graft-polymer-generated region and electroless-plating the activated region, a metal thin film is formed by adding an activator to the no-graft-polymer-generated region formed on the base material and plating only the region where the activator is added, selectively while the base material is immersed in an electroless plating solution.
It is possible by the method to form a thin-film metal pattern (conductive pattern) only in the no-graft-polymer-generated region, or in the desired base material-exposed region, accurately in a simple process.

Hereinafter, the method of forming a conductive pattern by electroless plating according to the present invention will be described in detail.
Examples of the electroless plating solutions used in the method include plating solutions such as a nickel electroless plating solution containing nickel chloride, hypophosphorous acid and water and a gold electroless plating solution containing water.
In particular in using a base material having graft polymers, for example, formed by using FAS, a solution of 20 mg of palladium chloride dissolved in 100 ml of 4 % by mass as hydrochloric acid that is adjusted to pH 5 by addition of sodium hydroxide is used as an activator, and an electroless plating solution of 25 g of nickel chloride and 25 g of sodium hypophosphite dissolved in 1 liter of water that is adjusted to around pH 5 by addition of a pH adjuster is used favorably.

Two or more different metal thin films may be formed on different regions in the no-graft-polymer-generated region by using two or more plating solutions such as electroless plating solutions. For example, it is possible to form various wires as a conductive pattern, by forming nickel thin films in certain regions and gold thin films in the other regions. It is also possible to superimpose different metal thin films by ejecting two or more electroless plating droplets onto the same regions of the no-graft-polymer-generated region.
The thickness of the metal thin film can be controlled by adjusting the ink-ejecting condition according to the precipitation condition of the metal used in the electroless plating droplet. Specifically, the number of electroless plating droplets ejected may be altered, and in such a case, it is possible to change the thickness of the metal thin film as needed, for example, by changing the ejection dot number in each lot according to the desired thickness of the metal thin film or by changing the ejection dot number according to the ejection position on a base material. Alternatively, ejection of plating solution droplet may be repeated for predetermined times, and in such a case, it is possible to change the thickness of the metal thin film by adjusting the ejection dot number and the ejection frequency of the electroless plating droplets. It is possible to reduce the change in thickness of the metal thin film into ±5% by such a method of controlling the metal thin film.

In the present invention, it is needed to activate the no-graft-polymer-generated region before application of the electroless plating solution. Thus, a metal film is formed by forming an active species layer in the no-graft-polymer-generated region by the activation treatment and ejecting and coating electroless plating droplets on the active species layer selectively.
The activation treatment is performed then by immersing a base material having a graft polymer-generated region and a non-generated region in a solution of a known activator (liquid mixture containing palladium chloride, hydrogen chloride, and others adjusted to pH 5.8, for example, by addition of an aqueous sodium hydroxide solution at room temperature) for 1 to 5 minutes. The activator is then deposited selectively in the no-graft-polymer-generated region, because of the oil- and water-repellency of the graft polymer-generated region and the barrier effect emerging between the graft polymer-generated region and the non-generated region. Alternatively, the activator may be applied only in the no-graft-polymer-generated region by inkjet ejection. In such a case, the base material after inkjet ejection of the activator is preferably left at room temperature for 1 to 5 minutes and then, washed with water.

The thickness of the plated film (metal thin film) finally obtained by the method above may be determined freely according to applications, but is preferably 0.02 to 2 µm.
The ejection condition during electroless plating is controlled according to the precipitation condition of the metal used in the electroless plating droplet. Specifically when nickel is used as the metal, the base material temperature and the humidity during ejection are preferably adjusted respectively to 30 to 60°C and 70% or more, and the ejection dot number, approximately 5; the ejection frequency, 1; and the ink ejection per dot, approximately 30 pL.

### (Formation of conductive pattern with conductive polymer layer)

Specifically in the method of forming a conductivity region by forming a conductive polymer layer in the no-graft-polymer-generated region, a conductive polymer layer is formed by coating a liquid containing a conductive polymer on the base material having an oil- and water-repellent graft polymer-generated region and a non-generated region, and immobilizing the liquid selectively in the no-graft-polymer-generated region by the oil- and water-repellency of the graft polymer-generated region and the barrier effect emerging between the graft polymer-generated region and the non-generated region.
A conductive pattern is formed with the conductive polymer layer.

The conductive polymer for the conductive polymer layer preferably has a conductivity of 10⁻⁶ s·cm⁻¹ or more, preferably 10⁻¹ s·cm⁻¹ or more, and specific examples thereof include substituted and unsubstituted conductive polyanilines, poly-para-phenylenes, poly-para-phenylene vinylenes, polythiophenes, polyfurans, polypyrroles, polyselenophenes, polyisothianaphthenes, polyphenylene sulfides, polyacetylenes, polypyridylvinylenes, polyazines, and the like. These polymers may be used alone or in combination of two or more kinds according to applications.
The conductive polymer layer may be a mixture with other non-conductive polymer in the range that does not impair the desirable conductivity, or may be a copolymer of a conductive monomer and another non-conductive monomer.
The thickness of the conductive polymer layer may be altered arbitrarily according to applications, but is preferably 0.1 to 10 µm.

In the raw conductive material-depositing process according to the present invention, it is preferable to surface-oxidize the non-generated region, for example, by surface corona discharge treatment or with permanganic acid to generate polar groups such as hydroxyl and carboxyl on the surface thereof before deposition of the raw conductive material in the no-graft-polymer-generated region. By applying a liquid containing conductive fine particles, a liquid containing metal oxide fine particles, an activator, a liquid containing a conductive polymer on the no-graft-polymer-generated region having the generated polar groups as in the method described above, interaction among the conductive fine particles, metal oxide fine particles, metal ion, conductive polymer and polar groups constituting these liquids is formed, and consequently, the raw conductive material is tightly adsorbed in the non-generated region. Thus, the conductive pattern obtained has an improved durability and wider ranges of application and use environment.

Specific methods and the conditions of depositing a raw conductive material in the no-graft-polymer-generated region obtained by the graft pattern-forming methods in the first to fourth embodiments are respectively similar to each other.
In the graft pattern-forming method in the fourth embodiment, there is a compound (Q-Y) remaining not photocleaved in the no-graft-polymer-generated region and no base material exposed unlike in the first embodiment, but it is also possible to form a conductive pattern in the fourth embodiment by a method similar to that in the first embodiment, because there are the oil- and water-repellency in the graft polymer-generated region and the barrier effect emerging between the graft polymer-generated region and the non-generated region.

### (Base material used in the method of forming a conductive pattern)

The base material for use in the method of forming a conductive pattern according to the present invention is the same as that used in the graft pattern-forming method, and the favorable embodiments are also the same.

### (Application of the method of forming a conductive pattern)

It is possible to form a wiring (conductive pattern), for example, having a specific volume resistivity of 1×10⁻⁵ Ω·cm or less at a minimum wiring width and an interwire distance of approximately 50 µm by the method of forming a conductive pattern according to the present invention described above.
The conductive pattern thus obtained is higher in conductivity and may be used in various applications. For example, it can be used in applications including fine electric wiring, high-density magnetic disk, magnetism head, magnetic tape, nonmagnetic sheet, magnetic disk, and the like, and thus, has a wider application range. It also has a potential to be used in applications such as micromachine and very large scale integrated circuit.
In addition, when a transparent film such as of PET is used as the base material, it may be used as a patterned transparent conductive film. Applications of the transparent conductive film include transparent electrode for display, dimmer device, solar battery, touch panel, other transparent conductive films, and the like, and the film is particularly useful as an electromagnetic shield filter for use in CRT and plasma display. Such an electromagnetic shield filter demands high conductivity and transparency, and thus, a metal (fine particle) film is preferably formed in the lattice form. The width of the lattice line is preferably 20 to 100 µm, and the opening between them, approximately 50 to 600 µm. The lattice may be made of regular, straight lines or alternatively may be curved.

### <Method of producing the color filter according to the present invention>

Hereinafter, the method of producing the color filter according to the present invention comprising a transparent base material and multiple pixels and partitions separating the neighboring pixels formed thereon will be described in detail.
The method of producing a color filter according to the present invention, includes a process of forming partitions separating the graft polymer-generated regions formed by the graft pattern-forming method described in the first to fourth embodiment (hereinafter, suitably referred to as "partition-forming process") and a process of forming pixels in the no-graft-polymer-generated region by using a liquid containing a colorant (hereinafter, suitably referred to as "pixel-forming process").
The partition-forming process is the same as the graft polymer-generating process in the graft pattern-forming method of the first to fourth embodiment, and the favorable conditions and others are also the same.
Hereinafter, the graft pattern-forming method in the partition-forming process and then the pixel-forming process will be described.

### (First embodiment of graft pattern-forming method)

The first embodiment of the graft pattern-forming method according to the present invention includes a process of forming a graft polymer-generated region and a non-graft polymer-generated region on the base material surface (hereinafter, referred to as "graft polymer-generating process (A)") by bringing a radically polymerizable compound having an oil- and water-repellent functional group into contact with the surface of a base material capable of generating radicals by photoirradiation, and generating graft polymers from the radicals generated in the exposure region as initial points by patternwise photoirradiation on the base material.

The "base material capable of generating radicals by photoirradiation" used in the present process is, for example, a base material containing a radical generator. Examples of the radical generators include (1) low-molecular weight radical generators (hereinafter, referred to as "low-molecular weight radical generators") and (2) polymer compounds having a radical-generating site in its main or side chain (hereinafter, referred to as "polymeric radical generators"). Hereinafter, the present invention will be described, as the low-molecular weight base material containing a radical generator is designated as base material (1) and the polymeric base material containing a radical generator as base material (2).
The base material may be prepared by adding a radical generator directly to the components constituting the base material or forming a layer containing a radical generator (radical generator-containing layer) on a substrate.
When the base material has a substrate and a radical generator-containing layer, an undercoat layer may be formed additionally between them for improvement in adhesiveness.

Examples of the low-molecular weight radical generators used in the base material (1) include known radical generator such as acetophenones, benzophenones, Michler's ketone, benzoylbenzoates, benzoins, α-acyloxime esters, tetramethylthiuram monosulfide, trichloromethyltriazine and thioxanthones. Other examples thereof for use in the present invention include sulfonium and iodonium salts normally used as photochemical acid generators, which also function as a radical generator by photoirradiation.

Examples of the polymeric radical generators for use in the base material (2) include the polymer compounds having an active carbonyl group on the side chain described, for example, in JP-A No. 9-77891, paragraph numbers [0012] to [0030] and JP-A No. 10-45927, paragraph numbers [0020] to [0073].
The molecular weight of the polymeric radical generator is preferably 1,000 to 300,000, and more preferably 3,000 to 100,000, from the viewpoint of controllability in production.

The content of these low-molecular weight radical generator or polymeric radical generator may be selected properly according to the kind of the base material used, the amount of the desired graft polymer generated, and the like.
Generally, the content of the low-molecular weight radical generator is preferably in the range of 0.1 to 40 % by mass based on the total solid content in the base material or to the radical generator-containing layer, and the content of the polymeric radical generator is preferably in the range of 1.0 to 50 % by mass based on the total solid content in the base material or to the radical generator-containing layer.

In addition to the low-molecular weight radical generator and the polymeric radical generator, a sensitizer may be added to the base material for improvement in sensitivity. Examples of the sensitizers include n-butylamine, triethylamine, tri-n-butylphosphine, thioxanthone derivatives, and the like.
The content of the sensitizer is preferably, approximately 50 to 200 % by mass, based on the radical generator.

Although a radical generator should be added to the base material itself in the base materials (1) and (2) described above, it is possible to form a "base material capable of generating radicals by photoirradiation" by forming a layer capable of generating radicals on the surface of a substrate, as in the following base material (3).
Specifically, it is a base material (3) prepared by coating and drying a coating solution containing a polymer compound having on the side chain a crosslinking site and a radical-generating site on the surface of a substrate and forming a crosslinked structure in the coated film.
Specifically, as for the base material (3), it is possible to obtain a "base material capable of generating radicals by photoirradiation", by forming a polymerization-initiation layer on a substrate by immobilizing a polymer having on the side chain a functional group capable of initiating polymerization and a crosslinkable group by crosslinking reaction. Photoirradiation of the polymerization-initiation layer surface in a patterned form generates radicals in the region.
Such a method of forming a polymerization-initiation layer is described, for example, in JP-A No. 2004-123837 in detail, and such a polymerization-initiation layer may be applied to the present invention.

Advantageously in the presence of a polymerization-initiation layer in the crosslinked structure, it is possible, for example, to prevent undesirable solubilization of the polymerization-initiating component when a liquid monomer component, specifically a radically polymerizable compound having an oil- and water-repellent functional group, is brought into contact; it is possible to perform efficient radical polymerization reaction because the strength of the polymerization-initiation layer is high and to improve the adhesiveness of the formed graft polymer with the base material.

In the graft polymer-generating process (A) of the present invention, a material for the desirable graft polymer, i.e., a radically polymerizable compound having an oil- and water-repellent functional group (e.g., oil-repellent monomer represented by fluorine-containing monomer) is brought into contact with the base material surface described above; radicals are generated in the exposure region of the base material by pattern exposure; and grafting reaction of the radically polymerizable compound having an oil- and water-repellent functional group is initiated and advanced from the radicals as initial points. As a result, an oil- and water-repellent graft polymer is generated only in the exposure region of the base material.

Hereinafter, the method of preparing a graft polymer in the graft polymer-generating process (A) will be described in detail.
The graft polymer according to the present invention is prepared by using a radically polymerizable compound having an oil- and water-repellent functional group as raw material and radicals generated on the base material surface as initial points.
During preparation of the graft polymer, a raw material, i.e., a radically polymerizable compound having an oil- and water-repellent functional group, is brought into contact with the base material, and examples of the methods include a so-called non-solvent method of bringing the compound alone into contact, a method of coating a solution or dispersion of the compound, a method of dipping a base material into the solution or dispersion, and others.
When the raw material is brought into contact with the base material without solvent, the concentration of the radically polymerizable compound having an oil- and water-repellent functional group in the composition that is brought into contact with the base material is 100%.
The radically polymerizable compound having an oil- and water-repellent functional group is used as a composition as it is diluted with a good solvent from the viewpoint of handling efficiency. The solvent for use is not particularly limited, but preferable solvents are methanol, acetone, methylethylketone, ethanol, hexane, heptane, benzene, toluene, and the like. Additives such as other monofunctional or multifunctional monomer, surfactant, and thickener may be added then as needed to the composition, together with the radically polymerizable compound having an oil- and water-repellent functional group.

For prevention of polymerization inhibition by oxygen during preparation of the graft polymer, contact of the composition containing a radically polymerizable compound having an oil- and water-repellent functional group with the base material and graft polymerization reaction thereof may be performed under an inert gas atmosphere such as of nitrogen, or alternatively, the composition containing a radically polymerizable compound having an oil-and water-repellent functional group may be covered, after contact with the base material, with a plate or film of a material transmitting the light for graft polymerization reaction such as glass, quartz, or a transparent plastic material.

In the graft polymer-generating process (A), any light may be used in the patternwise photoirradiation for preparation of the graft polymer without restriction, if it is a light having a wavelength allowing generation of radicals from the base material capable of generating radicals by photoirradiation, and specifically favorable lights include ultraviolet and visible rays having a wavelength of 150 to 800 nm, preferably 200 to 600 nm.
Specific examples of the light sources include high-pressure mercury lamp, low-pressure mercury lamp, halogen lamp, xenon lamp, excimer laser, colorant laser, semiconductor laser, YAG laser, and the like.
For preparation of the graft polymer in desired region, it is needed to irradiate the region other than the desired conductive region accurately by the pattern irradiation. Scanning beam irradiation by using a particular optical system or masked irradiation allowing high-resolution pattern irradiation is favorable for patternwise photoirradiation, and a photoirradiation method suitable for the desired resolution of pattern is selected. Alternatively, a stepper irradiation, for example by using an i-ray, KrF, or ArF stepper, may be used.

Hereinafter, the radically polymerizable compound having an oil- and water-repellent functional group for use in the present invention graft polymer-generating process (A) will be described.
The radically polymerizable compound having an oil- and water-repellent functional group is not particularly limited, if it is a compound having an oil- and water-repellent functional group and a radically polymerizable group, and may be in any form of monomer, macromer, oligomer, or polymer.

### (Radically polymerizable compound having an oil- and water-repellent functional group)

Hereinafter, examples of the radically polymerizable compound having an oil- and water-repellent functional group favorably used in the graft polymer-generating process (A) are described.
In the present invention, the water-droplet contact angle of the formed graft polymer in air is desirably 90 degrees or more, for high discrimination between the oil- and water-repellent graft polymer-generated region and the non-generated region. The high oil-and water-repellency can be estimated from the surface atom content as determined by ESCA. In the case of a silicon-containing silicon-based graft polymer, a high oil- and water-repellency is usually obtained, for example, when the Si ratio in the surface elemental composition is 10 % by atom or more based on the total amount of Si, C, and O. Alternatively in the case of a fluorine-containing fluorine-based graft polymer, the F ratio in the surface elemental composition should be 30 % by atom or more based on the total amount of F, C, and O. For preparation of a graft polymer having such a surface atom content, the raw monomer should have a silicon content of at least 10 % by atom or more in the atoms constituting the monomer when it is a silicon-based monomer and a fluorine content of 30 % by atom or more when it is a fluorine-based monomer. Thus, it is important to use a monomer satisfying the requirements above to obtain a high oil- and water-repellent graft polymer.
The macromer, oligomer, polymer, or the like used for preparation of a graft polymer having such a surface atom content should also have a silicon or fluorine atom content ratio in the molecule similar to that above.

Specific examples of the monomers having an oil- and water-repellent functional group satisfying the requirements include fluorine- and silicone-containing monomers, and the like.
Hereinafter, the fluorine- and silicone-containing monomers used in the present invention will be described.

### -Fluorine-containing monomer-

The fluorine-containing monomer for use in the graft polymer-generating process (A) is, at least one fluorine-containing monomer selected from the groups consisting of the monomers represented by the following Formulae (I), (II), (III), (IV) and (V).

CH=CRCOR²RF (I)

[wherein, R¹ represents a hydrogen atom or a methyl group; R² represents -CₚH₂ₚ-, -C(CₚH₂ₚ₊₁)H-, -CH₂C(CₚH₂ₚ₊₁)H-, or -CH₂CH₂O-; R^{f} represents -CₙF₂ₙ₊₁, -(CF₂)ₙH, -CₙF₂ₙ₊₁-CF₃, -(CF₂)ₚOCₙH₂ₙCᵢF₂ᵢ₊₁, -(CF₂)ₚOCₘH₂ₘCᵢF₂ᵢH, -N(CₚH₂ₚ₊₁)COCₙF₂ₙ₊₁, or -N(CₚH₂ₚ₊₁)SO₂CnF₂ₙ₊₁; however, p is an integer of 1 to 10; n is an integer of 1 to 16; and m is an integer of 0 to 10; and i is an integer of 0 to 16].

CF₂=CFOR^{g} (II)

[wherein, R^{g} represents a fluoroalkyl group having 1 to 20 carbon atoms].

CH₂=CHR^{g} (III)

[wherein, R^{g} represents a fluoroalkyl group having 1 to 20 carbon atoms].

CH=CR³COOR⁵R^{j}R⁶OCOCR⁴=CH₂ (IV)

[wherein, R³ and R⁴ each independently represent a hydrogen atom or a methyl group; R⁵ and R⁶ each independently represent -C_{q}H_{2q}-, -C(C_{q}H₂₊₁)H-, -CH₂C(C_{q}H_{2q+1})H-, or -CH₂CH₂O-; R^{j} represents -CₜF₂ₜ; however, q is an integer of 1 to 10, and t is an integer of 1 to 16].

CH₂=CHR⁷COOCH₂(CH₂R^{k})CHOCOCR⁸=CH₂ (V)

(wherein, R⁷, R⁸ each independently represent a hydrogen atom or a methyl group; R^{k} represents -C_{y}F_{2y+1}; however, y is an integer of 1 to 16].

Hereinafter, specific examples of the fluorine-containing monomers for use in the graft polymer-generating process (A) will be listed, however the present invention is not restricted thereby.
Examples of the monomers represented by Formula (I) include CF₃(CF₂)₇CH₂CH₂OCOCH=CH₂, CF₃CH₂OCOCH=CH₂, CF₃(CF₂)₄CH₂CH₂OCOC(CH₃)=CH₂, C₇F₁₅CON(C₂H₅)CH₂OCOC(CH₃)=CH₂, CF₃(CF₂)₇SO₂N(CH₃)CH₂CH₂OCOCH=CH₂, CF₃(CF₂)₇SO₂N(C₃H₇)CH₂CH₂OCOCH=CH₂, C₂F₅SO₂N(C₃H₇)CH₂CH₂OCOC(CH₃)=CH₂, (CF₃)₂CF(CF₂)₆(CH₂)₃OCOCH=CH₂, (CF₃)₂CF(CF₂)₁₀(CH₂)₃OCOC(CH)=CH₂, CF₃(CF₄)aCH(CH3)OCOC(CH₃)=CH2,

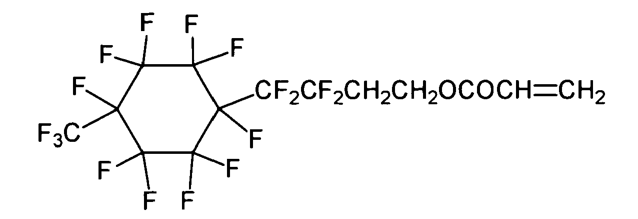

CF₃CH₂OCH₂CH₂OCOCH=CH₂, C₂F₅(CH₂CH₂O)CH₂OCOCH=CH₂, (CF₃)₂CFO(CH₂)₅OCOCH=CH₂, CF₃(CF₂)₄OCH₂CH₂OCOC(CH₃)=CH₂, C₂F₅CON(C₂H₅)CH₂OCOCH=CH₂, CF₃(CF₂)₂CON(CH₃)CH(CH₃)CH₂OCOCH=CH₂, H(CF₂)₆C(C₂H₅)OCOC(CH₃)=CH₂, H(CF₂)₆CH₂OCOCH=CH₂, H(CF₂)₄CH₂OCOCH=CH₂, H(CF₂)CH₂OCOC(CH₃)=CH₂,

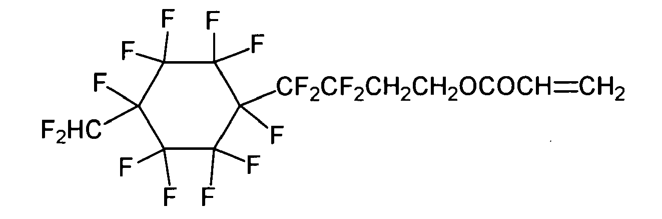

CF₃(CF₂)₇SO₂N(CH₃)CH₂CH₂OCOC(CH₃)=CH₂, CF₃(CF₂)₇SO₂N(CH₃)(CH₂)₁₀OCOCH=CH₂, C₂F₅SO₂N(C₂H₅)CH₂CH₂OCOC(CH₃)=CH₂, CF₃(CF₂)SO₂N(CH₃)(CH₂)₄OCOCH=CH₂, C₂F₅SO₂N(C₂H₅)C(C₂H₅)HCH₂OCOCH=CH₂, and the like.

Examples of the fluoroalkylated olefins represented by Formulae (II) and (III) include C₃F₇CH=CH₂, C₄F₉CH=CH₂, C₁₀F₂₁CH=CH₂, C₃F₇OCF₌CF₂, C₇F₁₅OCF=CF₂, C₈F₁₇OCF=CF₂, and the like.

Examples of the monomers represented by Formulae (IV) and (V) include CH₂=CHCOOCH₂(CF₂)₃CH₂OCOCH=CH₂, CH₂=CHCOOCH₂CH(CH₂C₈F₁₇)OCOCH=CH₂, and the like.

It is possible to use another monomer containing no fluorine as the monomer for preparation of the fluorine-containing graft polymer, in combination with the fluorine-containing monomer above in the range that does not impair the advantageous effects of the present invention. The monomer is not particularly limited, if it is radically polymerizable, and specific examples thereof include unsaturated carboxylic acids such as (meth)acrylic acid, maleic acid, fumaric acid, and itaconic acid, the alkyl or glycidyl esters thereof, styrene, alkyl acid vinyl esters, silicon-containing monomers, and the like.
The content of the monomers when used in combination is preferably 50 % by mass or less based on the fluorine-containing monomer.

### -Silicon-containing monomer-

Examples of the silicon-containing monomer for use in the graft polymer-generating process (A) include silicon-containing monomers having a SiCH₃ or O-Si-CH₃ group. A specific example thereof is silicone acrylate or methacrylate represented by the following Formula: (CH₃O)ₙSi(CH₃)₃-ₙ-R³-O-CO-CR⁴=CH₂ (n is an integer of 0 to 3), wherein R³ represents a connecting group, and R⁴ represents methyl or hydrogen. Other favorable examples thereof include the silicon-based monomers described in JP-A No. 2003-335984, paragraph number [0025].

These monomers having an oil- and water-repellent functional group may be used alone or as a mixture of two or more.

It is preferable to remove the homopolymer remaining on the base material having the graft polymer-generated region and the non-generated region thus formed, for example by immersing the base material in solvent, and thus to purify the base material. Specifically, the base material is purified by washing with water or acetone, drying, or the like. Use of a means such as ultrasonic wave irradiation is preferable, from the viewpoint of removability of the homopolymer
After purification, the homopolymer remaining on the base material surface is removed completely, and there is only a patterned oil- and water-repellent graft polymer tightly bound to the base material.

### (Second embodiment of graft pattern-forming method)

Hereinafter, the second embodiment of the method of forming a graft pattern according to the present invention will be described. The second embodiment of the method of forming a graft pattern according to the present invention is characteristically includes a process of generating radicals in an exposure region of a base material by bringing a hydrogen-abstraction radical generator into contact with the base material surface and performing patternwise photoirradiation on the base material (hereinafter, referred to as "radical-generating process") and a process of forming a graft polymer-generated region and a non-graft polymer-generated region on the base material surface by using the radicals generated in the exposure region by bringing a radically polymerizable compound having an oil- and water-repellent functional group into contact with the base material surface as initial points (hereinafter, referred to as "graft polymer-generating process (B)").

In the second embodiment of the present invention, radicals are generated in the radical-generating process, by bringing a hydrogen-abstraction radical generator into contact with the base material surface and performing patternwise photoirradiation on the base material exposure region.
The radical-generating process and the graft polymer-generating process (B) preferably proceed simultaneously, for more efficiency utilization of the generated radical in preparation of the graft polymer. In other words, radical generation on the base material surface and graft polymerization from the radicals as initial points preferably proceed almost simultaneously.
Specifically, used is a method of bringing a mixture of a hydrogen-abstraction radical generator and a radically polymerizable compound having an oil- and water-repellent functional group into contact with the base material and performing patternwise photoirradiation on the base material. Specifically, used is a method of bringing a mixture of a hydrogen-abstraction radical generator and a radically polymerizable compound having an oil- and water-repellent functional group into contact with the base material and performing patternwise photoirradiation on the base material. As a result, graft polymers having an oil-and water-repellent functional group are formed only in the exposure region of the base material.

Examples of the hydrogen-abstraction radical generators include benzophenones, thioxanthones, and the like.
For contact of the hydrogen-abstraction radical generator with the base material, used is a method of dissolving or dispersing the radical generator in a suitable solvent such as methylethylketone or 1-methoxy-2-propanol and coating the solution or dispersion on the base material surface, a method of dipping a base material in the solution or dispersion, or the like. The concentration of the hydrogen-abstraction radical generator in such a solution or dispersion is preferably, approximately 0.1 to 10 % by mass.
A solution or dispersion containing hydrogen-abstraction radical generator additionally containing an added radically polymerizable compound having an oil- and water-repellent functional group is used for bringing the hydrogen-abstraction radical generator and the radically polymerizable compound having an oil- and water-repellent functional group simultaneously into contact with the base material surface.

In the graft polymer-generating process (B) in the second embodiment of the present invention, if the processing is conducted simultaneously with that in the radical-generating process as described above, a solution or dispersion containing both a hydrogen-abstraction radical generator and a radically polymerizable compound having an oil- and water-repellent functional group is used for contact thereof with the base material, and the method, condition; and other method, condition, and the like are the same as those for the graft polymer-generating process (A) in the first embodiment of the present invention.
Regions containing and not containing the graft polymer having an oil- and water-repellent functional group are formed in the graft polymer-generating process (B).

### (Third embodiment of the method of forming a graft pattern according to the present invention)

In the third embodiment, the graft pattern-forming method according to the present invention characteristically includes a process of bonding a compound having a polymerization-initiating site capable of initiating radical polymerization by photocleavage (photocleavable compound) on the base material surface in a patterned form.
For example, a method of bonding a photocleavable compound over the entire base material surface and decomposing (inactivating) the polymerization-initiating sites in the exposure region by patternwise photoirradiation or a method of depositing and bonding a photocleavable compound on the base material surface in the patterned form by microcontact printing can be used in the process.
Most preferable in the embodiment is a method including a process of bonding a compound having a polymerization-initiating site capable of initiating radical polymerization by photocleavage and a base material-bonding site (hereinafter, referred to as "photocleavable compound-bonding process (A)") to the base material surface and a process of inactivating the polymerization-initiating sites in the exposure region by patternwise photoirradiation (hereinafter, referred to as "polymerization initiating potential-inactivating process").

The third embodiment of the graft pattern-forming method according to the present invention characteristically has a process of forming a graft polymer-generated region and a non-generated region on the base material surface by bringing a radically polymerizable compound having an oil- and water-repellent functional group into contact with the base material, photoirradiating the entire surface, and thus, preparing graft polymers from the polymerization-initiating sites as initial points (hereinafter, referred to as "graft polymer-generating process (C)".

Hereinafter, the processes to the graft polymer-generating process (C) will be described briefly, taking the third embodiment of the present invention as the most favorable embodiment, with reference to Figure 1.
Figure 1 is an exemplary schematic chart illustrating the processes to the graft polymer-generating process (C) in the third embodiment of the method of forming a conductive pattern according to the present invention.

As shown in Figure 1 (a), the base material surface has functional groups (represented by Z in the Figure) from the first. A compound (Q-Y) having a base material-bonding site (Q) and a polymerization-initiating site capable of initiating radical polymerization by photocleavage (Y) is then brought into contact with the base material surface. As shown in Figure 1(b), the functional group (Z) present on the base material surface and the base material-bonding site (Q) bind to each other, introducing the compound (Q-Y) on the base material surface [photocleavable compound-bonding process (A)].
Then, the compound (Q-Y)-introduced face is pattern-irradiated, as indicated by the arrow in Figure 1(b). The polymerization-initiating site (Y) is cleaved by the irradiation energy. As a result, as shown in Figure 1(c), the compound (Q-Y) in the exposure region becomes a compound having a polymerization initiating potential-inactivated site (S), by decomposition and inactivation of the polymerization-initiating site (Y) [polymerization initiating potential-inactivating process].
Then as shown in Figure 1(d), the entire surface is exposed to light while a raw material for graft polymer such as a monomer having an oil- and water-repellent functional group kept in contact, as indicated by the arrow in Figure 1 (d). As shown in Figure 1 (e), a graft polymer is grown from the polymerization-initiating site (Y) of the compound (Q-Y) as an initial point in the region where the polymerization-initiating site (Y) is preserved [graft polymer-generating process (C)].

Hereinafter, each of the processes above will be described specifically.
The group represented by (Z) in Figure 1 is a functional group present on the base material surface, and specifically, for example, a hydroxyl, carboxyl, or amino group, or the like. The functional group may be the group inherently present on the base material surface of silicon or glass, or a group additionally formed by surface treatment of the base material surface, for example, by corona discharge treatment.

The base material for use in the present invention is not particularly limited, and examples thereof include base materials having a functional group (Z) such as hydroxy, carboxyl, or amino on the base material surface and base materials having a functional group such as hydroxyl or carboxyl generated by surface treatment such as corona discharge treatment, glow treatment, or plasma treatment.
Generally, a flat plate-shaped base material is used, however the base material is not limited to a flat plate-shaped base material, and the graft polymer may be introduced on the surface of a base material in any other shape such as cylindrical.

Specific examples of the base materials favorable in the present invention include various base material having surface hydroxyl groups such as glass, quartz, ITO, and silicon, plastic base materials, such as PET, polypropylene, polyimide, epoxy, acryl, and urethane, having surface hydroxyl and carboxyl groups generated by surface treatment such as corona discharge treatment, glow treatment, or plasma treatment, and the like.
The thickness of the base material varies according to applications and is not particularly limited, but generally, approximately 10 µm to 10 cm.

Hereinafter, the structure of the compound having a polymerization-initiating site capable of initiating radical polymerization by photocleavage (hereinafter, simply referred to as polymerization-initiating site) and a base material-bonding site (photocleavable compound) will be described in detail.
When the photocleavable compound is described in detail by using the model of the compound (Q-Y) having a base material-bonding site (Q) and a polymerization-initiating site (Y) in the schematic chart of Figure 1, the polymerization-initiating site (Y) generally has a structure containing a single bond that cleaves by photoirradiation.
The photocleavable single bond is, for example, a single bond that is broken by carbonyl α- and β-cleavage reaction, photo-Fries rearrangement reaction, phenacyl ester cleavage reaction, sulfonimide cleavage reaction, sulfonyl ester cleavage reaction, N-hydroxysulfonyl ester cleavage reaction, benzylimide cleavage reaction, activated halogenated compound cleavage reaction, or the like. The photocleavable single bond is broken by such a reaction. Examples of the cleavable single bonds include C-C, C-N, C-O, C-Cl, N-O, and S-N bonds, and the like.

The polymerization-initiating site (Y) containing a photocleavable single bond becomes the initial point of graft polymerization in the graft polymer-generating process (C), and thus, has a function to generate a radical by cleavage reaction when the photocleavable single bond is cleaved. Examples of such structures having a photocleavable single bond and a polymerization-initiating site (Y) capable of generating a radical include structures having a group such as an aromatic ketone, phenacyl ester, sulfonimide, sulfonyl ester, N-hydroxysulfonyl ester, benzylimide, trichloromethyl, or benzyl chloride group.

Such a polymerization-initiating site (Y) generates a radical by photocleavage, and thus, when polymerizable compounds are present in the area around the radical, a desired graft polymer, and thus a graft polymer-generated region, is formed, with the radical functioning as an initial point of graft polymerization reaction.
On the other hand, when there is no polymerizable compound in the area around the radical, the radical is inactivated without use even when it is generated by photoirradiation cleavage of the polymerization-initiating site (Y), and as a result, the polymerization-initiating potential is also inactivated. As a result, the region becomes a no-graft-polymer-generated region.

On the other hand, the base material-bonding site (Q) is a reactive group bonding to the functional group (Z) present on the base material surface, and specific examples of the reactive groups include the following groups.

Base material-bonding group Q: -Si(OMe)₃, -SiCl₃, -NCO, -CH₂Cl

The polymerization-initiating site (Y) and the base material-bonding site (Q) may bind to each other directly or via a connecting group. Examples of the connecting groups include those containing atoms selected from the group consisting of carbon, nitrogen, oxygen, and sulfur; and specific examples thereof include saturated carbon groups, aromatic groups, ester groups, amido groups, ureido groups, ether groups, amino groups, sulfonamido groups, and the like. The connecting group may have an additional substituent group, and examples of the substituent groups that may be introduced include alkyl groups, alkoxy groups, halogen atoms, and the like.

Specific examples of the compounds (Q-Y) having a base material-bonding site (Q) and a polymerization-initiating site (Y) are listed below (exemplary compounds 1 to 16), together with the cleavage sites, however the present invention is not particularly restricted thereby.

C-C bond cleavage compound

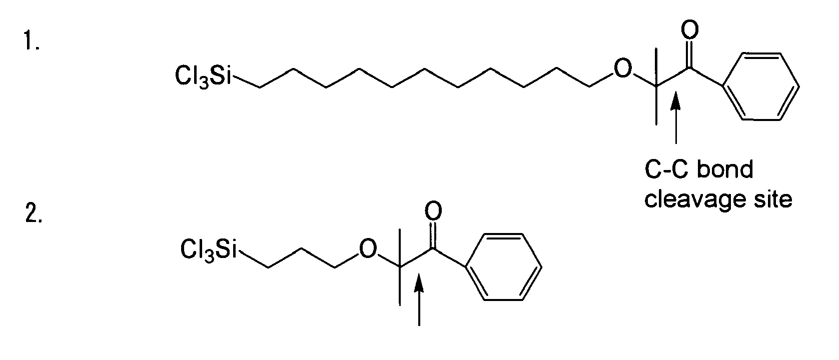

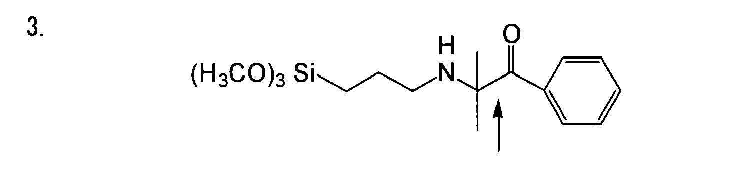

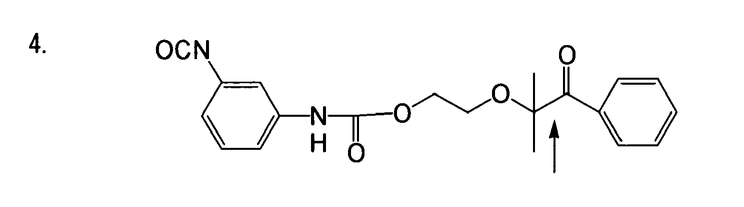

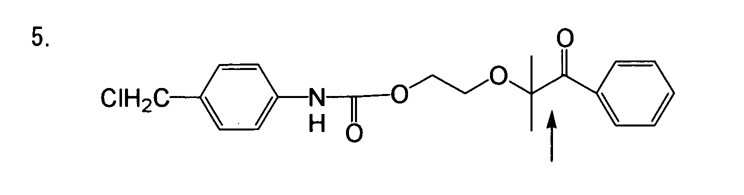

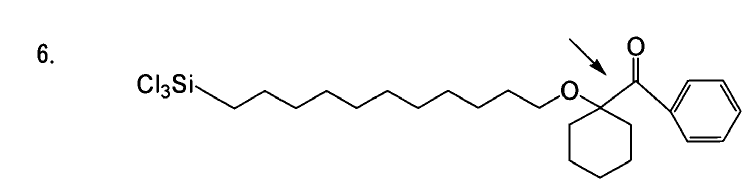

C-O bond cleavage compound 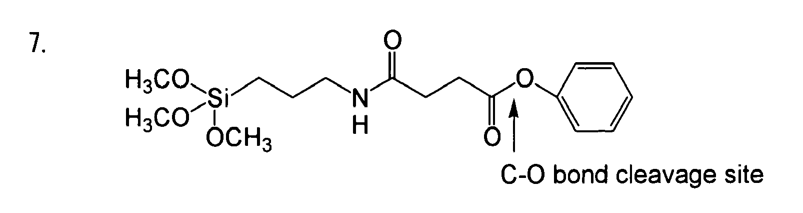 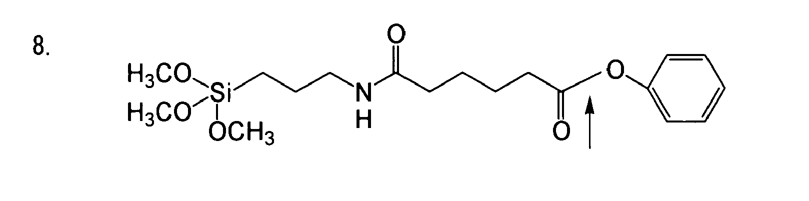 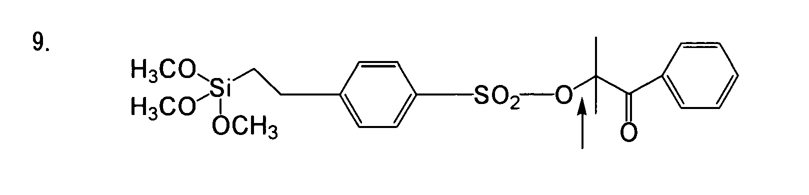 S-N bond cleavage compound

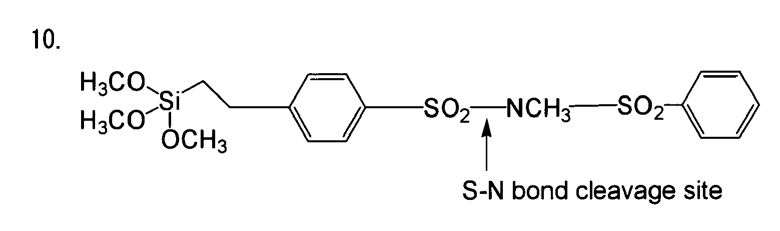

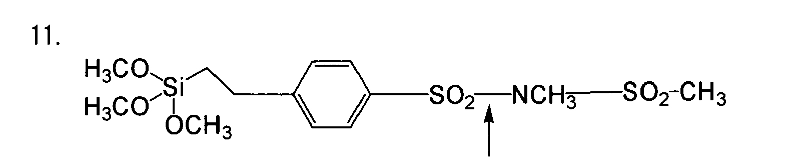

C-N bond cleavage compound 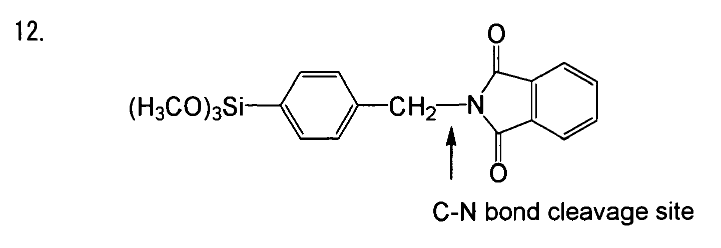 N-O bond cleavage compound 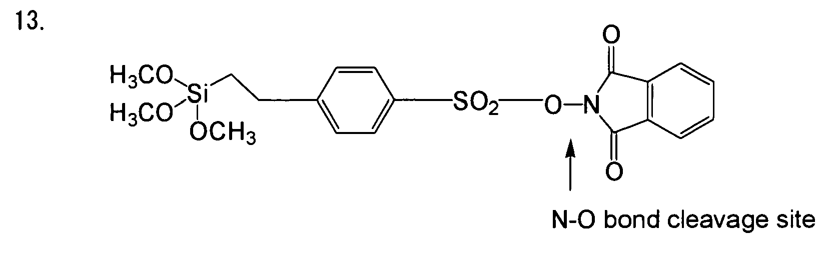 C-Cl bond cleavage compound

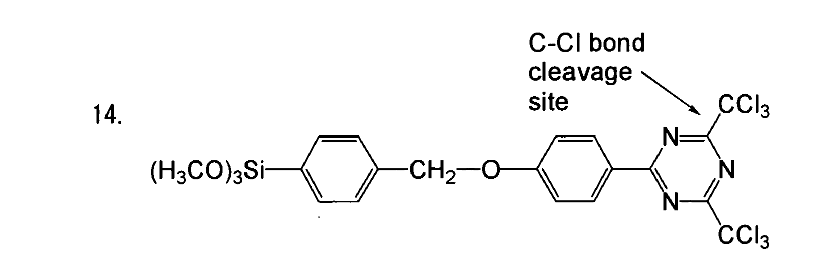

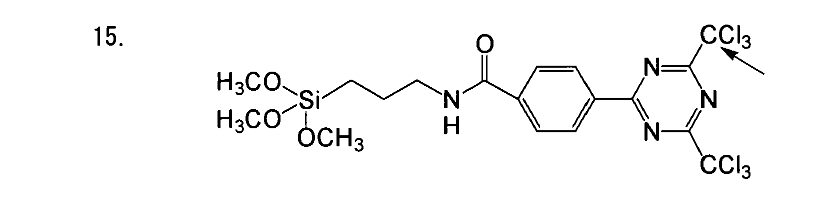

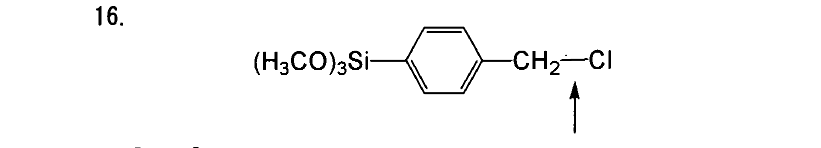

The photocleavable compound-bonding process (A) according to the present invention is a process of bonding such a compound (Q-Y) to the base material.
For example for bonding the exemplified compound (Q-Y) to the functional group (Z) present on the base material surface, a method of dissolving or dispersing a compound (Q-Y) in a suitable solvent such as toluene, hexane, or acetone and coating the solution or dispersion on the base material surface or a method of dipping the base material in the solution or dispersion may be applied. The concentration of the compound (Q-Y) in the solution or dispersion then is preferably 0.01 to 30 % by mass, particularly preferably 0.1 to 15 % by mass. The liquid temperature when in contact is preferably 0°C to 100°C. The contact period is preferably 1 second to 50 hours, more preferably 10 seconds to 10 hours.

Then in the polymerization initiating potential-inactivating process, the compound (Q-Y) bound to the base material surface is photocleaved, and the polymerization-initiating potential is inactivated by patternwise photoirradiation in the region where generation of the graft polymer is desirably prevented. As a result, a polymerization initiation-allowing region and a polymerization-initiating-potential-inactivated region are formed on the base material surface.
In the polymerization initiating potential-inactivating process, the resolution of the pattern of the polymerization initiation-allowing region and the polymerization-initiating-potential-inactivated region depends on the photoirradiation condition.
The patternwise photoirradiation methods for obtaining high resolution include, for example, scanning beam irradiation by using a particular optical system, masked irradiation, and the like, and a photoirradiation method suitable for the desired resolution of pattern is selected. Specifically, a stepper exposure, for example by using an i-ray, KrF, or ArF stepper, can be used.

The base material having the polymerization initiation-allowing region and the polymerization-initiating-potential-inactivated region thus formed is then processed in the graft polymer-generating process (C).
In the graft polymer-generating process (C), grafting reaction of the radically polymerizable compound having an oil- and water-repellent functional group is initiated and advanced from the radicals as initial points, by bringing a material for the desirable graft polymer, i.e., a radically polymerizable compound having an oil- and water-repellent functional group (e.g., oil-repellent monomer represented by fluorine-containing monomer), into contact with the base material having a polymerization initiation-allowing region and a polymerization-initiating-potential-inactivated region, photoirradiating the entire surface, and thus, generating radicals by photocleavage of the polymerization-initiating sites (Y) in the polymerization initiation-allowing region. As a result, the oil- and water-repellent graft polymers are generated only in the polymerization initiation-allowing region.

The method of preparing the graft polymer in the graft polymer-generating process (C), the condition thereof, and others are the same as those in the graft polymer-generating process (C) of the first embodiment described above, except that the entire surface is irradiated.
Because a photocleavable compound-containing layer is formed on the base material surface in the third embodiment, for prevention of uneven generation of the graft polymer by surface solubilization of the photocleavable compound-containing layer, it is preferable to select a solvent and other compounds having a physical property that does not dissolve the photocleavable compound-containing layer when the composition containing a radically polymerizable compound having an oil- and water-repellent functional group is brought into contact with the base material, as those contained in the composition containing the radically polymerizable compound.
The radically polymerizable compound having an oil- and water-repellent functional group used in the graft polymer-generating process (C) is also the same as that in the graft polymer-generating process (A).

Any light may be used without restriction in photoirradiation (patternwise photoirradiation and entire-surface irradiation) in the third embodiment of the present invention, if it can cleave the polymerization-initiating site (Y) of photocleavable compound by irradiation, but a ultraviolet or visible ray specifically having a wavelength of 200 to 800 nm, preferably 200 to 600 nm, is preferable.
Specific examples of the light sources include high-pressure mercury lamp, low-pressure mercury lamp, halogen lamp, xenon lamp, excimer laser, colorant laser, semiconductor laser, YAG laser, and the like.

### (Fourth embodiment of the method of forming a graft pattern according to the present invention)

Hereinafter, the fourth embodiment of the method of forming a graft pattern according to the present invention will be described.
In the fourth embodiment of the graft pattern-forming method according to the present invention is characterized by including a process of bonding a compound having a polymerization-initiating site capable of initiating radical polymerization by photocleavage and a base material-bonding site to the surface of a material surface (hereinafter, referred to as "photocleavable compound-bonding process (B)") and a process of forming a graft polymer-generated region and a non-generated region by performing patternwise photoirradiation after bringing a radically polymerizable compound having an oil- and water-repellent functional group into contact with the base material and generating graft polymers from the polymerization-initiating site in the exposure region as an initial points (hereinafter, referred to as "graft polymer-generating process (D)"), which are performed in this order.

Hereinafter, photocleavable compound-bonding process (B) and the graft polymer-generating process (B) in the fourth embodiment of the present invention will be described briefly, with reference to Figure 2.
Figure 2 is an exemplary schematic chart illustrating the photocleavable compound-bonding process (B) and the graft polymer-generating process (D) in the method of forming a conductive pattern in the fourth embodiment of the present invention.
As shown in Figure 2(a), the base material has functional groups (indicated by Z in the Figure) on the surface from the first. A compound (Q-Y) having a base material-bonding site (Q) and a polymerization-initiating site (Y) capable of initiating radical polymerization by photocleavage is then brought into contact with the base material surface. As shown in Figure 2(b), the functional group (Z) present on the base material surface and the base material-bonding site (Q) bind to each other, introducing the compound (Q-Y) on the base material surface [photocleavable compound-bonding process (B)].
Then as shown in Figure 2(c), patternwise photoirradiation is performed in the presence of a known raw graft polymer material such as monomer. As shown in Figure 2(d), a graft polymer-generated region is formed in the exposure region by generation of graft polymers from the polymerization-initiating sites (Y) of the compound (Q-Y) as initial points, while a no-graft-polymer-generated region is formed in the non-exposure region where there is no graft polymer generated [graft polymer-generating process (D)].

Hereinafter, each of the processes above will be described specifically.
The group represented by (Z) in Figure 2 is the same as the functional group (Z) present on the base material surface described in the third embodiment, and is specifically, for example, a hydroxyl, carboxyl or amino group, or the like.
The specific examples, shape, thickness, and others of the base material having the functional group (Z) are also the same as those in the third embodiment.

Hereinafter, the structure of the compound having a polymerization-initiating site capable of initiating radical polymerization by photocleavage (hereinafter, simply referred to as polymerization-initiating site) and a base material-bonding site will be described specifically. The compound (Q-Y) having a base material-bonding site (Q) and a polymerization-initiating site (Y) in the schematic chart of Figure 2 is the same as the compound (Q-Y) having a base material-bonding site (Q) and a polymerization-initiating site (Y) described in the third embodiment, and the structure and specific examples are also the same.
In the fourth embodiment, the polymerization-initiating sites (Y) capable of generating radicals are distributed over the entire base material surface in the graft polymer-generating process (D), because the polymerization-initiating sites are not inactivated previously by patternwise photoirradiation, as in the third embodiment.

When a radical is formed by patternwise photoirradiation cleavage at the polymerization-initiating site (Y), the radical, which functions as an initial point of graft polymerization reaction, induces growth of a desired graft polymer and gives a graft polymer-generated region if there are polymerizable compounds in the area around the radical. On the other hand, there is no cleavage at the polymerization-initiating site (Y) and no growth of graft polymer in the non-exposure region and thus, there is no graft-polymer-generated region formed.

The photocleavable compound-bonding process (B) according to the present invention is a process of bonding such a compound (Q-Y) to the base material. The method and condition used in the present process are the same as those in the photocleavable compound-bonding process (A) of the third embodiment.

In the graft polymer-generating process (D) of the present invention, grafting reaction of the radically polymerizable compound having an oil- and water-repellent functional group is initiated and advanced from the radicals as initial points, by bringing a material for the desirable graft polymer, i.e., a radically polymerizable compound having an oil- and water-repellent functional group (e.g., monomer having an oil-repellent functional group monomer), into contact with the base material after processing in the photocleavable compound-bonding process (B), performing patternwise photoirradiation, and thus, generating radicals by photocleavage of the polymerization-initiating sites in the exposure region (Y). As a result, oil- and water-repellent graft polymers are generated only in the exposure region.
In the fourth embodiment of the present invention, the unphotocleaved compound (Q-Y) remains in the no-graft-polymer-generated region.

The method of bringing the radically polymerizable compound having an oil- and water-repellent functional group into contact with the base material surface in the graft polymer-generating process (D) may be the same as that in the graft polymer-generating process (A) of the first embodiment. The radically polymerizable compound having an oil-and water-repellent functional group for use in the graft polymer-generating process (D) is also the same as that described in the graft polymer-generating process (A) of the first embodiment.

The method for patternwise photoirradiation for use in the graft polymer-generating process (D) is not particularly limited, if it is a light having a wavelength allowing photocleavage of the polymerization-initiating site (Y) of photocleavable compound, and a ultraviolet or visible ray having a wavelength similar to that described in the third embodiment is used favorably.
Also in the graft polymer-generating process (D), the resolution of the pattern of a graft polymer-generated region and a non-generated region depends on the condition of the patternwise photoirradiation. The patternwise photoirradiation methods for obtaining high resolution include, for example, scanning beam irradiation by using a particular optical system, masked irradiation, and the like, and a photoirradiation method suitable for the desired resolution of pattern is selected. Specifically, a stepper exposure, for example by using an i-ray, KrF, or ArF stepper, can be used. A high-resolution pattern of a graft polymer-generated region and a non-generated region is formed in the graft polymer-generating process (D), and the high-resolution patternwise photoirradiation give a high-resolution pattern according to the irradiation.

### (Pixel-forming process)

The liquid containing a colorant used in the pixel-forming process is not limited, if it contains colorants in various colors so that pixels in R, G and B are formed after hardening. Also in the present invention, the liquid containing a colorant preferably contains, at least, a colorant, a hardening component, and a solvent.
Hereinafter, the components for the liquid containing a colorant will be described.

### -Colorant -

Any dye- or pigment-based colorant in a particular color may be used as the colorant for use in the present invention. When used as a colorant, a pigment demand an additional dispersant for uniform dispersion in liquid, leading to decrease in the content of the colorant in the total solid content, and thus, use of a dye is preferable. The amount of the colorant added is preferably the same as or less than that of the hardening component described below.

### -Hardening component-

The hardening component for use in the present invention is not particularly limited, if it is a component that hardens by treatment such as heat treatment or photoirradiation and immobilizes the colorant, and the components preferably includes, for example, a crosslinkable monomer or polymer, or the like. In particular, considering the resistance to the subsequent heat treatment, the hardening component for use is preferably a hardenable resin composition, for example, containing a thermosetting or UV-curing resin.
The hardenable resin composition generally contains a resin as well as a crosslinking agent and a photoinitiator (polymerization initiator) for hardening the resin by photoirradiation or heat treatment.
Examples of the resins include known thermosetting resins; known UV-curing resins; acrylic resins having a functional group such as a hydroxyl, carboxyl, alkoxy, or amido group; silicone resins; cellulose derivatives such as hydroxypropylcellulose, hydroxyethylcellulose, methylcellulose, and carboxymethylcellulose, and the derivatives thereof; and vinyl resins such as polyvinylpyrrolidone, polyvinylalcohol, and polyvinylacetal.
Examples of the crosslinking agents for use include known crosslinking agents including melamine derivatives such as methylolated melamine and the like; and examples of the photoinitiators (polymerization initiators) include dichromate salts, bisazide compounds, radical initiators, cationic initiators, anionic initiators, and the like. These photoinitiators may be used in combination of two or more kinds or with another sensitizer.

### -Solvent -

The solvent for use in the present invention is preferably a mixed solvent of water and an organic solvent.
The water is preferably not common water containing various ions but ion-exchange water (deionized water).
The organic solvent is preferably selected from alkyl alcohols having 1 to 4 carbon atoms such as methyl alcohol, ethyl alcohol, n-propyl alcohol, isopropyl alcohol, n-butyl alcohol, sec-butyl alcohol, and tert-butyl alcohol; amides such as dimethylformamide and dimethylacetamide; ketones and ketoalcohols such as acetone and diacetone alcohol; ethers such as tetrahydrofuran and dioxane; polyalkylene glycols such as polyethylene glycol and polypropylene glycol; alkylene glycols with an alkylene group having 2 to 4 carbon atoms such as ethylene glycol, propylene glycol, butylene glycol, triethylene glycol, thiodiglycol, hexylene glycol, and diethylene glycol; glycerols; polyvalent alcohol lower-alkyl ethers such as ethylene glycol monomethylether, diethylene glycol methylether, and triethylene glycol monomethylether; N-methyl-2-pyrrolidone, 2-pyrrolidone, and the like.

### -Other components-

For obtaining a liquid having desired physical properties, two or more organic solvents different in boiling point may be used in combination or other additives such as surfactant, antifoam, and antiseptic may be added as needed in addition to the components above.

### -Method of adding and hardening the liquid containing a colorant-

The colorant liquid containing the components above is applied on the no-graft-polymer-generated region in the pixel-forming process. An inkjet method or any other conventionally known application method may be used for application of the liquid containing a colorant.
When an inkjet method is used for application of the liquid containing a colorant, the colorant-containing liquid is ejected as ink droplets on the no-graft-polymer-generated region. Then, the ink is repelled or removed from the graft polymer-generated region, even if deposited, and immobilized only in the no-graft-polymer-generated region.
The region where inks deposited in colors R, G, and B by the inkjet method are then subjected to desirable treatment such as heat treatment and/or photoirradiation and treatment for removal of the solvent component and hardening, before giving pixels.

In the present invention, the inkjet device used for ejecting the inks is not particularly limited, and an inkjet device in any one of various modes, for example, in a mode of ejecting charged ink continuously and controlling the ink in magnetic field, ejecting ink intermittently by using a piezoelectric device, or ejecting ink intermittently by using bubbles generated by heating.

On the other hand, when a liquid containing a colorant is applied by a known application method, the liquid containing a colorant is applied on the base material having a graft polymer-generated region and a non-generated region and fixed in the no-graft-polymer-generated region selectively by the oil- and water-repellency of the graft polymer-generated region, and then, only the area where the pixels in the color of the liquid used are desirably formed is subjected to needed treatment such as heat treatment and/or photoirradiation, and the liquid placed in the other region is removed. The processing is repeated thrice for inks in three colors R, G, and B, giving desired pixels.

The heat treatment for hardening the colorant-containing liquid is preferably performed in a temperature range of 80 to 200°C for a period in the range of 30 seconds to 1 hour.
For photoirradiation of the colorant-containing liquid, a light having a wavelength in the ultraviolet to visible range is preferably irradiated for a period in the range of 1 second to 1 hour. The irradiation energy then is preferably in the range of 1 to 1,000 mW/cm².

Specific method and condition in the process of forming pixels in the no-graft-polymer-generated region formed by the graft pattern-forming method in the first to fourth embodiment are similar to the method and condition described above.
In the partition-forming process, which corresponds to the graft pattern-forming method in the fourth embodiment, there is still the compound (Q-Y) remaining undecomposed photochemically in the non-graft polymer-generated region and there is no base material exposed, differently from the first embodiment. However, it is also possible to form pixels by a method similar to that in the first embodiment in the fourth embodiment, because the partitions in the graft polymer-generated region are superior in oil- and water-repellency.

### (Transparent base material used in method of producing a color filter)

The transparent base material for use in the present invention will be described below. The transparent base material is not particularly limited, if it has transparency allowing application to color filter, and the constituent material of it may be an organic, inorganic, or organic/inorganic hybrid material and is selected properly according to the mechanism of the polymerization-initiating active sites generated described above.
For example, an organic, inorganic, or organic/inorganic hybrid material is used as the material constituting the transparent base material for the transparent base materials (1) and (2) of the first embodiment and the transparent base material in the second embodiment.
When the transparent base material in (1) or (2) of the first embodiment has a substrate and a radical generator-containing layer formed thereon, or when the transparent base material has a polymerization-initiation layer on a substrate as in (3) of the first embodiment, the substrate may be either an organic or inorganic material.

The transparent base material in the third or fourth embodiment should have a functional group such as hydroxyl, carboxyl, or amino on the surface, or a functional group, such as hydroxyl or carboxyl, formed by surface treatment such as corona discharge treatment, glow treatment, or plasma treatment. Specific examples of the transparent base materials include various base materials containing surface hydroxyl groups such as glass, quartz, and ITO; and plastic base materials, such as PET, polypropylene, polyimide, epoxy, acryl, and urethane, having surface hydroxyl and carboxyl groups generated by surface treatment such as corona discharge treatment, glow treatment, or plasma treatment, and the like.

Examples of the organic materials for the various transparent base materials (substrates) include acrylic resins such as polymethyl methacrylate; polyester resins such as polyethylene terephthalate, polyethylene naphthalate, poly-1,4-cyclohexanedimethylene terephthalate, polyethylene-1,2-diphenoxyethane-4,4'-dicarboxylate, and polybutylene terephthalate; commercial products such as Epikote (trade name, manufactured by Yuka Shell Epoxy Co., Ltd.); epoxy resins, polycarbonate resins, polyimide resins, novolak resins, phenol resins, and the like.
Examples of other organic materials include cellulose esters (e.g., triacetylcellulose, diacetylcellulose, propionylcellulose, butyrylcellulose, and acetylpropionylcellulose, nitrocellulose), polyamides, polystyrenes (e.g., syndiotactic polystyrene), polyolefins (e.g., polypropylene, polyethylene, polymethylpentene), polysulfones, polyether sulfones, polyarylates, polyether imides, polyether ketones, and the like.

Examples of the inorganic material for the various transparent base materials (substrates) include glass, quartz, ITO, and the like. The composite materials thereof are also usable.

Other compounds may be added to the base material of organic material as needed according to application of the graft pattern.
For example, it is possible to improve the strength of the base material by adding a compound having a radically polymerizable double bond. Examples of the compound shaving a radically polymerizable double bond include acrylate and methacrylate compounds. The acrylate ((meth)acrylate) compound for use in the present invention is not particularly limited, if it has an ethylenic unsaturated group, acryloyl group, in the molecule, but is preferably a multifunctional monomer for improvement in hardening efficiency, rigidity of the base material surface, strength and surface radical reactivity.
The multifunctional monomer favorably used in the present invention is preferably an ester of a polyvalent alcohol and acrylic or methacrylic acid. Examples of the polyvalent alcohols include ethylene glycol, 1,4-cyclohexanol, pentaerythritol, trimethylolpropane, trimethylolethane, dipentaerythritol, 1,2,4-cyclohexanol, polyurethane polyols, and polyester polyols. Among them, trimethylolpropane, pentaerythritol, dipentaerythritol and polyurethane polyol are preferable. The intermediate layer may contain two or more multifunctional monomers.

The multifunctional monomer is a monomer having at least two ethylenic unsaturated groups, more preferably a monomer having three or more unsaturated groups. Specific examples there of include multifunctional acrylate monomer having 3 to 6 acrylic ester groups in the molecule; and oligomers, called urethane acrylates, polyester acrylate, and epoxyacrylates, that have several acrylic ester groups in the molecule and a molecular weight of several hundreds to several thousands are also used favorably as the component for the intermediate layer according to the present invention.
Specific examples of the acrylates having three or more acryl group in the molecule include polyol polyacrylates such as trimethylolpropane triacrylate, ditrimethyrollpropane tetraacrylate, pentaerythritol triacrylate, pentaerythritol tetraacrylate, dipentaerythritol pentaacrylate, and dipentaerythritol hexaacrylate; urethane acrylates obtained in reaction of a polyisocyanate and a hydroxyl group-containing acrylate such as hydroxyethyl acrylate; and the like.
The thickness of the base material is not particularly limited, but generally, approximately 10 µm to 10 cm.

The method of producing a color filter according to the present invention may have a process of forming a protective layer or a transparent conductive film as needed after the pixels are formed in any embodiment. The protective layer for use in such a case is, for example, a photo-hardening, thermosetting, or photo- and thermo-setting resin material, an inorganic film formed, for example, by vapor deposition or sputtering, or the like, and any material may be used if it is a material that has transparency suitable for color filter and is resistant to the processing condition during production of the transparent conductive film. The transparent conductive film is formed, for example, with ITO (indium tin oxide). The transparent conductive film may be formed directly on the pixels without a protective layer.

### (Application of the method of producing a color filter)

As described above, the method of producing a color filter according to the present invention allows easily production of a uniform, fine color filter in a simpler process without any expensive apparatus. As a result, the method is applicable effectively to the processes for production of display device and image sensor that demand fine color filters.

### <Method of producing a microlens according to the present invention>

The first embodiment of the method of producing a microlens according to the present invention characteristically includes a process of forming a graft polymer-generated region and a non-generated region by using the graft pattern-forming method of the third embodiment (hereinafter, suitably referred to as "graft polymer-generating process (A)") and a process of applying a microlens raw material fluid on the no-graft-polymer-generated region and hardening the microlens raw material fluid (hereinafter, suitably referred to as "microlens-forming process").
The method of producing a microlens according to the present invention in the second embodiment characteristically includes a process of forming a graft polymer-generated region and a non-generated region by using the graft pattern-forming method of the fourth embodiment (hereinafter, suitably referred to as "graft polymer-generating process (B)") and a process of applying a microlens raw material fluid in the no-graft-polymer-generated region and hardening the microlens raw material fluid (hereinafter, suitably referred to as "microlens-forming process").

### <First embodiment of the method of producing a microlens according to the present invention>

In the first embodiment of the method of producing a microlens according to the present invention, a compound having a polymerization-initiating site capable of initiating radical polymerization by photocleavage (photocleavable compound) is bound to the base material surface in a patterned form.
For example, a method of bonding a photocleavable compound over the entire base material surface and decomposing (inactivating) the polymerization-initiating sites in the exposure region by desirably patternwise photoirradiation or a method of applying a photocleavable compound on the base material surface and bonding it thereto in a desired pattern by microcontact printing may be used in the process.
Most preferable in the present embodiment is a method including a process of bonding a compound having a polymerization-initiating site capable of initiating radical polymerization by photocleavage and a base material-bonding site to the base material surface (hereinafter, suitably referred to as "photocleavable compound-bonding process (A)") and a process of inactivating the polymerization-initiating sites in the exposure region by patternwise photoirradiation (hereinafter, suitably referred to as "polymerization initiating potential-inactivating process").

Additionally after the process, the first embodimentof the method of producing a microlens according to the present invention has a process of forming a graft polymer-generated region and a non-generated region by applying an oil-repellent radically polymerizable compound having a functional group on the base material above, photoirradiating the entire surface, and thus, preparing graft polymers from the polymerization-initiating sites as initial points (hereinafter, referred to as "graft polymer-generating process (C)"), and a process of applying a microlens raw material fluid in the no-graft-polymer-generated region and hardening the microlens raw material fluid (hereinafter, referred to as "microlens-forming process (A)").

Hereinafter, the respective processes to the graft polymer-generating process (C) in the first embodiment of the method of producing a microlens according to the present invention will be described briefly with reference to Figure 1.
Figure 1 is a schematic chart illustrating respective processes in the first embodiment of the method of producing a microlens according to the present invention.

As shown in Figure 1(a), the base material surface has functional groups (represented by Z in the Figure) from the first. A compound (Q-Y) having a base material-bonding site (Q) and a polymerization-initiating site capable of initiating radical polymerization by photocleavage (Y) is then brought into contact with the base material surface. As shown in Figure 1(b), the functional group (Z) present on the base material surface and the base material-bonding site (Q) bind to each other, introducing the compound (Q-Y) on the base material surface [photocleavable compound-bonding process (A)].
Then, the compound (Q-Y)-introduced face is pattern-irradiated, as indicated by the arrow in Figure 1(b). The polymerization-initiating site (Y) is cleaved by the irradiation energy. As a result, as shown in Figure 1 (c), the compound (Q-Y) in the exposure region becomes a compound having a polymerization initiating potential-inactivated site (S), by decomposition and inactivation of the polymerization-initiating site (Y) [polymerization initiating potential-inactivating process].
Then as shown in Figure 1(d), the entire surface is exposed to light while a raw material for graft polymer such as a monomer having an oil- and water-repellent functional group kept in contact, as indicated by the arrow in Figure 1(d). As shown in Figure 1(e), graft polymers are grown from the polymerization-initiating sites (Y) of the compound (Q-Y) as initial points in the region where the polymerization-initiating site (Y) is preserved [graft polymer-generating process (C)].

Hereinafter, each of the processes above will be described specifically.
The group represented by (Z) in Figure 1 is a functional group present on the base material surface, and specifically, for example, a hydroxyl, carboxyl, or amino group, or the like. The functional group may be the group inherently present on the base material surface of silicon or glass, or a group additionally formed by surface treatment of the base material surface, for example, by corona discharge treatment.

The base material for use in the present invention is not particularly limited, and examples thereof include base materials having a functional group (Z) such as hydroxy, carboxyl, or amino on the base material surface and base materials having a functional group such as hydroxyl or carboxyl generated by surface treatment such as corona discharge treatment, glow treatment, or plasma treatment, and the like.
Generally, a flat plate-shaped base material is used, however the base material is not limited to a flat plate-shaped base material, and the graft polymer may be introduced on the surface of a base material in any other shape such as cylindrical.

Specific examples of the base materials favorable in the present invention include various base material having surface hydroxyl groups such as glass, quartz, ITO, and silicon, plastic base materials, such as PET, polypropylene, polyimide, epoxy, acryl, and urethane, having surface hydroxyl and carboxyl groups generated by surface treatment such as corona discharge treatment, glow treatment, or plasma treatment, and the like.
Specifically, for example when the microlens obtained in the present invention is used for reflective purpose, for example, as a plasma display or reflection liquid crystal display, an aluminum plate or a base material carrying an aluminum thin film may be used.
When the method of producing a microlens according to the present invention is applied to production of a microlens array having microlenses arranged in multiple lines at a particular distance on a base material, it is preferable to select a base material having a favorable light-transmitting efficiency, strength, and thickness suitable for the desirable array. It is preferable to select a base material allowing tight adhesion between the microlenses formed on the surface and the base material, when the method is applied to production of a microlens array.

The method according to the present invention, which allows formation of microlenses in a desired shape freely on the surface independently of the properties of base material, has advantages that the freedom in selecting the base material is wider and that it is possible to form a microlens array freely on a desirable base material.

Hereinafter, the structure of the compound having a polymerization-initiating site capable of initiating radical polymerization by photocleavage (hereinafter, simply referred to as polymerization-initiating site) and a base material-bonding site (photocleavable compound) will be described specifically.
When the photocleavable compound is described in detail by using the model of the compound (Q-Y) having a base material-bonding site (Q) and a polymerization-initiating site (Y) in the schematic chart of Figure 1, the polymerization-initiating site (Y) generally has a structure containing a single bond that cleaves by photoirradiation.
The photocleavable single bond is, for example, a single bond that is broken by carbonyl α- and β-cleavage reaction, photo-Fries rearrangement reaction, phenacyl ester cleavage reaction, sulfonimide cleavage reaction, sulfonyl ester cleavage reaction, N-hydroxysulfonyl ester cleavage reaction, benzylimide cleavage reaction, activated halogenated compound cleavage reaction, or the like. The photocleavable single bond is broken by such a reaction. Examples of the cleavable single bonds include C-C, C-N, C-O, C-Cl, N-O, and S-N bonds, and the like.

The polymerization-initiating site (Y) containing a photocleavable single bond becomes the initial point of graft polymerization in the graft polymer-generating process (C), and thus, has a function to generate a radical by cleavage reaction when the photocleavable single bond is cleaved. Examples of such structures having a photocleavable single bond and a polymerization-initiating site (Y) capable of generating a radical include structures having a group such as an aromatic ketone, phenacyl ester, sulfonimide, sulfonyl ester, N-hydroxysulfonyl ester, benzylimide, trichloromethyl, or benzyl chloride group.

Such a polymerization-initiating site (Y) generates a radical by photocleavage, and thus, when polymerizable compounds are present in the area around the radical, a desired graft polymer, and thus a graft polymer-generated region, is formed, with the radical functioning as an initial point of graft polymerization reaction.
On the other hand, when there is no polymerizable compound in the area around the radical, the radical is inactivated without use even when it is generated by photoirradiation cleavage of the polymerization-initiating site (Y), and as a result, the polymerization-initiating potential is also inactivated. As a result, the region becomes a no-graft-polymer-generated region.

On the other hand, the base material-bonding site (Q) is a reactive group bonding to the functional group (Z) present on the base material surface, and specific examples of the reactive groups include the following groups.

Base material-bonding group Q: -Si(OMe)₃, -SiCl₃, -NCO, -CH₂Cl

The polymerization-initiating site (Y) and the base material-bonding site (Q) may bind to each other directly or via a connecting group. Examples of the connecting groups include those containing atoms selected from the group consisting of carbon, nitrogen, oxygen, and sulfur; and specific examples thereof include saturated carbon groups, aromatic groups, ester groups, amido groups, ureido groups, ether groups, amino groups, sulfonamido groups, and the like. The connecting group may have an additional substituent group, and examples of the substituent groups that may be introduced include alkyl groups, alkoxy groups, halogen atoms, and the like.

Specific examples of the compounds (Q-Y) having a base material-bonding site (Q) and a polymerization-initiating site (Y) are listed below (exemplary compounds 1 to 16), together with the cleavage sites, however the present invention is not particularly restricted thereby.

C-C bond cleavage compound

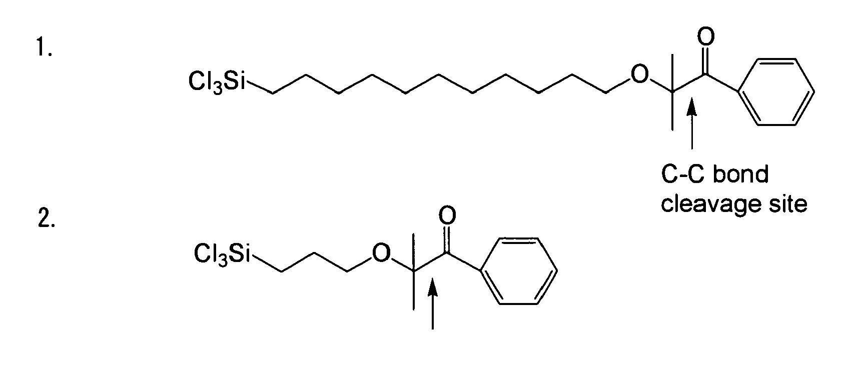

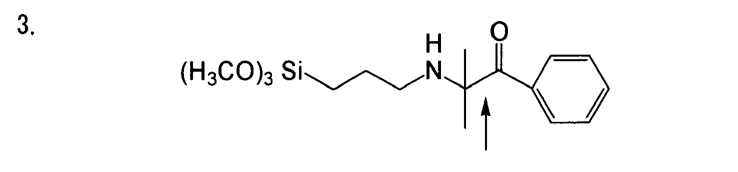

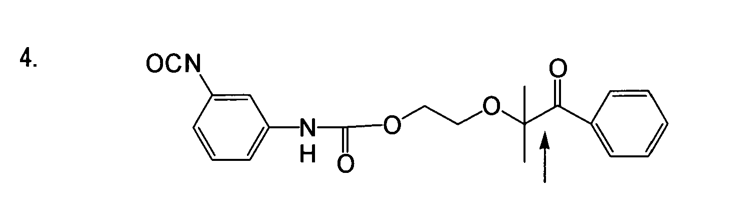

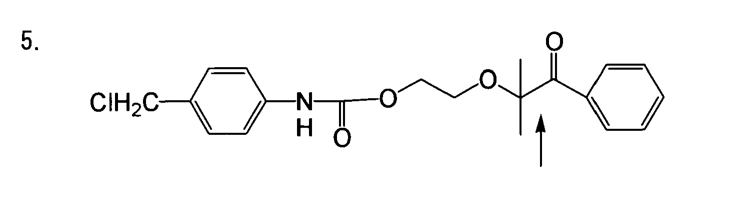

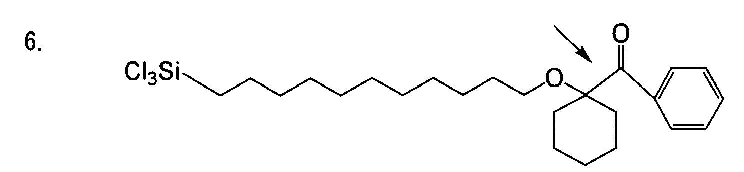

C-O bond cleavage compound 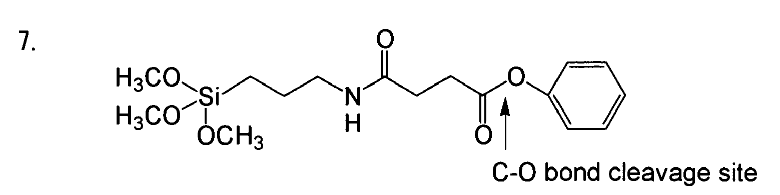 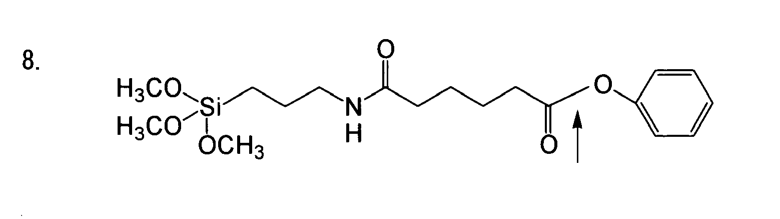 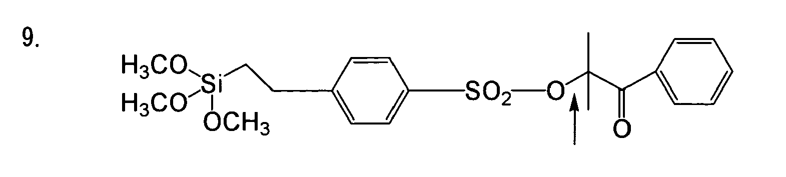 S-N bond cleavage compound

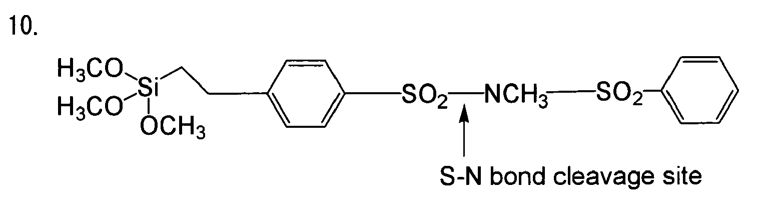

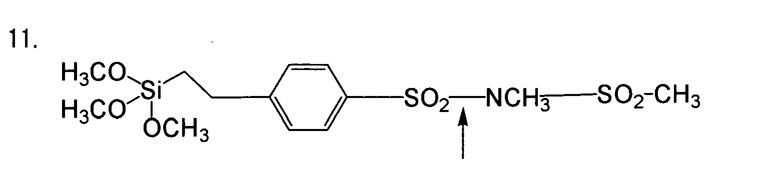

C-N bond cleavage compound 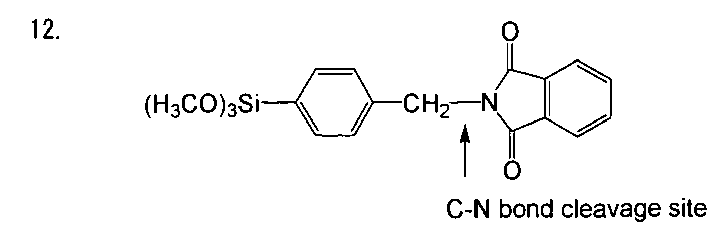 N-O bond cleavage compound 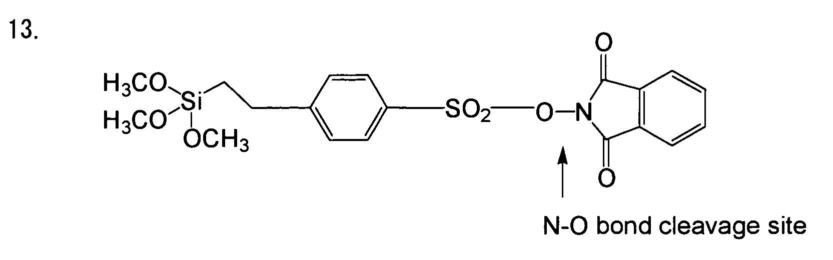 C-Cl bond cleavage compound

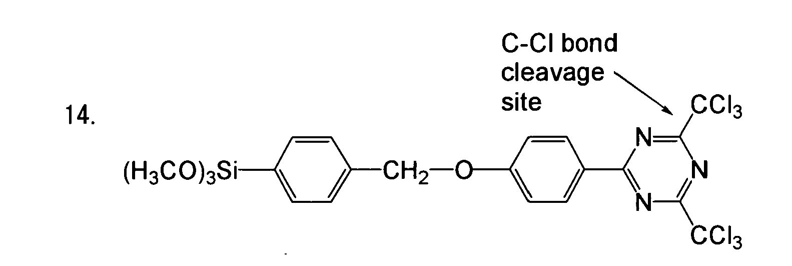

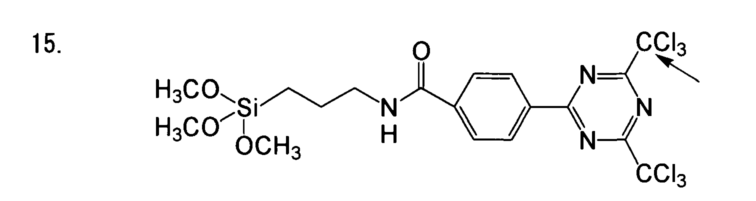

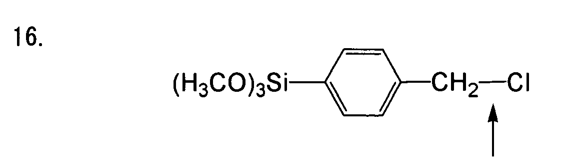

The photocleavable compound-bonding process (A) according to the present invention is a process of bonding such a compound (Q-Y) to the base material.
For example for bonding the exemplified compound (Q-Y) to the functional group (Z) present on the base material surface, a method of dissolving or dispersing a compound (Q-Y) in a suitable solvent such as toluene, hexane, or acetone and coating the solution or dispersion on the base material surface or a method of dipping the base material in the solution or dispersion may be applied. The concentration of the compound (Q-Y) in the solution or dispersion then is preferably 0.01 to 30 % by mass, particularly preferably 0.1 to 15 % by mass. The liquid temperature when in contact is preferably 0°C to 100°C. The contact period is preferably 1 second to 50 hours, more preferably 10 seconds to 10 hours.

Then in the polymerization initiating potential-inactivating process, the compound (Q-Y) bound to the base material surface is photocleaved, and the polymerization-initiating potential is inactivated by patternwise photoirradiation in the region where generation of the graft polymer is desirably prevented. As a result, a polymerization initiation-allowing region and a polymerization-initiating-potential-inactivated region are formed on the base material surface.
The region where generation of the graft polymer is desirably prevented is a region
on which the microlens raw material fluid is applied in the circular or square form with a desired microlens shape. Thus in the present process, the region in the circular or square shape is exposed to light, converting only the exposed region into a polymerization-initiating-potential-inactivated region.
When the microlens production method according to the present invention is applied to production of a microlens array, the distance between the lenses is preferably smaller, and thus in the present process, high-resolution patternwise photoirradiation is preferable. For example, scanning beam irradiation by using a particular optical system or masked irradiation is used favorably for the high-resolution patternwise photoirradiation, and a photoirradiation method suitable for the desired resolution of pattern is selected. Alternatively, a stepper exposure, for example by using an i-ray, KrF, or ArF stepper, may be used.

The base material having the polymerization initiation-allowing region and the polymerization-initiating-potential-inactivated region thus formed is then processed in the graft polymer-generating process (C).
In the graft polymer-generating process (C), grafting reaction of the radically polymerizable compound having an oil- and water-repellent functional group is initiated and advanced from the radicals as initial points, by bringing a material for the desirable graft polymer, i.e., a radically polymerizable compound having an oil- and water-repellent functional group (e.g., oil-repellent monomer represented by fluorine-containing monomer), into contact with the base material having a polymerization initiation-allowing region and a polymerization-initiating-potential-inactivated region, photoirradiating the entire surface, and thus, generating radicals by photocleavage of the polymerization-initiating sites (Y) in the polymerization initiation-allowing region. As a result, the oil- and water-repellent graft polymers are generated only in the polymerization initiation-allowing region.

The method of preparing a graft polymer in the graft polymer-generating process (C) will be described below in detail.
The graft polymer according to the present invention is prepared with an oil-repellent radically polymerizable compound having a functional group as raw material by using the radicals generated from the polymerization-initiating sites (Y) formed optically by photoirradiation as initial points.
During preparation of the graft polymer, a raw material, i.e., a radically polymerizable compound having an oil- and water-repellent functional group, is brought into contact with the base material, and examples of the methods include a so-called non-solvent method of bringing the compound alone into contact, a method of coating a solution or dispersion of the compound, a method of dipping a base material into the solution or dispersion, and others.
When the raw material is brought into contact with the base material without solvent, the concentration of the radically polymerizable compound having an oil- and water-repellent functional group in the composition that is brought into contact with the base material is 100%.
The radically polymerizable compound having an oil- and water-repellent functional group is used as a composition as it is diluted with a good solvent from the viewpoint of handling efficiency. The solvent for use is not particularly limited, but preferable solvents are methanol, acetone, methylethylketone, ethanol, hexane, heptane, benzene, toluene, and the like. Additives such as other monofunctional or multifunctional monomer, surfactant, and thickener may be added then as needed to the composition, together with the radically polymerizable compound having an oil- and water-repellent functional group.

During application of the composition containing a radically polymerizable compound having an oil-repellent functional group on the base material, it is preferable to select a solvent and other compounds having physical properties that do not dissolve the initiator compound layer as those contained in the composition containing a radically polymerizable compound having an oil-repellent functional group, for prevention of solubilization of the surface of the initiator compound layer having polymerization-initiating sites and heterogeneous growth of the graft polymer.

For prevention of polymerization inhibition by oxygen during preparation of the graft polymer, contact of the composition containing a radically polymerizable compound having an oil- and water-repellent functional group with the base material and graft polymerization reaction thereof may be performed under an inert gas atmosphere such as of nitrogen, or alternatively, the composition containing a radically polymerizable compound having an oil-and water-repellent functional group may be covered, after contact with the base material, with a plate or film of a material transmitting the light for graft polymerization reaction such as glass, quartz, or a transparent plastic material.

The light used for photoirradiation (patternwise photoirradiation and entire-surface irradiation) in the first embodiment of the method of producing a microlens according to the present invention is not particularly limited, if it is a light having a wavelength allowing photocleavage at the polymerization-initiating site (Y) of photocleavable compound, and is preferably a light having a wavelength of 200 to 800 nm, more preferably a ultraviolet or visible ray having a wavelength of 300 to 600 nm.
Specific examples of the light sources include high-pressure mercury lamp, low-pressure mercury lamp, halogen lamp, xenon lamp, excimer laser, colorant laser, semiconductor laser, YAG laser, and the like.

Hereinafter, the oil-repellent radically polymerizable compound having a functional group used in the graft polymer-generating process (C) of the present invention will be described.
The radically polymerizable compound having an oil-repellent functional group is not particularly limited, if it is a compound having an oil-repellent functional group and a radically polymerizable group, and may be in any form of monomer, macromer, oligomer, or polymer.

### (Radically polymerizable compound having an oil-repellent functional group)

Favorable examples of the radically polymerizable compounds having an oil-repellent functional group used favorably in the graft polymer-generating process (C) are listed below.
The water-droplet contact angle of the formed graft polymer in air is preferably 90 degrees or more, for high discrimination between the oil-repellent graft polymer-generated region and the non-generated region in the present invention. The high oil-repellency value can be estimated from the surface atom rate as determined by ESCA. In the case of a silicon-containing silicon-based graft polymer, a high oil- and water-repellency is usually obtained, for example, when the Si ratio in the surface elemental composition is 10 % by atom or more based on the total amount of Si, C, and O. Alternatively in the case of a fluorine-containing fluorine-based graft polymer, the F ratio in the surface elemental composition should be 30 % by atom or more based on the total amount of F, C, and O. For preparation of a graft polymer having such a surface atom content, the raw monomer should have a silicon content of at least 10 % by atom or more in the atoms constituting the monomer when it is a silicon-based monomer and a fluorine content of 30 % by atom or more when it is a fluorine-based monomer. Thus, it is important to use a monomer satisfying the requirements above to obtain a high oil- and water-repellent graft polymer.
The macromer, oligomer, polymer, or the like used for preparation of a graft polymer having such a surface atom content should also have a silicon or fluorine atom content ratio in the molecule similar to that above.

Specific examples of the monomers having an oil- and water-repellent functional group satisfying the requirements include fluorine- and silicone-containing monomers, and the like. Hereinafter, the fluorine- and silicone-containing monomers used in the present invention will be described.

### -Fluorine-containing monomer -

The fluorine-containing monomer for use in the graft polymer-generating process (A) is, at least one fluorine-containing monomer selected from the groups consisting of the monomers represented by the following Formulae (I), (II), (III), (IV) and (V).

CH₂=CR1COOR²R^{f} (I)

[wherein, R¹ represents a hydrogen atom or a methyl group; R² represents -CₚH₂ₚ-, -C(CₚH₂ₚ₊₁)H-, -CH₂C(CₚH₂ₚ₊₁)H-, or - CH₂CH₂O-; R^{f} represents -CₙF₂ₙ₊₁, -(CF₂)ₙH, -CₙF₂ₙ₊₁-CF₃, -(CF₂)ₚOCₙH₂ₙCᵢF₂ᵢ₊₁, -(CF₂)ₚOCₘH₂ₘCᵢF₂ᵢH, -N(CₚH₂ₚ₊₁)COCₙF₂ₙ₊₁, or -N(CₚH₂ₚ₊₁)SO₂CₙF₂ₙ₊₁; however, p is an integer of 1 to 10; n is an integer of 1 to 16; m is an integer of 0 to 10; and i is an integer of 0 to 16].

CF₂=CFOR^{g} (II)

[wherein, R^{g} represents a fluoroalkyl group having 1 to 20 carbon atoms].

CH₂=CHR^{g} (III)

[wherein, R^{g} represents a fluoroalkyl group having 1 to 20 carbon atoms].

CH₂ =CR³COOR⁵R^{j}R⁶OCOCR⁴=CH₂ (IV)

(wherein, R³ and R⁴ each independently represent a hydrogen atom or a methyl group;
R⁵ and R⁶ each independently represent -C_{q}H_{2q}-, -C(C_{q}H_{2q+1})H-, -CH₂(C_{q}H_{2q+1})H-, or -CH₂CH₂O-; R^{j} represents -CₜF₂ₜ; however, q is an integer of 1 to 10, and t is an integer of 1 to 16].

CH₂=GHR⁷COOCH₂(CH₂R^{k})CHOCOCR⁸=CH₂ (V)

[wherein, R⁷ and R⁸each independently represent a hydrogen atom or a methyl group; R^{k} represents -CyF_{2y+1}; however, y is an integer of 1 to 16].

Hereinafter, specific examples of the fluorine-containing monomers used in the graft polymer-generating process (C) are listed, however the present invention is not limited thereto.
Examples of the monomers represented by Formula (I) include CF₃(CF₂)₇CH₂CH₂OCOCH=CH₂, CF₃CH₂OCOCH=CH₂, CF₃(CF₂)₄CH₂CH₂OCOC(CH₃)=CH₂, C₇F₁₅CON(C₂H₅)CH₂OCOC(CH₃)=CH₂, CF₃(CF₂)₇SO₂N(CH₃)CH₂CH₂OCOCH=CH₂, CF₃(CF₂)₇SO₂N(C₃H₇)CH₂CH₂OCOCH=CH₂, C₂F_{S}SO₂N(C₃H₇)CH₂CH₂OCOC(CH₃)=CH₂, (CF₃)₂CF(CF₂)₆(CH₂)₃OCOCH=CH₂, (CF₃)₂CF(CF₂)₁₀(CH₂)₃OCOC(CH₃)=CH₂, CF₃(CF₂)₄CH(CH₃)OCOC(CH₃)=CH₂,

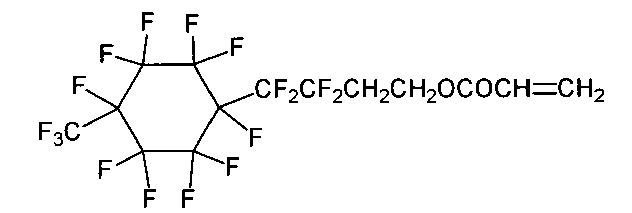

CF₃CH₂OCH₂CH₂OCOCH=CH₂, C₂F₅(CH₂CH₂O)₂CH₂OCOCH=CH₂, (CF₃)₂CFO(CH₂)₅OCOCH=CH₂, CF₃(CF₂)₄OCH₂CH₂OCOC(CH₃)=CH₂, C₂F₅CON(C₂H₅)CH₂OCOCH=CH₂, CF₃(CF₂)₂CON(CH₃)CH(CH₃)CH₂OCOCH=CH₂, H(CF₂)₆C(C₂H₅)OCOC(CH₃)=CH₂, H(CF₂)₈CH₂OCOCH=CH₂, H(CF₂)₄CH₂OCOCH=CH₂, H(CF₂)CH₂OCOC(CH)=CH₂,

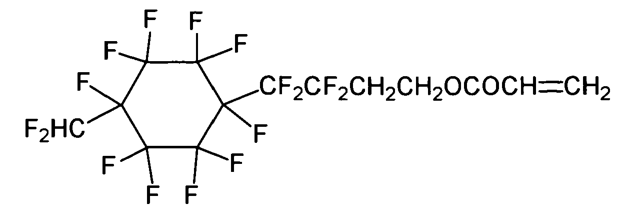

CF₃(CF₂)₇SO₂N(CH₃)CH₂CH₂OCOC(CH₃)=CH₂, CF₃(CF₂)₇SO₂N(CH₃)(CH₂)₁₀OCOCH=CH₂, C₂F₅SO₂N(C₂H₅)CH₂CH₂OCOC(CH₃)=CH₂, CF₃(CF₂)₇SO₂N(CH₃)(CH₂)₄OCOCH=CH₂, C₂F₅SO₂N(C₂H₅)C(C₂H₅)HCH₂OCOCH=CH₂, and the like.

Examples of the fluoroalkylated olefins represented by Formulae (II) and (III) include C₃F₇CH=CH₂, C₄F₉CH=CH₂, C₁₀F₂₁CH=CH₂, C₃F₇OCF=CF₂, C₇F₁₅OCF=CF₂, C₈F₁₇OCF=CF₂, and the like.

Examples of the monomers represented by Formulae (IV) and (V) include CH₂=CHCOOCH₂(CF₂)₃CH₂OCOCH=CH₂, CH₂=CHCOOCH₂CH(CH₂C₈F₁₇)OCOCH=CH₂, and the like.

It is possible to use another monomer containing no fluorine as the monomer for preparation of the fluorine-containing graft polymer, in combination with the fluorine-containing monomer above in the range that does not impair the advantageous effects of the present invention. The monomer is not particularly limited, if it is radically polymerizable, and specific examples thereof include unsaturated carboxylic acids such as (meth)acrylic acid, maleic acid, fumaric acid, and itaconic acid, the alkyl or glycidyl esters thereof, styrene, alkyl acid vinyl esters, silicon-containing monomers, and the like. The content of the monomers when used in combination is preferably 50 % by mass or less based on the fluorine-containing monomer.

### -Silicon-containing monomer -

Examples of the silicon-containing monomer for use in the graft polymer-generating process (A) include silicon-containing monomers having a SiCH₃ or O-Si-CH₃ group. A specific example thereof is silicone acrylate or methacrylate represented by the following Formula: (CH₃O)ₙSi(CH₃)₃₋ₙ-R³-O-CO-CR⁴=CH₂ (n is an integer of 0 to 3), wherein R³ represents a connecting group, and R⁴ represents methyl or hydrogen. Other favorable examples thereof include the silicon-based monomers described in JP-A No. 2003-335984, paragraph number [0025].

In the graft polymer-generating process (C) of the present invention, polymers having an oil-repellent functional group such as a fluorine- or silicon-based functional group and a radically polymerizable group (hereinafter, referred to as "radically polymerizable group-containing oil-repellent polymers") may also be used, in addition to the fluorine-containing monomers and the silicon-containing monomers above.

### -Radically polymerizable group-containing oil-repellent polymer-

The radically polymerizable group-containing oil-repellent polymer according to the present invention is a polymer having an oil-repellent functional group and a radical polymerizable ethylenic addition-polymerization unsaturated group such as vinyl, allyl, or (meth)acryl group in the molecule. The radically polymerizable group-containing oil-repellent polymer should have the radically polymerizable group on the main-chain terminal and/or on the side chain, and preferably have the radically polymerizable groups on both of them.

Such a radically polymerizable group-containing oil-repellent polymer is prepared in the following manner.
Examples of the synthetic methods include methods, by using one of the oil-repellent monomers described above such as a fluorine-containing monomer, of (a) copolymerizing the oil-repellent monomer with a monomer having an ethylenic addition-polymerization unsaturated group (b) copolymerizing the oil-repellent monomer with a monomer having a double bond precursor and then introducing a double bond by after-treatment for example with a base, and (c) allowing the functional group of an oil-repellent polymer having a functional group such as carboxylic acid with a compound having an ethylenic addition-polymerization unsaturated group. Among them, particularly favorable from the viewpoint of productivity is the method (3) of allowing the functional group of an oil-repellent polymer to react with an ethylenic addition-polymerization unsaturated group-containing monomer.

Examples of the oil-repellent monomers used for preparation of the radically polymerizable group-containing oil-repellent polymer include the fluorine- and silicone-based monomers described above, and the like.
The oil-repellent polymer used for preparation of the radically polymerizable group-containing oil-repellent polymer is, for example, an oil-repellent homopolymer or copolymer prepared by using at least one compound selected from these oil-repellent monomers.

Examples of ethylenic addition-polymerization unsaturated group-containing monomers to be copolymerized with an oil-repellent monomer in preparation of the radically polymerizable group-containing oil-repellent polymer by the method (a) include allyl group-containing monomers, and specific examples thereof include allyl (meth)acrylate and 2-allyloxyethyl methacrylate.

An example of the monomer having a double bond precursor to be copolymerized with an oil-repellent monomer in preparation of the radically polymerizable group-containing oil-repellent polymer by the method (b) is 2-(3-chloro-1-oxopropoxy)ethyl methacrylate.

Examples of the monomer containing an addition-polymerization unsaturated group used for introducing an unsaturated group in reaction of the carboxyl or amino group or the salt thereof in the oil-repellent polymer with the functional group such as hydroxyl and epoxy in preparation of the radically polymerizable group-containing oil-repellent polymer by the method (c) include (meth)acrylic acid, glycidyl (meth)acrylate, allyl glycidyl ether, 2-isocyanatoethyl (meth)acrylate, and the like.

These monomers having an oil-repellent functional group or the radically polymerizable group-containing oil-repellent polymers may be used alone or in combination of two or more kinds.

It is preferable to remove the homopolymer remaining on the base material having the graft polymer-generated region and the non-generated region thus formed, for example by immersing the base material in solvent, and thus to purify the base material. Specifically, the base material is purified by washing with water or acetone, drying, or the like. Use of a means such as ultrasonic wave irradiation is preferable, from the viewpoint of removability of the homopolymer.
After purification, the homopolymer remaining on the base material surface is removed completely, and there is only a patterned oil- and water-repellent graft polymer tightly bound to the base material.

Subsequently in the present invention microlens-forming process (A), a microlens raw material fluid is spotted on the no-graft-polymer-generated region obtained as described above, i.e., on the exposed area of the base material, and then, the microlens raw material fluid is hardened, to give a desired microlens.
The microlens raw material fluid for use in the present invention will be described first. Various materials may be used in the microlens raw material fluid, according to the desirable properties of the microlens. The fluid in the present invention is a liquid having a viscosity of 50 mPa/s (cp) or lower at normal temperature (25°C), preferably having a fluidity allowing ejection from the ink-ejecting nozzle of inkjet device.
A solution of a microlens raw material dissolved in a solvent suitable for the raw material is normally used as the microlens raw material fluid, however a dispersion of inorganic fine particle, resin fine particles, or latex may be used if it gives a homogeneous layer, for example, by heat treatment in the hardening process. Alternatively, a microlens may be formed with a fluid such as of a modified alkyl silicate by sol-gel process.

The resin used as the raw material for microlens is selected properly according to applications, for example, from resins that harden by removal of the solvent and resins prepared from a monomer/oligomer solution or dispersion containing a particular initiator that hardens and crosslinks in polymerization and crosslinking reaction caused by heat or photoirradiation.
Specific examples thereof include water-soluble UV-hardening resins such as acrylic ester resins, photohardenable resins of a relatively heat-resistant resin such as acrylic, polyimide, epoxy, or polyvinylalcohol-based resin having a photosensitive functional group or polymerizable unsaturated bond, silicon-based organic materials such as modified alkyl silicates, and the like.
Examples of the inorganic materials include SiO₂-containing amorphous inorganic materials and the like.

Additives for providing an additional function such as colorant of dye or pigment and ultraviolet absorbent and additives for control of the fluid physical properties such as surfactant, thickener, and dispersant may be added as needed to the microlens raw material fluid, according to application of the formed microlens.
Addition of colorants in microlens raw material fluids and subsequent preparation of a microlens array carrying microlenses different in color tone give a microlens array functioning as a color filter, which eliminates the need for another color filter in forming a liquid crystal panel and thus further simplifies the structure of the panel.
Alternatively, addition of a suitable dopant into the microlens raw material fluid allows control of the refractive index of the resulting microlens and provides a microlens and a microlens array with varieties of functions in a simple production process.
Such functional components may be added alone or in combination of two or more kinds to the microlens raw material fluid. In addition, multiple raw materials may be mixed previously for obtaining desired properties.

When a dispersion of solid fine particles is used as the microlens raw material fluid, the particle diameter of the fine particles is preferably in the range of 0.1 to 1,000 nm, more preferably in the range of 1 to 100 nm, from the viewpoint of dispersion and lens-forming efficiency.
The kinds and the amounts of the microlens raw material fluid and the microlens raw materials contained therein are determined properly according to the application of the resulting microlens.

The microlens raw material fluid is applied on the base material having an oil-repellent graft polymer-generated region and a non-generated region, fixed in the no-graft-polymer-generated region selectively by oil-repellency of the graft polymer-generated region and the barrier effect emerging between the graft polymer-generated region and the non-generated region, and then hardened, to give a microlens.
For example, a method of coating a microlens raw material fluid on the surface or a method of dipping the base material in the solution or dispersion of the microlens raw material fluid is used for application of the microlens raw material fluid on the surface having a graft polymer-generated region and a non-generated region of base material.
The microlens raw material fluid is applied only in the no-graft-polymer-generated region selectively, for example, by using an on/off selectable coater, inkjet device, plotter device, or the like. Among them, the method of ejecting ink through an inkjet head in inkjet device is preferable, form the point of controllability of the feeding accuracy and amount of the microlens raw material fluid in the particular region.

It is also possible to form multiple microlens arrays different in characteristics one by one on a single base material by using such an inkjet device. Namely, a first microlens raw material fluid is applied and hardened in the first particular position on the base material having multiple no-graft-polymer-generated regions in an inkjet device, forming the first microlens on the base material. Then, a second microlens raw material fluid is applied and hardened at the second particular position in an inkjet device, forming the second microlens on the base material. Repetition of such processes allows production of a microlens array having multiple microlenses different in characteristics on the same base material.

As described above, a microlens is formed by applying a raw material fluid in the no-graft-polymer-generated region microlens and hardening the microlens raw material fluid by a particular method. The processing in the hardening process is performed properly according to the properties of the fluid by a known method. For example, the solvent is removed by heating, drying or under reduced pressure when a resin solution is used, while a radiation ray having a wavelength suitable for the resin is irradiated when a photohardening ultraviolet ray-curing resin is used. A condition that does not affect the desired shape of the microlens formed from the microlens raw material fluid should be selected in any hardening process.

### <Second embodiment of the method of producing a microlens according to the present invention>

Hereinafter, the second embodiment of the method of forming a graft pattern according to the present invention will be described.
The second embodiment of the method of producing a microlens according to the present invention characteristically includes a process of bonding a compound having a polymerization-initiating site capable of initiating radical polymerization by photocleavage and a base material-bonding site to the surface of a material surface (hereinafter, suitably referred to as "photocleavable compound-bonding process (B)"), a process of forming a graft polymer-generated region and a non-generated region by applying an oil-repellent radically polymerizable compound having a functional group on the base material, performing patternwise photoirradiation, and thus, generating graft polymers by using the polymerization-initiating sites in the exposure region as initial points, (hereinafter, suitably referred to as "graft polymer-generating process (D)"), and a process of applying a microlens raw material fluid in the no-graft-polymer-generated region and hardening the microlens raw material fluid (hereinafter, suitably referred to as "microlens-forming process (B)"].

Hereinafter, the photocleavable compound-bonding process (B) and the graft polymer-generating process (D) in the method of producing a microlens in the second embodiment of the present invention will be described with reference to Figure 2.
Figure 2 is a schematic chart illustrating tje respective processes in the second embodiment of the method of producing a microlens according to the present invention.
As shown in Figure 2(a), the base material has functional groups (indicated by Z in the Figure) on the surface from the first. A compound (Q-Y) having a base material-bonding site (Q) and a polymerization-initiating site (Y) capable of initiating radical polymerization by photocleavage is then brought into contact with the base material surface. As shown in Figure 2(b), the functional group (Z) present on the base material surface and the base material-bonding site (Q) bind to each other, introducing the compound (Q-Y) on the base material surface [photocleavable compound-bonding process (B)].
Then as shown in Figure 2(c), patternwise photoirradiation is performed in the presence of a known raw graft polymer material such as monomer. As shown in Figure 2(d), a graft polymer-generated region is formed in the exposure region by generation of graft polymers from the polymerization-initiating sites (Y) of the compound (Q-Y) as initial points, while a no-graft-polymer-generated region is formed in the non-exposure region where there is no graft polymer generated [graft polymer-generating process (D)].

Hereinafter, each of the processes above will be described specifically.
The group represented by (Z) in Figure 2 is the same as the functional group (Z) present on the base material surface described in the third embodiment, and is specifically, for example, a hydroxyl, carboxyl or amino group, or the like.
The specific examples, shape, thickness, and others of the base material having the functional group (Z) are also the same as those in the third embodiment.

Hereinafter, the structure of the compound having a polymerization-initiating site capable of initiating radical polymerization by photocleavage (hereinafter, simply referred to as polymerization-initiating site) and a base material-bonding site will be described specifically. The compound (Q-Y) having a base material-bonding site (Q) and a polymerization-initiating site (Y) in the schematic chart of Figure 2 is the same as the compound (Q-Y) having a base material-bonding site (Q) and a polymerization-initiating site (Y) described in the first embodiment, and the structure and specific examples are also the same.
In the second embodiment the polymerization-initiating sites (Y) capable of generating radicals are distributed over the entire base material surface in the graft polymer-generating process (D), because the polymerization-initiating sites are not inactivated previously by patternwise photoirradiation, as in the first embodiment.

When a radical is formed by patternwise photoirradiation cleavage at the polymerization-initiating site (Y), the radical, which functions as an initial point of graft polymerization reaction, induces growth of a desired graft polymer and gives a graft polymer-generated region if there are polymerizable compounds in the area around the radical. On the other hand, there is no cleavage at the polymerization-initiating site (Y) and no growth of graft polymer in the non-exposure region and thus, there is no graft-polymer-generated region formed.

The photocleavable compound-bonding process (B) according to the present invention is a process of bonding such a compound (Q-Y) to the base material. The method and condition used in the present process are the same as those in the photocleavable compound-bonding process (A) of the first embodiment.

In the graft polymer-generating process (D) of the present invention, grafting reaction of the radically polymerizable compound having an oil- and water-repellent functional group is initiated and advanced from the radicals as initial points, by bringing a material for the desirable graft polymer, i.e., a radically polymerizable compound having an oil- and water-repellent functional group (e.g., monomer having an oil-repellent functional group monomer), into contact with the base material after processing in the photocleavable compound-bonding process (B), performing patternwise photoirradiation, and thus, generating radicals by photocleavage of the polymerization-initiating sites in the exposure region (Y). As a result, oil- and water-repellent graft polymers are generated only in the exposure region.
In the second embodiment of the method of producing a microlens, the compound (Q-Y) having a polymerization-initiating site (Y) not photocleaved remains in the no-graft-polymer-generated region according to the present invention.

A method similar to that in the first embodiment may be used for bringing the oil-repellent radically polymerizable compound having a functional group into contact with the base material surface. The oil-repellent radically polymerizable compound having a functional group used in the present process is also similar to the described in the first embodiment.

The method of patternwise photoirradiation for use in the graft polymer-generating process (D) of the present invention is not particularly limited, if it can cleave the polymerization-initiating site (Y) of photocleavable compound photochemically, and the light used is similar to the light used in the first embodiment and, for example, an ultraviolet or visible ray.
Because the distance between lenses is preferably smaller also in the present process when the method of the present invention is applied to production of a microlens array, high-resolution patternwise photoirradiation is preferable, and use of scanning beam irradiation by using a particular optical system, masked irradiation, or stepper exposure, for example, by using an i-ray, KrF, or ArF stepper is preferable, similarly to the first embodiment.

Subsequently, the base material is further processed in the present invention microlens-forming process (B).
In the present process, a microlens is formed on the base material having an oil-repellent graft polymer-generated region and a non-generated region prepared in the graft polymer-generating process (D) by a method similar to that in the first embodiment.
In the second embodiment, there is the unphotocleaved compound (Q-Y) remaining in the no-graft-polymer-generated region, and the base material is not exposed, differently from the first embodiment; but it is also possible to form pixels in the second embodiment by a method similar to that in the first embodiment, because of the oil repellency of the graft polymer-generated region and the barrier effect emerging between the graft polymer-generated region and the non-generated region on the base substrate.

### (Application of the method of producing a microlens)

The method of producing a microlens according to the present invention demands no complicated process or expensive apparatuses and allows easy production of a uniform, fine microlens, as described above. Accordingly, it allows production of a high-resolution microlens that is applicable to circuits and elements demanding a fine microlens array.
The method of producing a microlens according to the present invention also allows production of a microlens array having various functions by proper selection of the functional components used in the microlens raw material fluid, and thus gives a microlens possibly having a wider use.
In addition, it is possible to produce a microlens array favorable for used in liquid crystal display by using a transparent film such as of PET as the base material and also to produce a microlens array functioning as a color filter by forming the microlens with multiple colorants, and thus, the method according to the present invention gives a microlens applicable in wider fields.

Hereinafter, the present invention will be described specifically with reference to Examples, however the present invention is not limited thereto.

### (Preparative Example 1: Preparation of compound A)

The exemplary compound 6 was prepared in the following two processes. The respective processes will be described below with reference to its schemes.

### 1. Process 1 (Preparation of compound a)

24.5 g (0.12 mol) of 1-hydroxycyclohexylphenylketone was dissolved in a mixed solvent including 50 g of DMAc and 50 g of THF, and 7.2 g (0.18 mol) of NaH (60 % by mass in oil) was added gradually while the mixture was cooled in an ice bath. 44.2 g (0,18 mol) of 11-bromo-1-undecene (95 % by mass) was added dropwise thereto, and the mixture was allowed to react at room temperature. The reaction was completed in one hour. The reaction solution was poured into ice water, and the product was extracted with ethyl acetate, to give a mixture containing a yellow liquid compound 2a. The mixture 37 g was dissolved in 370 ml of acetonitrile, and 7.4 g of water was added thereto. 1.85 g of p-toluenesulfonic acid monohydrate was added, and the mixture was stirred at room temperature for 20 minutes. The organic phase was extracted with ethyl acetate, and the solvent was removed by distillation. The compound a was isolated by column chromatography (filler: Wako Gel C-200, elution solvent: ethyl acetate/hexane=1/80).
The synthetic scheme is shown below.

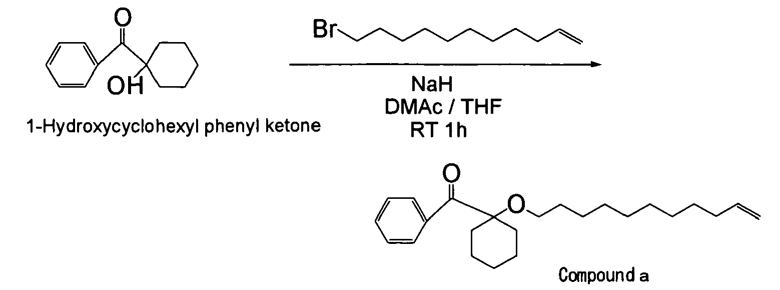

1H NMR (300 MHz, CCl₃)
δ: 1.2-1.8 (mb, 24H), 2.0 (q, 2H), 3.2 (t, J=6.6, 2H), 4.9-5.0 (m, 2H), 5.8 (ddt, J=24,4, J=10.5, J=6.6, 1H), 7.4 (t, J=7.4, 2H), 7.5 (t, J=7.4, 1H), and 8,3 (d, 1H)

### 2. Process 2 (Preparation of compound A by hydrosilylation of compound a)

Two drops of Speier catalyst (H₂ PtCl₆·6H₂ O/2-PrOH, 0.1 mol/1) were added to 5.0 g (0.014 mol) of the compound a; 2.8 g (0.021 mol) oftrichlorosilane was added thereto dropwise; and the mixture was stirred in an ice bath. 1.6 g (0.012 mol) of trichlorosilane was added dropwise additionally after 1 hour, and the mixture was allow to warm to room temperature. The reaction was completed in 3 hours. After reaction, the unreacted trichlorosilane was removed under reduced pressure, to give a compound A.
The synthetic scheme is shown below.

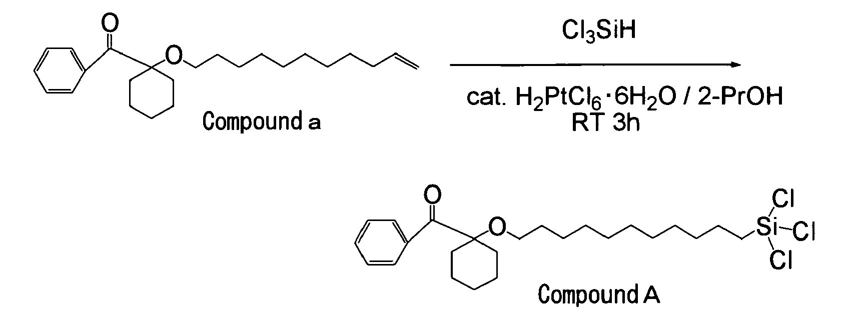

1H NMR (300 MHz, CDCl₃)
δ: 1.2-1,8 (m, 30H), 3,2 (t, J=6,3, 2H), 7,3-7,7 (m, 3H), and 8,3 (d, 2H)

### Example 1

### (Photocleavable compound-bonding process)

A glass substrate (manufactured by Nippon Sheet Glass Co., Ltd.) was immersed in piranha solution (1/1 vol. mixed solution of sulfuric acid and 30% hydrogen peroxide) overnight and then washed with pure water. The substrate was placed in a nitrogen-substituted separable flask and immersed in a dehydrated toluene solution containing 12.5 % by mass of compound A for 1 hour. After removal, the substrate was washed with toluene, acetone, and pure water in this order. The substrate obtained is designated as substrate A1.

### (Oil- and water-repellent graft polymer-generating process)

0.5 g of 2-(perfluorooctyl)ethyl methacrylate (manufactured by Abmax Co.) as a fluorine-containing monomer and 0.5 g of 1-methoxy-2-propanol (manufactured by Wako Pure Chemical Industries, Ltd.) were mixed, to give a homogeneous solution.
Approximately 0.5 ml of the solution above was applied dropwise on the substrate A1 thus obtained, and a quartz plate was placed thereon, forming a liquid film as uniform as possible. A pattern mask (NC-1, manufactured by Toppan Printing Co., Ltd.) was attached thereto, and the liquid film was irradiated in an exposure machine (UVE202S, manufactured by Sanei Denki Seisakusho K.K.) with a light having a wavelength of 254 nm at an irradiation intensity of 10 mW/cm² for 60 seconds. After irradiation, the quartz plate was removed, and the fluorine-based graft pattern obtained was washed with acetone, removing impurities such as the unreacted fluorine-containing monomer, to give a fluorine compound-patterned silicon substrate.

The water-droplet contact angle in the exposure region (fluorine-graft-patterned region), as measured for confirmation of the water repellency of the pattern, was 115 degrees, indicating high water-repellency.
When a magic ink (Mackee Care, black, manufactured by Zebra Co., Ltd.) is applied for confirmation of the oil repellency of the pattern, the ink deposited only in the region other than the fluorine graft polymer-formed region, indicating that the pattern-forming region was highly oil- and water-repellent.
Microscopic observation revealed a pattern with a line width of 5 µm and a spacing of 5 µm. The height of the graft pattern, as determined by using Nanopics 1000 (manufactured by Seiko Instruments Inc.), was 10 nm.
The surface fluorine atom content as determined by ESCA was 52 % by atom (other surface atom contents: C: 42% and O: 6%), indicating presence of a fluorine polymer. (for reference: monomeric fluorine content: 52 % by atom, other atom contents: C: 42% and O: 6%)
A pattern A1 (having a graft polymer-generated region and a non-generated region) was prepared in this manner.

### Example 2

### (Photocleavable compound-bonding process)

A substrate A1 having the photocleavable compounds on the entire surface was prepared in a similar manner to Example 1.

### (Polymerization initiating potential-inactivating process)

The pattern mask used in Example 1 (NC-1, manufactured by Toppan Printing Co., Ltd.) was attached onto the substrate A1 thus obtained, and the substrate was exposed to a light having a wavelength of 254 nm at an irradiation intensity of 10 mW/cm² for 60 seconds in an exposure machine (UVE202S, manufactured by Sanei Denki Seisakusho K.K.), to give a substrate B 1 having photocleavage potential only in the unexposed region.

### (Graft polymer-generating process)

0.5 g of 2-(perfluorobutyl)ethyl acrylate (manufactured by Abmax Co.) as a fluorine-containing monomer and 0.5 g of 1-methoxy-2-propanol (manufactured by Wako Pure Chemical Industries, Ltd.) were mixed, to give a homogeneous solution. Approximately 0.5 ml of the solution above was applied dropwise on the substrate B 1 thus obtained, and a quartz plate was placed thereon, to form a liquid film as uniform as possible. The entire-surface of the liquid film was then exposed to light in the exposure machine above for 60 seconds.

The water-droplet contact angle in the exposure region (fluorine-graft-patterned region), as measured for confirmation of the water repellency of the pattern, was 110 degrees, indicating high water-repellency.
When a magic ink (Mackee Care, black, manufactured by Zebra Co., Ltd.) is applied for confirmation of the oil repellency of the pattern, the ink deposited only in the region other than the fluorine graft polymer-formed region, indicating that the pattern-formed region was highly oil- and water-repellent.
Microscopic observation revealed a pattern with a line width of 5 µm and a spacing of 5 µm. The height of the graft pattern, as determined by using Nanopics 1000 (manufactured by Seiko Instruments Inc.), was 10 nm.
The surface fluorine atom content as determined by ESCA was 40 % by atom (other surface atom contents: C: 48% and O: 12%), indicating presence of a fluorine polymer. (for reference: monomeric fluorine content: 45 % by atom, other atom contents: C: 45% and O: 10%).
A pattern B 1 (having a graft polymer-generated region and a non-generated region) was prepared in this manner.

### Example 3

### (Lithography method)

Each of the fluorine-graft-patterned silicon substrates obtained in Examples 1 and 2 was immersed in an etchant of 1.5 % by mass hydrofluoric acid. Naturally oxidized film (SiO₂) formed on the silicon surface had a thickness of 2 nm, and the immersion period was 30 seconds when the etching speed was 5 nm/min. It functioned sufficiently as a linographic resist film, because it demands 10 minutes or more for the fluorine molecule film being damaged by the etchant and the substrate exposed.
Observation of the remaining resist surface under an optical microscope showed no change between before and after the etching process or no cavity thereon.
The etching resulted in removal of the naturally oxidized film (SiO₂) on the silicon surface in a pattern of a width of 5 µm and a pitch of 5 µm.
The resistance of the pattern A1 of Example 1 to the 1.5 % by mass hydrofluoric acid etchant used in Example was 15 minutes, while the resistance of the pattern B 1 of Example 2 was 12 minutes.

### Comparative Example 1

A monomolecular film of heptadecafluoro-1,1,2,2-tetrahydrodecyl trimethoxysilane was formed on a silicon substrate according to the method described in Example 1 of JP-A No. 2000-282240 (Patent Document 2) shown below.
The film was photoirradiated with the exposure machine used in Example 1 for 45 minutes, but no distinct oil- and water-repellent pattern was obtained. The contact angle in the unexposed region was 115 degrees, indicating superior water repellency. The surface fluorine atom content, as determined by ESCA, was 53%. The height of the graft pattern was 5 nm or less and could not be measured in a similar manner to Example 1 by using Nanopics 1000 (manufactured by Seiko Instruments Inc.).

### Comparative Example 2

A monomolecular film of heptadecafluoro-1,1,2,2-tetrahydrodecyl trimethoxysilane was formed on the silicon substrate as in Comparative Example 1, and a pattern is formed thereon according to the method described in Example 1 of the Patent Document 2. Specifically, the silicon substrate carrying a fluorine alkylsilane monomolecular film formed was exposed through a mask pattern to UV light at a wavelength of 172 nm. The exposure intensity was 10 mW/cm², and the exposure period was 10 minutes. UV irradiation resulted in cleavage of the C-C bond and decomposition of the silane monomolecular film, giving a pattern C 1.
The pattern C 1 was used as an etching stopper, similarly to Example 3. It functioned as a resist for up to an immersion period of 30 seconds, however observation of the remaining resist surface under an optical microscope showed spotty cavities on the resist film; prolongation of the immersion period to 45 seconds resulted in significant damage of the film by the etchant and the film did not function as a resist, because the monomolecular film, i.e., fluorine film, is thinner. The resistance of the pattern of Comparative Example 1 to the 1.5 % by mass hydrofluoric acid etchant used in Examples was one minute, indicating that the etching resistance is lower.

### Example 4

### (Preparation of substrate)

125 g of a mixture of dipentaerythritol pentaacrylate and dipentaerythritol hexaacrylate (DPHA, manufactured by Nippon Kayaku Co., Ltd.) and 125 g of a urethane acrylate oligomer (UV-6300B, manufactured by Nippon Synthetic Chemical Industry Co., Ltd.) were dissolved in 439 g of industrial denatured ethanol. A solution containing 7.5 g of a photopolymerization initiator (Irgacure 907, manufactured by Ciba-Geigy Corp.) and 5.0 g of a photosensitizer (Kayacure DETX, manufactured by Nippon Kayaku Co., Ltd.) dissolved in 49 g of methylethylketone was added to the solution obtained. The mixture was stirred and then, filtered through a polypropylene filter having a pore size of 1 µm, to give a substrate-coating solution.

A triacetylcellulose film having a thickness of 80 µm (TAC-TD80U, manufactured by Fuji Photo Film Co.) was used as the base material, and a gelatin undercoat layer was formed on the surface. The intermediate layer-coating solution above was coated on the gelatin undercoat layer with a bar coater, dried at 120°C, and irradiated with a light from a high-pressure mercury lamp for 30 seconds for hardening, to give a hardened substrate having a thickness of 15 µm. The high-pressure mercury lamp used was UVX-02516S1LP01 manufactured by Ushio Inc.

### (Formation of fluorine-containing polymer pattern)

0.5 g of a fluorine-containing monomer 2-(perfluorobutyl)ethyl acrylate (manufactured by Abmax Co.) and 0.5 g of 1-methoxy-2-propanol (manufactured by Wako Pure Chemical Industries, Ltd.) were mixed as the radically polymerizable compounds having an oil- and water-repellent functional group, to give a homogeneous solution.
The hardened base material obtained above was cut into pieces of 4 cmx5 cm in size, and approximately 0.5 ml of the solution was applied dropwise on each of it, and a quartz plate was placed thereon, to form a liquid film as uniform as possible. The liquid film was exposed to light through a mask pattern (NC-1, manufactured by Toppan Printing Co., Ltd.) in a UV exposure device (UVX-02516S1LP01, high-pressure mercury lamp, manufactured by Ushio Inc.) for 5 minutes. The mask and the quartz plate were separated after photoirradiation, and the fluorine-based graft film obtained was washed with acetone, removing impurities such as unreacted fluorine-containing monomer, to give a fluorine graft pattern.

The water-droplet contact angle in the fluorine graft region determined was 107.8 degrees, indicating superior water repellency. The contact angle of the region other than the graft region was 80.3 degrees.
When a magic ink (Mackee Care, black, manufactured by Zebra Co., Ltd.) is applied for confirmation of the oil repellency of the pattern, the ink deposited only in the region other than the fluorine graft polymer-formed region, indicating that the pattern-formed region was highly oil- and water-repellent.
Microscopic observation revealed a pattern with a line width of 10 µm and a spacing of 10 µm.

### Example 5

A test on the method of forming a graft pattern having the fluorine graft polymer generated in the patterned form was performed in a similar manner to Example 4, except that 7.5 g of the photopolymerization initiator (Irgacure 907, manufactured by Ciba-Geigy Corp.) and 5.0 g of photosensitizer (Kayacure DETX, manufactured by Nippon Kayaku Co., Ltd.) used as photoradical generators in Example 4 were replaced with 12.5 g of the polymeric radical generator described in JP-A No. 9-77891, paragraph number [0076].
The water-droplet contact angle in the fluorine graft region determined was 110 degrees. The contact angle in the region other than the graft region was 76 degrees.
When a magic ink (Mackee Care, black, manufactured by Zebra Co., Ltd.) is applied for confirmation of the oil repellency of the pattern, the ink deposited only in the region other than the fluorine graft polymer-formed region, indicating that the pattern-formed region was highly oil- and water-repellent.
Microscopic observation revealed a pattern with a line width of 10 µm and a spacing of 10 µm.

### Example 6

### (Preparation of polymerization-initiation polymer A)

30 g of propylene glycol monomethylether (MFG) was placed in a 300 ml three-necked flask and heated to 75°C. A solution containing 8.1 g of [2-(acryloyloxy)ethyl](4-benzoylbenzyl)dimethylammonium bromide, 9.9 g of 2-hydroxyethyl methacrylate, 13.5 g of isopropyl methacrylate, 0.43 g of dimethyl-2,2'-azobis(2-methyl propionate), and 30 g of MFG was added thereto dropwise over 2.5 hours. Then, the reaction temperature was raised to 80°C and allowed to react additionally for 2 hours, to give a polymer A having a polymerization-initiating group.

### (Polymerization-initiation layer-forming process)

A polyethylene terephthalate film having a thickness of 0.188 mm (product name: M4100, manufactured by Toyobo Co., Ltd.) was used as the substrate, and the following polymerization-initiation layer coating solution 1 was coated on the surface with a rod bar No. 18, and dried and crosslinked at 110°C for 10 minutes. The thickness of the polymerization-initiation layer was 9.3 µm.

### <Polymerization-initiation layer coating solution 1>

- Particular polymerization-initiation polymer A 0.4 g
- TDI (tolylene-2,4-diisocyanate) 0.16 g
- Propylene glycol monomethylether (MFG) 1.6 g

the polymerization-initiation layer obtained was grafted with a fluorine compound in a similar manner to Example 1. Specifically, 0.5 g of a fluorine-containing monomer 2-(perfluorooctyl)ethyl methacrylate (manufactured by Abmax Co., Ltd.) and 0.5 g of 1-methoxy-2-propanol (manufactured by Wako Pure Chemical Industries, Ltd.) were mixed, to give a homogeneous solution.
Approximately 0.5 ml of the solution above was applied dropwise on the substrate having the polymerization-initiation layer thus obtained, and a quartz plate was placed thereon, to form a liquid film as uniform as possible. A pattern mask (NC-1, manufactured by Toppan Printing Co., Ltd.) was attached thereto, and the liquid film was irradiated in an exposure machine (UVE202S, manufactured by Sanei Denki Seisakusho K.K.) with a light having a wavelength of 254 nm at an irradiation intensity of 10 mW/cm² for 60 seconds. After irradiation, the quartz plate was removed, the fluorine-based graft pattern obtained was washed with acetone, removing impurities such as the unreacted fluorine-containing monomer, to give a fluorine compound-patterned silicon substrate.
The water-droplet contact angle in the fluorine-grafted region determined then was 115 degrees, indicating superior water repellency. The contact angle of the region other than the graft region was 83 degrees.
When a magic ink (Mackee Care, black, manufactured by Zebra Co., Ltd.) is applied for confirmation of the oil repellency of the pattern, the ink deposited only in the region other than the fluorine graft polymer-formed region, indicating that the pattern-formed region was highly oil- and water-repellent.
Microscopic observation revealed a pattern with a line width of 15 µm and a spacing of 15 µm. Example 7

The following epoxy resin was used as the substrate.
First, 20 parts by weight of a bisphenol-A epoxy resin (epoxy equivalence: 185, manufactured by Japan Epoxy Resin Co., Ltd., Epikote 828) (hereinafter, all blending amounts are expressed by parts by weight), 45 parts of a cresol novolak epoxy resin (epoxy equivalence: 215, manufactured by Dainippon Ink and Chemicals, Inc., Epichlone N-673), and 30 parts of a phenolic novolak resin (phenolic hydroxyl group equivalence; 105, manufactured by Dainippon Ink and Chemicals, Inc., Phenolite) were dissolved in 20 parts of ethyl diglycol acetate and 20 parts of solvent naphtha while the mixture is stirred under heat, and then cooled to room temperature; 30 parts of a cyclohexanone varnish containing a phenoxy resin of a bisphenol-A epoxy resin (Epikote 828) and bisphenol S (YL6747H30, manufactured by Japan Epoxy Resin Co., Ltd., nonvolatile content: 30 % by mass, weight-average molecular weight: 47,000), 0.8 part of 2-phenyl-4,5-bis(hydroxymethyl)imidazole, 2 parts of finely pulverized silica, and 0.5 part of a silicon-based antifoam were added thereto, to give an epoxy resin varnish. The varnish was coated on a SUS substrate with a doctor blade, and heated and dried at 100°C for 10 minutes and then at 200°C for 5 minutes, to give a hardened epoxy substrate having a thickness of 200 µm.

The fluorine-containing monomer was grafted by using materials similar to those in Example 1 and the polymerization-initiation layer obtained. Specifically, 0.5 g of a fluorine-containing monomer 2-(perfluorooctyl)ethyl methacrylate (manufactured by Abmax Co., Ltd.), 0.5 g of 1-methoxy-2-propanol (manufactured by Wako Pure Chemical Industries, Ltd.), and 0.01 g of a hydrogen-abstraction photoinitiator were mixed, and the mixture was stirred into a homogeneous solution.
Approximately 0.5 ml of the solution was applied dropwise on the substrate obtained above, and a quartz plate was placed thereon, to form a liquid film as uniform as possible. A pattern mask (NC-1, manufactured by Toppan Printing Co., Ltd.) was attached thereto, and the liquid film was irradiated in an exposure machine (UVE202S, manufactured by Sanei Denki Seisakusho K.K.) with a light having a wavelength of 254 nm at an irradiation intensity of 10 mW/cm² for 60 seconds. After photoirradiation, the quartz plate was removed, and the fluorine-based graft pattern obtained was washed with acetone, removing impurities such as unreacted fluorine-containing monomer, to give a substrate fluorine-grafted in a patterned form.

The water-droplet contact angle in the fluorine-grafted region determined then was 113 degrees, indicating superior water repellency. The contact angle of the region other than the graft region was 80 degrees.
When a magic ink (Mackee Care, black, manufactured by Zebra Co., Ltd.) is applied for confirmation of the oil repellency of the pattern, the ink deposited only in the region other than the fluorine graft polymer-formed region, indicating that the pattern-formed region was highly oil- and water-repellent.
Microscopic observation revealed a pattern with a line width of 10 µm and a spacing of 10 µm.

### Example 8

### [Photocleavable compound-bonding process (B)]

A silicon substrate (manufactured by SUMCO) was immersed in piranha solution (1/1 vol. mixed solution of sulfuric acid and 30% hydrogen peroxide) overnight and then washed with pure water. The substrate was immersed in a dehydrated toluene solution containing 12.5 % by mass of compound A in a nitrogen-substituted separable flask for 1 hour. After removal, the substrate was washed with toluene, acetone, and pure water in this order.
The base plate obtained is designated as substrate A1.

### [Graft polymer-generating process (D)]

0.5 g of a fluorine-containing monomer 2-(perfluorooctyl)ethyl methacrylate (manufactured by Abmax Co., Ltd.) and 0.5 g of 1-methoxy-2-propanol (manufactured by Wako Pure Chemical Industries, Ltd.) were mixed, to give a homogeneous solution.
Approximately 0.5 ml of the solution was applied dropwise on the base material A1 obtained above and a quartz plate was placed thereon, to form a liquid film as uniform as possible. A pattern mask (NC-1, manufactured by Toppan Printing Co., Ltd.) was attached thereto, and the liquid film was irradiated in an exposure machine (UVE202S, manufactured by Sanei Denki Seisakusho K.K.) with a light having a wavelength of 254 nm at an irradiation intensity of 10 mW/cm² for 60 seconds. The quartz plate was separated after photoirradiation, and the fluorine-based graft polymer obtained was washed with acetone, for removal of impurities such as unreacted fluorine-containing monomer, to give a fluorine-based base material having a graft polymer-generated region and a non-generated region A2.

The water-droplet contact angle in the fluorine-based graft polymer-generated region of the base material A2, as determined for confirmation of water repellency, was 115 degrees, indicating superior water repellency.
When a magic ink (Mackee Care, black, manufactured by Zebra Co., Ltd.) is applied for confirmation of the oil repellency of the pattern, the ink deposited not in the fluorine-based graft polymer-generated region but only in the region other than the fluorine graft polymer-formed region selectively.
The surface fluorine atom content of the fluorine-based graft polymer, as determined by ESCA, was 52 % by atom (other surface atom contents: C: 42% and O: 6%), indicating high oil- and water-repellency. (for reference: surface fluorine atom content of the fluorine-containing monomer: 52 % by atom, other surface atom contents: C: 42% and O: 6%)
The film thickness in the graft polymer-generated region, as determined by using Nanopics 1000 (manufactured by Seiko Instruments Inc.) was 10 nm.

### [Raw conductive material-depositing process]

A fine-particle dispersion of gold fine particles having a particle diameter of 10 nm in α-terpineol (trade name: "Perfect Gold", manufactured by Ulvac Materials, Inc.) was coated on the face carrying the fluorine-based graft polymer-generated region and the non-generated region of the base material A2 by spin coating. The coated fine particle dispersion was selectively fixed only in the no-fluorine-based-graft-polymer-generated region but not in the fluorine-based graft polymer-generated region.
Calcination (heat treatment) in air of the base material A2 at 300°C for 15 minutes converted the fine particle dispersion coated in the region carrying no fluorine-based graft-polymer into a gold thin film having a line pattern of a width of 5 µm and a spacing of 5 µm, i.e., in the pattern of a fluorine-based graft polymer-generated region and a non-generated region described above. The thickness of the gold thin film was 1.5 µm, and the resistivity, 5×10⁻⁶ Ω·cm.

### Example 9

### [Photocleavable compound-bonding process (A)]

A base material A1 having a photocleavable compound bound to the entire surface was prepared in a similar manner to Example 8.

### [Polymerization initiating potential-inactivating process]

The base material A1 thus obtained was exposed to a light having a wavelength of 254 nm at an irradiation intensity of 10 mW/cm² for 60 seconds through the pattern mask used in Example 8 (NC-1, manufactured by Toppan Printing Co., Ltd.) in an exposure machine (UVE202S, manufactured by Sanei Denki Seisakusho K.K.). The operation gave a base material B1 having a polymerization initiation-allowing region (unexposed region) and a polymerization-initiating-potential-inactivated region (exposed region).

### [Graft polymer-generating process (c)]

0.5 g of a fluorine-containing monomer 2-(perfluorooctyl)ethyl methacrylate (manufactured by Abmax Co., Ltd.) and 0.5 g of 1-methoxy-2-propanol (manufactured by Wako Pure Chemical Industries, Ltd.) were mixed, to give a homogeneous solution.
Approximately 0.5 ml of the solution was applied dropwise on the base material B1 obtained above, and a quartz plate was placed thereon, to form a liquid film as uniform as possible. The liquid film was then photoirradiated on the entire surface in the exposure machine used in the polymerization initiating potential-inactivating process for 60 seconds, allowing graft polymerization reaction to proceed. The quartz plate was separated after photoirradiation, and the fluorine-based graft polymer obtained was washed with acetone for removal of impurities such as unreacted fluorine-containing monomer, to give a fluorine-based base material having a graft polymer-generated region and a non-generated region B2.

The water-droplet contact angle in the fluorine-based graft polymer-generated region of the base material B2, as determined for confirmation of water repellency, was 110 degrees, indicating superior water repellency.
When a magic ink (Mackee Care, black, manufactured by Zebra Co., Ltd.) is applied for confirmation of the oil repellency of the pattern, the ink deposited not in the fluorine-based graft polymer-generated region but only in the region other than the fluorine graft polymer-formed region selectively.
The surface fluorine atom content of the fluorine-based graft polymer, as determined by ESCA, was 40 % by atom (other surface atom contents: C: 48% and O: 12%), indicating high oil- and water-repellency. (for reference: surface fluorine atom content of the fluorine-containing monomer: 45 % by atom, other surface atom contents: C: 45% and O: 10%)
The film thickness in the graft polymer-generated region, as determined by using Nanopics 1000 (manufactured by Seiko Instruments Inc.) was 10 nm.

### [Raw conductive material-depositing process]

20 mg of palladium chloride was dissolved as an activator in 100 ml of 4 % by mass hydrochloric acid, and the liquid was adjusted to pH 5 by addition of sodium hydroxide. The liquid was ejected through an inkjet head (inkjet head, manufactured by Seiko Epson Corporation) onto the no-fluorine-based-graft-polymer-generated region of base material B2. The inkjet head ejected an ink droplet of 25 picoliter in volume and 36 µm in diameter at a driving voltage of 20 V The ejection distance was 30 µm.
The ejected activator spread to the line width (15 µm) but stayed in the no-fluorine-based-graft-polymer-generated region, giving lines of the activator having a line width of 15 µm and a spacing of 15 µm. The base material B2 was left as it was for 5 minutes at room temperature and then washed with water.
The base material B2 was then plated as immersed in an electroless nickel plating solution (solution containing 25 g of nickel chloride and 25 g of sodium hypophosphite in 1 liter of water that is adjusted to a pH of approximately 5 by addition of a pH adjuster) at 80°C for 10 minutes, causing precipitation of nickel by electroless plating only in the hydrophilic region and thus, giving a nickel thin film in a line pattern having a width of 15 µm and a spacing of 1 µm, i.e., in the pattern of a fluorine-based graft polymer-generated region and a non-generated region. The thickness of the nickel thin film was 3 µm, and the specific resistance thereof was 1.0 Ωcm.

### Example 10

### [Raw conductive material-depositing process]

A base material A2 was prepared in processes similar to the photocleavable compound-bonding process (B) and graft polymer-generating process (D) in Example 8.
A solution of polyethyleneoxythiophene (Baytron P, aqueous conductive polymer manufactured by Bayer AG) was ejected onto the no-fluorine-based-graft-polymer-generated region of base material A2 by using the inkjet head of Example 9. Then after the liquid was dried, a conductive polymer layer in a line pattern having a width of 5 µm and a spacing of 5 µm, i.e., in the pattern of a fluorine-based graft polymer-generated region and a non-generated region was formed in the no-fluorine-based-graft-polymer-generated region. The thickness of the conductive polymer layer was 2 µm.
Subsequent measurement of the conductivity of the conductive polymer with a tester under microscope showed that the conductivity at any position was 1 Ω or less.
Microscope observation revealed that there was no spread of polyethyleneoxythiophene in the fluorine-based graft polymer-generated region and thus, no barrier effect emerging between the fluorine-based graft polymer-generated region and the non-generated region. Subsequent measurement of the conductivity of the fluorine-based graft polymer-generated region, similarly to the non-generated region, with a tester showed no conductivity therein, indicating that the region was present as an insulative region.

### Example 11

### [Preparation of base material]

125 g of a mixture of dipentaerythritol pentaacrylate and dipentaerythritol hexaacrylate (DPHA, manufactured by Nippon Kayaku Co., Ltd.) and 125 g of a urethane acrylate oligomer (UV-6300B, manufactured by Nippon Synthetic Chemical Industry Co., Ltd.) were dissolved in 439 g of industrial denatured ethanol. A solution containing 7.5 g of a low-molecular weight radical generator (photopolymerization initiator Irgacure 907, manufactured by Ciba-Geigy Corp.), 5.0 g of a photosensitizer (Kayacure DETIX, manufactured by Nippon Kayaku Co., Ltd.), and 49 g of methylethylketone was added to the solution obtained. After agitation, the mixture was filtered through a polypropylene filter having a pore size of 1 µm, to give a coating solution for radical generator-containing layer.

A triacetylcellulose film having a thickness of 80 µm (TAC-TD80U, manufactured by Fuji Photo Film Co.) was used as the substrate, and a gelatin undercoat layer was formed on the surface. The radical generator-containing layer-coating solution was applied on the gelatin undercoat layer with a bar coater, dried at 120°C, and exposed to a light from a high-pressure mercury lamp for 30 seconds allowing hardening of the coated film, to give a base material having a thickness of 15 µm. The high-pressure mercury lamp used was UVX-02516S1LP01 manufactured by Ushio Inc. The base material obtained is designated as base material C1.

### [Graft polymer-generating process (A)]

0.5 g of a fluorine-containing monomer 2-(perfluorobutyl)ethyl acrylate (manufactured by Abmax Co.) and 0.5 g of 1-methoxy-2-propanol (manufactured by Wako Pure Chemical Industries, Ltd.) were dissolved into a homogeneous solution.
The base material obtained above was cut into pieces of 4 cmx5 cm in size, and approximately 0.5 ml of the solution was applied dropwise on each of it, and a quartz plate was placed thereon, to form a liquid film as uniform as possible. The liquid film was exposed to light through a mask pattern (NC-5, manufactured by Toppan Printing Co., Ltd.) in a UV exposure device (UVX-02516S1LP01, high-pressure mercury lamp, manufactured by Ushio Inc.) for 5 minutes. The mask and the quartz plate were separated after photoirradiation, and the fluorine-based graft polymer obtained was washed with acetone, removing impurities such as unreacted fluorine-containing monomer, to give a fluorine-based base material C2 having a graft polymer-generated region and a non-generated region.

The water-droplet contact angle in the fluorine-based graft polymer-generated region on the base material C2, as determined for confirmation of water repellency, was 107.8 degrees, indicating superior water repellency.
When a magic ink (Mackee Care, black, manufactured by Zebra Co., Ltd.) is applied for confirmation of the oil repellency of the pattern, the ink deposited not in the fluorine-based graft polymer-generated region but only in the region other than the fluorine graft polymer-formed region selectively.
The surface fluorine atom content of the fluorine-based graft polymer of the base material C2, as determined by ESCA, was 51 % by atom (other surface atom contents: C: 43% and O: 6%), indicating high oil- and water-repellency. (for reference: fluorine content of monomer: 52 % by atom, other atom amounts: C: 42% and O: 6%).
The film thickness in the graft polymer-generated region, as determined by using Nanopics 1000 (manufacture by Seiko Instruments Inc.), was 15 nm.

### [Raw conductive material-applying process]

### (Preparation of dispersion)

A commercially available silver particle dispersion (trade name: independent-dispersion ultrafine particles Perfect Silver, manufactured by Ulvac Materials, Inc.), specifically, a silver particle dispersion (liquid viscosity at 25°C: 30 mPa·s) containing 15 parts by weight of dodecylamine (molecular weight 185.36, boiling point 248°C) as the alkylamine for use in the surface coating layer and 75 parts by weight of terpineol as the organic solvent for used as the dispersion solvent based on 100 parts by weight of silver particles having an average diameter of 5 nm, was concentrated, partially removing excessive amounts of the organic solvent and the coating agent dissolved therein. The concentration processing leads to increase in liquid viscosity and gave a pasty dispersion containing silver particles having the surface coating layer. The liquid viscosity of the dispersion prepared was 80 Pa·s (25°C).

Subsequently, the dispersion was applied on the face of the base material C2 having a fluorine-based graft polymer-generated region and a non-generated region by screen printing to an average film thickness of 10 µm during coating by using a #500-mesh stainless steel screen plate, to form a coated film.
Then, the coated film was heat-treated at 250°C for 40 minutes, allowing sintering of the silver particles contained therein, to form a conductive pattern of sintered silver layer.
The conductive pattern obtained has a silver line pattern having a width of 25 µm and a spacing of 25 µm formed in the pattern of a fluorine-based graft polymer-generated region and a non-generated region.
The average thickness of the sintered body layer was 5 µm, and the resistivity (volume resistivity) was favorable at 3.5×10⁻⁶ Ω·cm.

### Example 12

A base material was prepared in a similar manner to Example 11, except that
7.5 g of photopolymerization initiator (Irgacure 907, manufactured by Ciba-Geigy Corp.) and 5.0 g of the photosensitizer (Kayacure DETX, manufactured by Nippon Kayaku Co., Ltd.) used as the low-molecular weight radical generator in preparation of the base material in Example 11 were replaced with 12.5 g of the polymeric radical generator described in JP-A No. 9-77391, paragraph number (0076). The base material obtained is designated as base material D 1.

### [Graft polymer-generating process (A)]

A fluorine-based graft polymer was formed in a patterned form on the base material D1 thus obtained according to a method similar to that in Example 11, to give a base material D2 having a fluorine-based graft polymer-generated region and a non-generated region formed.

The water-droplet contact angle in the fluorine-based graft polymer-generated region of the base material D2, as determined for confirmation of water repellency, was 110 degrees, indicating superior water repellency.
When a magic ink (Mackee Care, black, manufactured by Zebra Co., Ltd.) is applied for confirmation of the oil repellency of the pattern, the ink deposited not in the fluorine-based graft polymer-generated region but only in the region other than the fluorine graft polymer-formed region selectively.
The surface fluorine atom content of the fluorine-based graft polymer on the base material D2, as determined by ESCA, was 50 % by atom (other surface atom contents: C: 44% and 0:6%), indicating high oil- and water-repellency. (for reference: fluorine content of monomer: 52 % by atom, other atom amounts: C: 42% and O: 6%)
The film thickness in the graft polymer-generated region, as determined by using Nanopics 1000 (manufactured by Seiko Instruments Inc.) was 20 nm.

### [Raw conductive material-applying process]

### (Preparation of dispersion)

A commercially available silver particle dispersion (trade name: independent-dispersion ultrafine particles Perfect Silver, manufactured by Ulvac Materials, Inc.), specifically a silver particle dispersion (liquid viscosity at 25°C: 30 mPa·s) containing 15 parts by weight of dodecylamine (molecular weight 185.36, boiling point 248°C) as the alkylamine for use in the surface coating layer and 75 parts by weight of terpineol as the organic solvent for use as the dispersion solvent based on mass 100 parts of silver particles having an average diameter of 5 nm was concentrated, partially removing excessive amounts of the organic solvent and the coating agent dissolved therein. The concentrated solution was then defoamed by filtration through a polytetraethylene filter having a mesh size of 0.5 µm, for removal of the fine air bubbles generated during agitation in the concentration treatment. Then, the liquid viscosity was adjusted to a liquid viscosity of 10 mPa·s (25°C) by addition of tetradecane in a suitable amount.

Subsequently, the dispersion above was coated on the face of the base material D2 having a fluorine-based graft polymer-generated region and a non-generated region to an average film thickness of 5 µm during coating by inkjet printing in a straight line pattern having a desirable line width of 20 µm, to form a coated film.
The coated film was then heat-treated at 230°C for 60 minutes, allowing sintering of the silver particles contained, to form a conductive pattern of sintered silver layer.
The conductive pattern obtained was a a silver line pattern having a width 20 µm and a spacing of 20 µm in the pattern of a fluorine-based graft polymer-generated region and a non-generated region.
The average thickness of the sintered body layer was 1 µm, and the resistivity (volume resistivity) thereof was favorable at 3.0×10⁻⁶ Ω·cm.

### Example 13

### [Preparation of base material]

### (Preparation of polymerization-initiation polymer A)

30 g of propylene glycol monomethylether (MFG) was placed in a 300-ml three-necked flask and heated to 75°C. A solution containing 8.1 g of [2-(acryloyloxy)ethyl)(4-benzoylbenzyl)dimethylammonium bromide, 9.9 g of 2-hydroxyethyl methacrylate, 13.5 g of isopropyl methacrylate, 0.43 g of dimethyl-2,2'-azobis(2-methyl propionate), and 30 g of MFG was added thereto dropwise over 2.5 hours. Then, the reaction temperature was raised to 80°C, and allowed to react additionally for 2 hours, to give a polymerization-initiating polymer A.

### (Polymerization-initiation layer-forming process)

A polyethylene terephthalate film having a thickness of 0.188 mm (product name: M4100, manufactured by Toyobo Co., Ltd.) was used as the substrate, and the following polymerization-initiation layer coating solution 1 was applied on the surface with a rod bar No. 18, and dried and crosslinked at 110°C for 10 minutes. The thickness of the polymerization-initiation layer was 9.3 µm. The base material thus obtained is designated as base material E 1.

### <Polymerization-initiation layer coating solution 1>

- Polymerization-initiation polymer A above 0.4 g
- TDK (tolylene-2,4-diisocyanate) 0.16 g
- Propylene glycol monomethylether (MFG) 1.6 g

### [Graft polymer-generating process (A)]

A fluorine-based graft polymer was generated on the base material obtained E 1 in a patterned form, according to a method similar to that in Example 8, to give a base material E2 having a fluorine-based graft polymer-generated region and a non-generated region formed.

The water-droplet contact angle in the fluorine-based graft polymer-generated region of base material E2, as determined for confirmation of water repellency, was 115 degrees, indicating superior water repellency.
When a magic ink (Mackee Care, black, manufactured by Zebra Co., Ltd.) is applied for confirmation of the oil repellency of the pattern, the ink deposited not in the fluorine-based graft polymer-generated region but only in the region other than the fluorine graft polymer-formed region selectively.
The surface fluorine atom content of the fluorine-based graft polymer of base material E2, as determined by ESCA, was 50 % by atom (other surface atom contents: C: 44% and O: 6%), indicating high oil- and water-repellency. (for reference: fluorine content of monomer: 52 % by atom, other atom amounts: C: 42% and O: 6%)
The film thickness in the graft polymer-generated region, as determined by using Nanopics 1000 (manufactured by Seiko Instruments Inc.) was 20 nm.

### [Raw conductive material-applying process]

### (Preparation of dispersion)

A commercially available copper oxide particle dispersion (trade name: independent-dispersion ultrafine particles Perfect Copper, manufactured by Ulvac Materials, Inc.), specifically a copper oxide particle dispersion containing 15 parts by weight of dodecylamine (molecular weight 185.36, boiling point 248°C) as the alkylamine for use in the surface coating layer and 75 parts by weight of terpineol as the organic solvent for use as the dispersion solvent (liquid viscosity at 25°C: 30 mPa·s) based on 100 parts by weight of copper oxide particles having an average diameter of 5 mm was concentrated, partially removing excessive amounts of the organic solvent and the coating agent dissolved in the organic solvent. The concentration processing lead to increase in liquid viscosity and gave a pasty dispersion containing copper oxide particles having the surface coating layer. The liquid viscosity of the dispersion prepared was 100 Pa·s (25°C).

Subsequently, the dispersion was coated on the face of the base material E2 having a fluorine-based graft polymer-generated region and a non-generated region formed to an average film thickness of 10 µm during coating by using a #500-mesh stainless steel screen plate by screen printing coating, to give a coated film. Then, the coated film wad reduced under the following condition, allowing conversion of the copper oxide particles into copper particles and sintering of the copper particles, to form a conductive pattern of sintered copper sintered body layer.

The base material E2 having the coated film was first placed in a flat-plate-electrode plasma-processing apparatus, and the internal pressure of the plasma-processing apparatus was reduced to 10 Pa with an exhaust system. A mixed gas of argon: hydrogen at 95:5 (by volume) was supplied under the reduced pressure into the apparatus through a gas inlet at a flow rate of 100 ml/min (normal flow rate), and a high-frequency power (frequency: 13.56 MHz) at 500 W was applied between the flat-plate electrodes, allowing plasma processing at 150°C for 5 minutes. During the plasma treatment, the internal pressure of the apparatus was kept at approximately 30 to 40 Pa.
Treatment in the plasma atmosphere by using a hydrogen-containing mixed gas as the reductive gas resulted in plasma reduction of the copper oxide particles into copper particles. It also lead to vaporization of the dispersion solvent contained in the coated film, removal of the dodecylamine surface-protecting molecular layer coating the copper particle surface, and plasma reduction deep into the coated film, and consequently to dense deposition of the copper particles over the entire coated film. Low-temperature heating in the state lead to low-temperature sintering of copper particles into the state without any oxide film on the surface and consequently, to generation of a sintered copper layer as a whole.
The conductive pattern obtained was a copper line pattern having a width of 20 µm and a spacing of 20 µm in the pattern of a fluorine-based graft polymer-generated region and a non-generated region.
The average thickness of the sintered body layer was 2 µm, and the resistivity (volume resistivity) was favorable at 4.9×10⁻⁶ Ω·cm.

### Example 14

### (Preparation of base material)

The following epoxy base material was prepared as the base material.
First, 20 parts by weight of a bisphenol-A epoxy resin (epoxy equivalence: 185, manufactured by Japan Epoxy Resin Co., Ltd., Epikote 828), 45 parts by weight of a cresol novolak epoxy resin (epoxy equivalence: 215, manufactured by Dainippon Ink and Chemicals, Inc., Epichlone N-673), and 30 parts by weight of a phenolic novolak resin (phenolic hydroxyl group equivalence 105, manufactured by Dainippon Ink and Chemicals, Inc., Phenolite) were dissolved in 20 parts by weight of ethyl diglycol acetate and 20 parts by weight of solvent naphtha under heat and agitation; after the mixture is allowed to cool to room temperature, 30 parts of a cyclohexanone varnish containing a bisphenol-A epoxy resin (Epikote 828) and bisphenol S (YL6747H30, manufactured by Japan Epoxy Resin Co., Ltd., nonvolatile content: 30 % by mass, weight-average molecular weight: 47,000), 0.8 part of 2-phenyl-4,5-bis(hydroxymethyl)imidazole, and additionally, 2 parts of finely pulverized silica and 0.5 part of a silicon-based antifoam were added thereto, to give an epoxy resin varnish. The varnish was coated on a SUS substrate by using a doctor blade and heated and dried at 100°C for 10 minutes and additionally at
200°C for 5 minutes, to give a hardened epoxy base material having a thickness of 200 µm. The epoxy base material is designated as base material F1.

### [Radical-generating process and graft polymer-generating process (B)]

0.5 g of a fluorine-containing monomer 2-(perfluorooctyl)ethyl methacrylate (manufactured by Abmax Co., Ltd.), 0.5 g of 1-methoxy-2-propanol (manufactured by Wako Pure Chemical Industries, Ltd.), and 0.01 g of benzophenone as the hydrogen-abstraction radical generator were mixed into a homogeneous solution.
Approximately 0.5 ml of the solution was applied dropwise on the base material F1 I obtained above, and a quartz plate was placed thereon, to form a liquid film as uniform as possible. The liquid film was exposed through a pattern mask (photomask, manufactured by SK-Electronics Co., Ltd.) to a light at a wavelength 254 nm at an irradiation intensity of 10 mw/cm² for 60 seconds in an exposure machine (UVE202S, manufactured by Sanei Denki Seisakusho K.K.), allowing graft polymerization reaction to proceed. After patternwise photoirradiation, the quartz plate was removed, and the fluorine-based graft polymer obtained was washed with acetone, removing impurities such as unreacted fluorine-containing monomer, to form a base material F2 having a fluorine-based graft polymer-generated region and a non-generated region.

The water-droplet contact angle in the fluorine-based graft polymer-generated region of base material F2, as determined for confirmation of water repellency, was 113 degrees, indicating superior water repellency.
When a magic ink (Mackee Care, black, manufactured by Zebra Co., Ltd.) is applied for confirmation of the oil repellency of the pattern, the ink deposited not in the fluorine-based graft polymer-generated region but only in the region other than the fluorine graft polymer-formed region selectively.
The surface fluorine atom content of the fluorine-based graft polymer of the base material F2, as determined by ESCA, was 50 % by atom (other surface atom contents: C: 44% and O: 6%), indicating high oil- and water-repellency. (for reference: fluorine content of monomer: 52 % by atom, other atom amounts: C: 42% and O: 6%]
The film thickness in the graft polymer-generated region, as determined by using Nanopics 1000 (manufactured by Seiko Instruments Inc.), was 20 nm.

### [Raw conductive material-applying process]

### (Preparation of dispersion)

15 g of silver nitrate and 20.5 g of tetrachloroauric acid were dissolved in 100 ml of distilled water, and 100 g of diethanolamine was added to the solution heated at 80°C. Subsequent reaction under agitation for 8 hours gave a black dispersion containing gold-silver alloy fine particles formed in wet reductive reaction. Acetone was added to the dispersion for removal of residual diethanolamine and also for precipitation of the gold-silver alloy fine particles. The acetone washing was repeated thrice, for removal of undesirable products and impurities including residual raw materials. The average particle diameter of the gold-silver alloy fine particles obtained in the wet reductive reaction was 9 nm.
A gold-silver alloy fine particle dispersion (liquid viscosity at 25°C: 30 mPa·s) containing 15 parts by weight of dodecylamine (molecular weight 185.36, boiling point 248°C) as the alkylamine for use in the surface coating layer and 75 parts by weight of terpineol as the organic solvent for use as the dispersion solvent based on 100 parts by weight of the gold-silver alloy fine particles obtained was concentrated, partially removing excessive amounts of the organic solvent and the coating agent dissolved therein. The concentration treatment lead to increase in liquid viscosity, and gave a pasty dispersion containing gold-silver alloy fine particles having the surface coating layer. The liquid viscosity of the dispersion prepared was 70 Pa·s (25°C).

Subsequently, the dispersion was applied on the face of the base material F2 having a fluorine-based graft polymer-generated region and a non-generated region formed by screen printing by using a #500-mesh stainless steel screen plate, to give a coated film.
The coated film was then heat-treated at 250°C for 40 minutes, allowing sintering of the gold-silver alloy particles contained, to form a conductive pattern of sintered gold-silver alloy layer.
The conductive pattern obtained had a gold-silver alloy line pattern having a width of 25 µm and a spacing of 25 µm in the pattern of a fluorine-based graft polymer-generated region and a non-generated region.
The average thickness of the sintered body layer was 2 µm, and the resistivity (volume resistivity) thereof was favorable at 5.0x10⁻⁶ Ω·cm.

### Comparative Example 3

A monomolecular film of heptadecafluoro-1,1,2,2-tetrahydrodecyltrimthoxysilane was formed on a silicon substrate according to the method described in Example 8 of JP-A No. 2000-282240 (the Patent Document 1).
The monomolecular film obtained was exposed to light in the exposure machine used in Example 8 of the present invention for 45 minutes, only giving a monomolecular film remaining incompletely removed in the exposed portion and thus, no distinct oil- and water-repellent pattern. Accordingly, the processing in the raw conductive material-depositing process was also performed inaccurately, leading to failure in forming a conductive pattern in the desired region.
The contact angle of the monomolecular film in the unexposed region determined was 115 degrees, indicating favorable water repellency. The surface fluorine atom content of the monomolecular film in the unexposed region, as determined by ESCA, was 53 % by atom, indicating high oil- and water-repellency.
The thickness of the monomolecular film formed on the silicon base material, as determined by using Nanopics 1000 (manufactured by Seiko Instruments Inc.) in a similar manner to Example 8, was 5 nm or less, and thus, unmeasurable.

After exposure of the monomolecular film obtained to light in the exposure machine used in Example 8 of the present invention for 1 hour and 30 minutes, the monomolecular film in the exposed portion was completely removed and a pattern having a monomolecular film-formed region and a non-generated region was obtained.
A conductive polymer layer was formed on the non-generated region of the monomolecular film, according to a method similar to that in Example 11, to give a conductive pattern. The conductive pattern was a conductive line pattern having a width of 10 µm and a spacing of more than 10 µm. The thickness of the conductive polymer layer was 0.5 µm.
Subsequent measurement of the conductivity of the conductive polymer with a tester under microscope showed that any position thereof had a conductivity of 10 Ω.

These results suggest distinctively that the methods of forming a conductive pattern according to the present invention described in Examples 8 to 14 are higher in conductivity and also in resolution and accuracy than the conductive pattern of Comparative Example 1.

### Example 15

### [Photocleavable compound-bonding process (B))

A glass substrate was immersed in piranha solution (sulfuric acid/30 % by mass hydrogen peroxide, 1/1 vol. liquid mixture) overnight, and then, washed with purified water. The substrate was placed in a nitrogen-substituted separable flask and immersed in the dehydrated toluene solution containing 12.5 % by mass compound A prepared in Preparative Example 1 above for 1 hour. After separation, the substrate was washed with toluene, acetone, and purified water in this order. The substrate obtained is designated as base material A1.

### [Partition-forming process (D)]

0.5 g of a fluorine-containing monomer 2-(perfluorooctyl)ethyl methacrylate (manufactured by Abmax Co., Ltd.) and 0.5 g of 1-methoxy-2-propanol (manufactured by Wako Pure Chemical Industries, Ltd.) were mixed into a homogeneous solution.
Approximately 0.5 ml of the solution was applied dropwise on the base material A1 obtained above, and a quartz plate was placed thereon, to form a liquid film as uniform as possible. The substrate was irradiated through a pattern mask (photomask manufactured by SK-Electronics Co., Ltd.) in an exposure machine (UVE202S, manufactured by Sanei Denki Seisakusho K.K.) with a light having a wavelength of 254 nm at an irradiation intensity of 10 mW/cm² for 60 seconds. The pattern mask used had squares of 5 µm in width and length separated by a distance of 1 µm, and the region other than the square regions transmitted light. After patternwise photoirradiation, the quartz plate was removed, and the fluorine-based graft polymer obtained was washed with acetone, removing impurities such as unreacted fluorine-containing monomer, to give a base material A2 having partitions of fluorine-based graft polymer-generated region formed.

The water-droplet contact angle in the fluorine-based graft polymer-generated region of the base material A2, as determined for confirmation of water repellency, was 115 degrees, indicating superior water repellency. The contact angle in the no-graft-polymer-generated region as determined by a similar method was 70 degrees.
When a magic ink (Mackee Care, black, manufactured by Zebra Co., Ltd.) is applied in the region, for confirmation of the oil repellency of the partitions, the ink deposited not in the partition but only in the no-graft-polymer-generated region selectively.
The surface fluorine atom content of the fluorine-based graft polymer, as determined by ESCA, was 52 % by atom (other surface atom contents: C: 42% and O: 6%), indicating high oil- and water-repellency. (for reference: fluorine content of monomer: 52 % by atom, other atom amounts: C: 42% and O: 6%)
The film thickness in the graft polymer-generated region, as determined by using Nanopics 1000 (manufactured by Seiko Instruments Inc.), was 10 nm.

### [Pixel-forming process]

An ink (liquid containing a colorant) in the following composition was ejected on the no-graft-polymer-generated region of the base material A2 in an inkjet device (PX-G900, manufactured by Seiko Epson Corp.). The base material was then heated at 80°C.

### (Red ink)

- Colorant: pigment 5 g
   (C.I. Pigment Red 177)
- Solvent 20 g
   (propylene glycol monomethylether acetate)
- Polymerization initiator 5 g
   (Irgacure 369, manufactured by Ciba Specialty Chemicals)
- UV hardening resin ·· -70 g
   (dipentaerythritol-hexaacrylate, manufactured by Nippon Kayaku Co., Ltd.)

### (Blue ink)

- Colorant: pigment 5 g
   (C.I. Pigment Blue15 + C.I. Pigment Violet23)
- Solvent 20 g
   (propylene glycol monomethylether acetate)
- Polymerization initiator 5 g
   (Irgacure 369, manufactured by Ciba Specialty Chemicals)
- UV hardening resin 70 g
   (dipentaerythritol hexaacrylate, manufactured by Nippon Kayaku Co., Ltd.)

### (Green ink)

- Colorant: pigment 5 g
   (C.I. Pigment Green 36)
- Solvent 20 g
   (propylene glycol monomethylether acetate)
- Polymerization initiator 5 g
   (Irgacure 369, manufactured by Ciba Specialty Chemicals)
- UV hardening resin 70 g
   (dipentaerythritol hexaacrylate, manufactured by Nippon Kayaku Co., Ltd.)

After heating, the ink-deposited face was UV-irradiated in the exposure machine above, allowing hardening of the ink and formation of the pixels.
The color filter thus obtained had a favorable display quality, when applied to a color liquid crystal display device.

### Example 16

### [Photocleavable compound-bonding process (A)]

A base material A1 having a photocleavable compound bound to the entire surface was prepared in a similar manner to Example 15.

### [Polymerization initiating potential-inactivating process]

The base material A1 thus obtained was exposed to a light at a wavelength of 254 nm at an irradiation intensity of 10 mW/cm² through the pattern mask used in Example 15 (photomask, manufactured by SK-Electronics Co., Ltd.) in an exposure machine (UVE202S, manufactured by Sanei Denki Seisakusho K.K.) for 60 seconds. The pattern mask used had squares of 5 µm in width and length separated by a distance of 1 µm, and the region other than the square regions transmitted light. The operation gave a base material B 1 having a polymerization initiation-allowing region (unexposed region) and a polymerization-initiating-potential-inactivated region (exposed region).

### [Partition-forming process (C)]

0.5 g of a fluorine-containing monomer 2-(perfluorooctyl)ethyl methacrylate (manufactured by Abmax Co., Ltd.) and 0.5 g of 1-methoxy-2-propanol (manufactured by Wako Pure Chemical Industries, Ltd.) were mixed, to give a homogeneous soluiton.
Approximately 0.5 ml of the solution was applied dropwise on the base material B1 obtained above, and a quartz plate was placed thereon, to form a liquid film as uniform as possible. The liquid film was then photoirradiated on the entire surface in the exposure machine used in the polymerization initiating potential-inactivating process for 60 seconds, allowing graft polymerization reaction to proceed. The quartz plate was separated after photoirradiation, and the fluorine-based graft polymer obtained was washed with acetone, for removal of impurities such as unreacted fluorine-containing monomer, to give a base material B2 having partitions of fluorine-based graft polymer-generated region formed.

The water-droplet contact angle in the fluorine-based graft polymer-generated region of the base material B2, as determined for confirmation of water repellency, was 113 degrees, indicating superior water repellency. The contact angle in the no-graft-polymer-generated region, as determined by a similar method, was 65 degrees.
When a magic ink (Mackee Care, black, manufactured by Zebra Co., Ltd.) is applied in the region for confirmation of the oil repellency in the partition, the ink deposited not in the partition but only in the no-graft-polymer-generated region selectively ink.
The surface fluorine atom content of the fluorine-based graft polymer, as determined by ESCA, was 40 % by atom (other surface atom contents: C: 48% and 0:12%), indicating high oil- and water-repellency. (for reference: fluorine content of monomer: 45 % by atom, other atom amounts: C: 45% and 0:10%) The film thickness in the graft polymer-generated region, as determined by using Nanopics 1000 (manufactured by Seiko Instruments Inc.) was 10 nm.

### [Pixel-forming process]

Inks in various colors were applied and hardened on the no-graft-polymer-generated region of the base material B2 according to a method similar to the in Example 15, to form pixels.
The color filter thus obtained had a favorable display quality, when applied to a color liquid crystal display device.

### Example 17

### [Preparation of transparent base material]

125 g of a mixture of dipentaerythritol pentaacrylate and dipentaerythritol hexaacrylate (DPHA, manufactured by Nippon Kayaku Co., Ltd.) and 125 g of a urethane acrylate oligomer (UV-6300B, manufactured by Nippon Synthetic Chemical Industry Co., Ltd.) were dissolved in 439 g of industrial denatured ethanol. A solution containing 7.5 g of a photopolymerization initiator (Irgacure 907, manufactured by Ciba-Geigy Corp.) as a low-molecular weight radical generator, 5.0 g of a photosensitizer (Kayacure DETX, manufactured by Nippon Kayaku Co., Ltd.), and 49 g of methylethylketone was added to the solution obtained. After agitation, the mixture was filtered through a polypropylene filter having a pore size of 1 µm, to give a coating solution for the radical generator-containing layer.

A triacetylcellulose film having a thickness of 80 µm (TAC-TD80U, manufactured by Fuji Photo Film Co.) was used as the substrate, and a gelatin undercoat layer was formed on the surface. The coating solution for the radical generator-containing layer was applied on the gelatin undercoat layer by using a bar coater, dried at 120°C, and exposed to a light from a high-pressure mercury lamp for 30 seconds, allowing hardening of the coated film, to give a base material having a thickness of 15 µm. The high-pressure mercury lamp used was UVX-02516S1LP01 manufactured by Ushio Inc. The base material obtained is designated as base material C 1.

### [Partition-forming process (A)]

0.5 g of a fluorine-containing monomer 2-(perfluorooctyl)ethyl methacrylate (manufactured by Abmax Co., Ltd.) and 0.5 g of 1-methoxy-2-propanol (manufactured by Wako Pure Chemical Industries, Ltd.) were mixed, to give a homogeneous solution.
The base material obtained above was cut into pieces of 4 cmx5 cm in size, and approximately 0.5 ml of the solution was applied dropwise on each of it, and a quartz plate was placed thereon, to form a liquid film as uniform as possible. The quartz plate was adhered to a mask pattern (NC-5, manufactured by Toppan Printing Co., Ltd.) in a UV exposure device (UVX-02516S1LP01, high-pressure mercury lamp, manufactured by Ushio Inc.) and photoirradiated for 5 minutes. The pattern mask used had squares of 5 µm in width and length separated by a distance of 1 µm, and the region other than the square regions transmitted light. The mask and the quartz plate were separated after photoirradiation, and the fluorine-based graft polymer obtained was washed with acetone, removing impurities such as unreacted fluorine-containing monomer, to give a base material C2 having partitions of fluorine-based graft polymer-generated region formed.

The contact angle of water droplet in the fluorine-based graft polymer-generated region of base material C2, as determined for confirmation of water repellency, was 107.8 degrees, indicating superior water repellency. The contact angle in the no-graft-polymer-generated region by a similar method was 80.3 degrees.
When a magic ink (Mackee Care, black, manufactured by Zebra Co., Ltd.) is applied in the region for confirmation of the oil repellency in the partition, the ink deposited not in the partition but only in the no-graft-polymer-generated region selectively ink.
The surface fluorine atom content of the fluorine-based graft polymer of the base material C2, as determined by ESCA, was 51 % by atom (other surface atom contents: C: 43% and O: 6%), indicating high oil- and water-repellency. (for reference: fluorine content of monomer: 52 % by atom, other atom amounts: C: 42% and O: 6%)
The film thickness in the graft polymer-generated region, as determined by using Nanopics 1000 (manufactured by Seiko Instruments Inc.) was 15 nm.

### [Pixel-forming process]

Inks in various colors were applied and hardened on the no-graft-polymer-generated region of the base material C2 by a method similar to that in Example 15, to form pixels.
The color filter thus obtained had a favorable display quality, when applied to a color liquid crystal display device.

### Example 18

A base material was prepared in a similar manner to Example 17, except that 7.5 g of the photopolymerization initiator (Irgacure 907, manufactured by Ciba-Geigy Corp.) and 5.0 g of the photosensitizer (Kayacure DETX, manufactured by Nippon Kayaku Co., Ltd.) used as the low-molecular weight radical generators in preparation of the transparent base material in Example 17 were replaced with 12.5 g of the polymeric radical generator described in JP-A No. 9-77891, paragraph number [0076]. The base material obtained is designated as base material D1.

### [Partition-forming process (A)]

A fluorine-based graft polymer was generated on the base material D 1 thus obtained by a method similar to that in Example 17, to give a base material D2 having the partitions of fluorine-based graft polymer-generated region formed.

The water-droplet contact angle in the partition of fluorine-based graft polymer-generated region of the base material D2, as determined for confirmation of water repellency, was 110 degrees, indicating superior water repellency. The contact angle in the no-graft-polymer-generated region by a similar method was 76 degrees.
When a magic ink (Mackee Care, black, manufactured by Zebra Co., Ltd.) is applied in the region for confirmation of the oil repellency in the partition, the ink deposited not in the partition but only in the no-graft-polymer-generated region selectively ink.
The surface fluorine atom content of the fluorine-based graft polymer on the base material D2, as determined by ESCA, was 50 % by atom (other surface atom contents: C: 44% and O: 6%), indicating high oil- and water-repellency. (for reference: fluorine content of monomer: 52 % by atom, other atom amounts: C: 42% and O: 6%]
The film thickness in the graft polymer-generated region, as determined by using Nanopics 1000 (manufactured by Seiko Instruments Inc.) was 20 nm.

### [Pixel-forming process]

Inks in various colors were applied and hardened on the no-graft-polymer-generated region of the base material D2 by a method similar to that in Example 15, to form pixels. The color filter thus obtained had a favorable display quality, when applied to a color liquid crystal display device.

### Example 19

### [Preparation of transparent base material]

### (Preparation of polymerization-initiation polymer A)

30 g of propylene glycol monomethylether (MFG) was placed in a 300 ml three-necked flask and heated to 75°C. A solution containing 8.1 g of [2-(acryloyloxy)ethyl)(4-benzoylbenzyl)dimethylammonium bromide, 9.9 g of 2-hydroxyethyl methacrylate, 13.5 g of isopropyl methacrylate, 0.43 g of dimethyl-2,2'-azobis(2-methyl propionate) and 30 g of MFG were added thereto dropwise over 2.5 hours. The reaction temperature was then raised to 80°C, and allowed to react additionally for 2 hours, to give a polymerization-initiating polymer A.

### (Polymerization-initiation layer-forming process)

A polyethylene terephthalate film having a thickness of 0.1881 nm (product name: M4100, manufactured by Toyobo Co., Ltd.) was used as the substrate, and the following polymerization-initiation layer coating solution 1 was coated on the surface with a rod bar No. 18, and dried and crosslinked at 110°C for 10 minutes. The thickness of the polymerization-initiation layer was 9.3 µm. The base material thus obtained is designated as base material E1.

### <Polymerization-initiation layer coating solution 1>

- Polymerization-initiation polymer A above 0.4 g
- TDK (tolylene-2,4-diisocyanate) 0.16 g
- Propylene glycol monomethylether (MFG) 1.6 g

### [Partition-forming process (A)]

A fluorine-based graft polymer was generated in a patterned form on the base material obtained E1, by a method similar to that in Example 15, to give a base material E2 having partitions of the fluorine-based graft polymer-generated region formed.

The water-droplet contact angle in the fluorine-based graft polymer-generated region of the base material E2, as determined for confirmation of water repellency, was 115 degrees, indicating superior water repellency. The contact angle in the no-graft-polymer-generated region by a similar method was 83 degrees.
When a magic ink (Mackee Care, black, manufactured by Zebra Co., Ltd.) is applied in the region for confirmation of the oil repellency in the partition, the ink deposited not in the partition but only in the no-graft-polymer-generated region selectively ink.
The surface fluorine atom content of the fluorine-based graft polymer on the base material E2, as determined by ESCA, was 50 % by atom (other surface atom contents: C: 44% and O: 6%), indicating high oil- and water-repellency. (for reference: fluorine content of monomer: 52 % by atom, other atom amounts: C: 42% and O: 6%) The film thickness in the graft polymer-generated region, as determined by using Nanopics 1000 (manufactured by Seiko Instruments Inc.) was 20 nm.

### [Pixel-forming process]

Inks in various colors were applied and hardened on the no-graft-polymer-generated region of the base material E2 by a method similar to that in Example 15, to form pixels. The color filter thus obtained had a favorable display quality, when applied to a color liquid crystal display device.

### Example 20

### (Preparation of transparent base material)

The following epoxy base material was prepared as the transparent base material.
First, 20 parts by weight of a bisphenol-A epoxy resin (epoxy equivalence 185, manufactured by Japan Epoxy Resin Co., Ltd., Epikote 828), 45 parts by weight of a cresol novolak epoxy resin (epoxy equivalence 215, manufactured by Dainippon Ink and Chemicals, Inc., Epichlone N-673), and 30 parts by weight of a phenolic novolak resin (phenolic hydroxyl group equivalence 105, manufactured by Dainippon Ink and Chemicals, Inc., Phenolite) were dissolved in 20 parts by weight of ethyl diglycol acetate and 20 parts by weight of solvent naphtha under heat while the mixture was stirred; and after the solution was cooled to room temperature, 30 parts of a phenoxy resin cyclohexanone varnish containing a bisphenol-A epoxy resin (Epikote 828) and bisphenol S (manufactured by Japan Epoxy Resin Co., Ltd. YL6747H30, nonvolatile content: 30 % by mass, weight-average molecular weight: 47000), 0.8 part of 2-phenyl-4,5-bis(hydroxymethyl)imidazole, 2 parts of finely pulverized silica, and 0.5 part of silicon-based antifoam were added thereto, to give an epoxy resin varnish. The varnish was applied on a SUS substrate by using a doctor blade and heated and dried at 100°C for 10 minutes and additionally at 200°C for 5 minutes, to give a hardened epoxy base material having a thickness of 200 µm. The epoxy base material is designate as base material F 1.

### [Radical-generating process, and partition-forming process (B))

0.5 g of a fluorine-containing monomer 2-(perfluorooctyl)ethyl methacrylate (manufactured by Abmax Co., Ltd.), 0.5 g of 1-methoxy-2-propanol (manufactured by Wako Pure Chemical Industries, Ltd.), and 0.01 g of a hydrogen-abstraction radical generator benzophenone were mixed into a homogeneous solution.
Approximately 0.5 ml of the solution was applied dropwise on the base material F1 obtained above, and a quartz plate was placed thereon, to form a liquid film as uniform as possible. The liquid film thus obtained was exposed to a light at a wavelength of 254 nm at an irradiation intensity of 10 mW/cm² through a pattern mask used (photomask, manufactured by SK-Electronics Co., Ltd.) in an exposure machine (UVE202S, manufactured by Sanei Denki Seisakusho K.K.) for 60 seconds. The pattern mask used had squares of 5 µm in width and length separated by a distance of 1 µm, and the region other than the square regions transmitted light. After patternwise photoirradiation, the quartz plate was removed, and the fluorine-based graft polymer obtained was washed with acetone, removing impurities such as unreacted fluorine-containing monomer, to give a base material F2 having a partition of fluorine-based graft polymer-generated region formed.

The water-droplet contact angle in the fluorine-based graft polymer-generated region of the base material F2, as determined for confirmation of water repellency, was 113 degrees, indicating superior water repellency. The contact angle in the no-graft-polymer-generated region by a similar method was 80 degrees.
When a magic ink (Mackee Care, black, manufactured by Zebra Co., Ltd.) is applied in the region for confirmation of the oil repellency in the partition, the ink deposited not in the partition but only in the no-graft-polymer-generated region selectively ink.
The surface fluorine atom content of the fluorine-based graft polymer on the base material F2, as determined by ESCA, was 50 % by atom (other surface atom contents: C: 44% and O: 6%), indicating high oil- and water-repellency. (for reference: fluorine content of monomer: 52 % by atom, other atom amounts: C: 42% and O: 6%) The film thickness in the graft polymer-generated region, as determined by using Nanopics 1000 (manufactured by Seiko Instruments Inc.) was 20 nm.

### [Pixel-forming process]

Inks in various colors were applied and hardened on the no-graft-polymer-generated region of the base material F2 by a method similar to that in Example 15, to form pixels.
The color filter thus obtained had a favorable display quality, when applied to a color liquid crystal display device.

### Example 21

### [Photocleavable compound-bonding process (B))

A glass substrate (manufactured by Nippon Sheet Glass) was immersed in piranha solution (1/1 vol. mixed solution of sulfuric acid and 30% hydrogen peroxide) overnight and then washed with pure water. The base material was placed in a nitrogen-substituted separable flask and immersed in the dehydrated toluene solution containing 12.5 % by mass compound A prepared in Preparative Example 1 above for 1 hour. After removal, the base material was washed with toluene, acetone, and purified water in this order. The base plate obtained is designated as substrate A1.

### [Graft polymer-generating process (B)]

0.5 g of a fluorine-containing monomer 2-(perfluorooctyl)ethyl methacrylate (manufactured by Abmax Co., Ltd.) and 0.5 g of 1-methoxy-2-propanol (manufactured by Wako Pure Chemical Industries, Ltd.) were mixed into a homogeneous solution.
Approximately 0.5 ml of the solution was applied dropwise on the base material A1 obtained above, and a quartz plate was placed thereon, to form a liquid film as uniform as possible. The liquid film thus obtained was exposed to a light at a wavelength of 254 nm at an irradiation intensity of 15.5 mW/cm² through a pattern mask used (photomask, manufactured by SK-Electronics Co., Ltd.) in an exposure machine (UVE202S, manufactured by Sanei Denki Seisakusho K.K.) for 60 seconds. The pattern mask used had squares of 50 µm in width and length separated by a distance of 3 µm, and the region other than the square regions transmitted light. After patternwise photoirradiation, the quartz plate was removed, and the fluorine-based graft polymer obtained was washed with acetone, removing impurities such as unreacted fluorine-containing monomer, to give a fluorine-based base material having a graft polymer-generated region and a non-generated region A2.

The water-droplet contact angle in the fluorine-based graft polymer-generated region of the base material A2, as determined for confirmation of oil repellency, was 115 degrees, indicating superior oil repellency. The contact angle in the no-graft-polymer-generated region by a similar method was 70 degrees.
When a magic ink (Mackee Care, black, manufactured by Zebra Co., Ltd.) is applied in the region for confirmation of the oil repellency in the partition, the ink deposited not in the partition but only in the no-graft-polymer-generated region selectively ink.
The surface fluorine atom content of the fluorine-based graft polymer, as determined by ESCA, was 52 % by atom (other surface atom contents: C: 42% and O: 6%), indicating high oil- and water-repellency. (for reference: fluorine content of monomer: 52 % by atom, other atom amounts: C: 42% and O: 6%)
The film thickness in the graft polymer-generated region, as determined by using Nanopics 1000 (manufactured by Seiko Instruments Inc.) was 10 nm.

### [Microlens-forming process (B)]

When the base material A2 was immersed in and withdrawn from a microlens raw material fluid containing 0.5 part by weight of a UV hardening resin (polyethylene glycol dimethacrylate, MK ester 9G; manufactured by Shin-Nakamura Chemicals), 0.025 parts by weight of a photoinitiator isopropylthioxanthone, and 9.5 parts by weight of a solvent 1-methoxy-2-propanol, the microlens raw material fluid deposited only in the no-graft-polymer-generated region but not in the graft polymer-generated region.
The microlens raw material fluid deposited appeared semispherical in shape on the base material, when seen from the side wall. The fluid was hardened by exposure to a light from a mercury lamp at an illuminance of 35 mW/cm² for 1 minute, to give a microlens array carrying multiple microlenses having a focal length of 1 mm formed on the base material.

### Example 22

### [Photocleavable compound-bonding process (A)]

A base material A1 having a photocleavable compound bound to the entire surface was prepared in a similar manner to Example 1.

### [Polymerization initiating potential-inactivating process]

The base material A1 thus obtained was exposed to a light having a wavelength of 254 nm at an irradiation intensity of 15.5J/m² through the pattern mask used in Example 21 (photomask manufactured by SK-Electronics Co., Ltd.) in an exposure machine (UVE202S, manufactured by Sanei Denki Seisakusho K.K.) for 60 seconds. The pattern mask used has squares of 50 µm in width and length separated by a distance of 3 µm, and the region other than the square regions transmitted light. The operation gave a base material B 1 having a polymerization initiation-allowing region (unexposed region) and a polymerization-initiating-potential-inactivated region (exposed region).

### [Graft polymer-generating process (A)]

0.5 g of a fluorine-containing monomer 2-(perfluorooctyl)ethyl methacrylate (manufactured by Abmax Co., Ltd.) and 0.5 g of 1-methoxy-2-propanol (manufactured by Wako Pure Chemical Industries, Ltd.) were mixed, to give a homogeneous solution.
Approximately 0.5 ml of the solution was applied dropwise on the base material B1 obtained above, and a quartz plate was placed thereon, to form a liquid film as uniform as possible. The liquid film was then photoirradiated on the entire surface in the exposure machine used in the polymerization initiating potential-inactivating process for 60 seconds, allowing graft polymerization reaction to proceed. The quartz plate was separated after photoirradiation, and the fluorine-based graft polymer obtained was washed with acetone, for removal of impurities such as unreacted fluorine-containing monomer, to give a fluorine-based base material having a graft polymer-generated region and a non-generated region B2.

The water-droplet contact angle in the fluorine-based graft polymer-generated region of the base material B2, as determined similarly to Example 21 for confirmation of oil repellency, was 113 degrees, indicating superior oil repellency. The contact angle in the no-graft-polymer-generated region by a similar method was 65 degrees.
When a magic ink (Mackee Care, black, manufactured by Zebra Co., Ltd.) is applied in the region for confirmation of the oil repellency in the partition, the ink deposited not in the partition but only in the no-graft-polymer-generated region selectively ink.
The surface fluorine atom content of the fluorine-based graft polymer, as determined by ESCA, was 40 % by atom (other surface atom contents: C: 48% and O:12%), indicating high oil repellency. (for reference: fluorine content of monomer: 45 % by atom, other atom &C:45% and O: 10%)
The film thickness in the graft polymer-generated region, as determined by using Nanopics 1000 (manufactured by Seiko Instruments Inc.) was 10 nm.

### [Microlens-forming process (A)]

A microlens raw material fluid was applied and hardened on the no-graft-polymer-generated region of the base material B2 by a method similar to that in Example 21, to form microlenses, to give a microlens array having multiple microlenses having a focal length of 1 mm formed on the base material.

## Claims

1. A graft pattern-forming method comprising:
bringing a radically polymerizable compound having an oil- and water-repellent functional group into contact with a surface of a base material which is capable of generating radicals by photoirradiation; and
generating a graft polymer from radicals generated in an exposure region as initial points by patternwise photoirradiation on the base material to form a graft polymer-generated region and a non-generated region on the surface of the base material.

2. The graft pattern-forming method according to Claim 1, wherein the base material, which is capable of generating radicals by photoirradiation, contains a radical generator.

3. The graft pattern-forming method according to Claim 1, wherein the base material, which is capable of generating radicals by photoirradiation, contains a polymer compound having a radical-generating site on a side chain thereof.

4. The graft pattern-forming method according to Claim 1, wherein the base material, which is capable of generating radicals by photoirradiation, is prepared by coating a coating solution containing a polymer compound having a crosslinking site and having a radical-generating site on a side chain thereof on a surface of a substrate, drying the coating solution, and generating a crosslinked structure in the coated film.

5. A graft pattern-forming method comprising:
generating radicals in an exposure region of a base material by bringing a hydrogen abstraction radical generator into contact with a surface of the base material and performing patternwise photoirradiation on the base material;
bringing a radically polymerizable compound having an oil- and water-repellent functional group into contact with the surface of the base material; and
generating a graft polymer from the radicals generated in the exposure region as initial points to form a graft polymer-generated region and a non-generated region on the surface of the base material.

6. A graft pattern-forming method comprising, in the following order:
bonding a compound having a polymerization-initiating site, which is capable of initiating radical polymerization by photocleavage, onto a surface of a base material in a patterned form;
bringing a radically polymerizable compound having an oil- and water-repellent functional group into contact with the base material; and
photoirradiating the entire surface to generate a graft polymer from the polymerization-initiating site as initial points and form a graft polymer-generated region and a non-generated region on the surface of the base material.

7. The graft pattern-forming method according to Claim 6, wherein the bonding of the compound having a polymerization-initiating site, which is capable of initiating radical polymerization by photocleavage, onto the surface of the base material in the patterned form comprises:
bonding a compound having a polymerization-initiating site, which is capable of initiating radical polymerization by photocleavage, and a base material-bonding site onto the surface of the base material; and
inactivating the polymerization-initiating site in an exposure region by patternwise photoirradiation.

8. A graft pattern-forming method comprising, in the following order:
bonding a compound having a polymerization-initiating site, which is capable of initiating radical polymerization by photocleavage, and a base material-bonding site onto a surface of a base material;
bringing a radically polymerizable compound having an oil- and water-repellent functional group into contact with the surface of the base material; and
performing patternwise photoirradiation to generate a graft polymer from the polymerization-initiating site in an exposure region as initial points and form a graft polymer-generated region and a non-generated region on the surface of the base material.

9. The graft pattern-forming method of any one of Claims 6 to 8, wherein the polymerization-initiating site contains any one of bonds selected from the group consisting of a C-C bond, a C-N bond, a C-O bond, a C-Cl bond, a N-O bond and a S-N bond.

10. A graft pattern material having an oil- and water-repellent functional group, prepared by the graft pattern-forming method according to any one of Claims 1 to 9.

11. A lithography method comprising using a graft pattern as an etching stopper, wherein the graft pattern has an oil- and water-repellent functional group and is prepared by the graft pattern-forming method according to any one of Claims 1 to 9.

12. A conductive pattern forming method comprising:
bringing a radically polymerizable compound having an oil- and water-repellent functional group into contact with a surface of a base material which is capable of generating radicals by photoirradiation;
generating a graft polymer from radicals generated in an exposure region as initial points by patternwise photoirradiation on the base material to form a graft polymer-generated region and a non-generated region on the surface of the base material; and
attaching a conductive material onto the graft polymer non-generated region.

13. The conductive pattern-forming method according to Claim 12, wherein the base material, which is capable of generating radicals by photoirradiation, contains a radical generator.

14. The conductive pattern-forming method according to Claim 12, wherein the base material, which is capable of generating radicals by photoirradiation, contains a polymer compound having a radical-generating site on a side chain thereof.

15. The conductive pattern-forming method according to Claim 12, wherein the base material, which is capable of generating radicals by photoirradiation, is prepared by coating a coating solution containing a polymer compound having a crosslinking site and having a radical-generating site on a side chain thereof on a surface of a substrate, drying the coating solution, and generating a crosslinked structure in the coated film.

16. A conductive pattern-forming method comprising:
generating radicals in an exposure region of a base material by bringing a hydrogen abstraction radical generator into contact with a surface of a base material and performing patternwise photoirradiation on the base material;
bringing a radically polymerizable compound having an oil- and water-repellent functional group into contact with the surface of the base material,
generating a graft polymer from the radicals generated in the exposure region as initial points to form a graft polymer-generated region and a non-generated region on the surface of the base material; and
attaching a conductive material onto the graft polymer non-generated region.

17. A conductive pattern-forming method comprising:
bonding a compound having a polymerization-initiating site, which is capable of initiating radical polymerization by photocleavage, onto a surface of a base material in a patterned form;
bringing a radically polymerizable compound having an oil- and water-repellent functional group into contact with the base material;
photoirradiating the entire surface to generate a graft polymer from the polymerization-initiating site as initial points and form a graft polymer-generated region and a non-generated region on the surface of the base material; and
attaching a conductive material onto the graft polymer non-generated region.

18. The conductive pattern-forming method according to Claim 17, wherein the bonding of a compound having a polymerization-initiating site, which is capable of initiating radical polymerization by photocleavage, onto the surface of the base material in a patterned form comprises:
bonding a compound having a polymerization-initiating site, which is capable of initiating radical polymerization by photocleavage, and a base material-bonding site to the base material surface; and
inactivating the polymerization-initiating site in an exposure region by patternwise photoirradiation.

19. A conductive pattern-forming method comprising, in the following order:
bonding a compound having a polymerization-initiating site, which is capable of initiating radical polymerization by photocleavage, and a base material-bonding site onto a surface of a base material;
bringing a radically polymerizable compound having an oil- and water-repellent functional group into contact with the base material;
performing patternwise photoirradiation to generate a graft polymer from the polymerization-initiating site in an exposure region as initial points and form a graft polymer-generated region and a non-generated region on the surface of the base material; and
attaching a conductive material onto the graft polymer non-generated region.

20. The conductive pattern-forming method according to any one of Claims 17 to 19, wherein the polymerization-initiating site contains any one of bonds selected from the group consisting of a C-C bond, a C-N bond, a C-O bond, a C-Cl bond, a N-O bond and a S-N bond.

21. The conductive pattern-forming method according to any one of Claims 12 to 20, wherein the attaching of the conductive material onto the graft polymer non-generated region comprises:
applying a liquid containing conductive fine particles onto the graft polymer non-generated region; and
drying the liquid.

22. The conductive pattern-forming method according to Claim 21, wherein the liquid containing conductive fine particles is applied and is heated.

23. The conductive pattern-forming method according to any one of Claims 12 to 20, wherein the attaching of the conductive material onto the graft polymer non-generated region comprises:
applying a liquid containing metal oxide fine particles onto the graft polymer non-generated region; and
reducing the metal oxide fine particles; and
heating.

24. The conductive pattern-forming method according to any one of Claims 12 to 20, wherein the attachying of the conductive material onto the graft polymer non-generated region comprises:
activating the graft polymer non-generated region; and
subjecting the activated region to electroless plating.

25. The conductive pattern-forming method according to any one of Claims 12 to 20, wherein a conductive polymer layer is formed in the graft polymer non-generated region in the attaching of the conductive material onto the graft polymer non-generated region.

26. A conductive pattern prepared by the conductive pattern-forming method according to any one of Claims 1 to 25.

27. A method of producing a color filter having a plurality of pixels and partitions separating neighboring pixels on a transparent base material, the method comprising:
bringing a radically polymerizable compound having an oil- and water-repellent functional group into contact with a surface of the transparent base material which is capable of generating radicals by photoirradiation; and
generating a graft polymer from radicals generated in an exposure region as initial points by patternwise photoirradiation on the transparent base material to form the partition; and
forming pixels in a graft polymer non-generated region by using a liquid containing a colorant.

28. The method of producing a color filter according to Claim 27, wherein the transparent base material, which is capable of generating radicals by photoirradiation, contains a radical generator.

29. The method of producing a color filter according to Claim 27, wherein the transparent base material, which is capable of generating radicals by photoirradiation, contains a polymer compound having a radical-generating site.

30. The method of producing a color filter according to Claim 27, wherein the transparent base material, which is capable of generating radicals by photoirradiation, is prepared by coating a coating solution containing a polymer compound having a crosslinking site and having a radical-generating site on the side chain thereof on a surface of a support, drying the coating solution, and generating a crosslinked structure in the coated film.

31. A method of producing a color filter having a plurality of pixels and partitions separating neighboring pixels on a transparent base material, the method comprising:
generating radicals in an exposure region of a transparent base material by bringing a hydrogen abstraction radical generator into contact with the surface of the transparent base material and performing patternwise photoirradiation on the transparent base material, bringing a radically polymerizable compound having an oil- and water-repellent functional group into contact with the surface of the transparent base material,
graft-polymerizing the radically polymerizable compound from the radicals generated in the exposure region as initial points to generate graft polymers and form the partition; and
forming pixels in a graft polymer non- generated region by using a liquid containing a colorant.

32. A method of producing a color filter having a plurality of pixels and partitions separating neighboring pixels on a transparent base material, the method comprising:
bonding a compound having a polymerization-initiating site, which is capable of initiating radical polymerization by photocleavage, onto a surface of the transparent base material in a patterned form;
bringing a radically polymerizable compound having an oil- and water-repellent functional group into contact with the transparent base material;
photoirradiating the entire surface to generate a graft polymer from the polymerization-initiating site as initial points and form the partition; and
forming pixels in a graft polymer non- generated by using a liquid containing a colorant.

33. The method of producing a color filter according to Claim 32, wherein the bonding of the compound having the polymerization-initiating site, which is capable of initiating radical polymerization by photocleavage, onto the surface of the transparent base material in the patterned form comprises:
bonding a compound having a polymerization-initiating site, which is capable of initiating radical polymerization by photocleavage, and a base material-bonding site to the surface of the transparent base material; and
inactivating the polymerization-initiating site in an exposure region by patternwise photoirradiation.

34. A method of producing a color filter having a plurality of pixels and partitions separating neighboring pixels on a transparent base material, the method comprising, in the following order:
bonding a compound having a polymerization-initiating site, which is capable of initiating radical polymerization by photocleavage, and a base material-bonding site to a surface of the transparent material;
bringing a radically polymerizable compound having an oil- and water-repellent functional group into contact with the surface of the transparent base material; and
generating a graft polymer from the polymerization-initiating site in an exposure region as initial points by patternwise photoirradiation on the surface of the transparent base material to form the partition; and
forming pixels in the graft polymer non- generated region by using a liquid containing a colorant.

35. The method of producing a color filter according to any one of Claims 32 to 34, wherein the polymerization-initiating site contains any one of bonds selected from the group consisting of a C-C bond, a C-N bond, a C-O bond, a C-Cl bond a N-O bond and a S-N bond.

36. A color filter produced by the method of producing a color filter according to any one of Claims 27 to 35.

37. A microlens-producing method comprising, in the following order:
bonding a compound having a polymerization-initiating site, which is capable of initiating radical polymerization by photocleavage, onto a surface of a base material in a patterned form;
bringing a radically polymerizable compound having an oil- and water-repellent functional group into contact with the base material;
photoirradiating the entire surface to generate a graft polymer from the polymerization-initiating site as initial points and form a graft polymer-generated region and a non-generated region on the base material;
attaching a microlens raw material fluid on the graft polymer non-generated region; and
hardening the microlens raw material fluid.

38. The microlens-producing method according to Claim 37, wherein the bonding of the compound having a polymerization-initiating site, which is capable of initiating radical polymerization by photocleavage, onto the surface of the base material in the patternwise form comprises:
bonding a compound having a polymerization-initiating site, which is capable of initiating radical polymerization by photocleavage, and a base material-bonding site to the surface of the base material; and
inactivating the polymerization-initiating site in an exposure region by patternwise photoirradiation.

39. A microlens-producing method comprising, in the following order:
bonding a compound having a polymerization-initiating site, which is capable of initiating radical polymerization by photocleavage, and base material-bonding site onto a surface of a base material;
bringing a radically polymerizable compound having an oil- and water-repellent functional group into contact with the base material;
generating a graft polymer from the polymerization-initiating site in an exposure region as initial points by patternwise photoirradiation on the base material to form a graft polymer-generated region and a non-generated region on the surface of the base material;
attaching a microlens raw material fluid on the graft polymer non- generated region; and
hardening the microlens raw material fluid.

40. The microlens-producing method according to any one of Claims 37 to 39, wherein the polymerization-initiating site contains any one of bonds selected from the group consisting of a C-C bond, a C-N bond, a C-O bond, a C-Cl bond, a N-O bond and a S-N bond.
